(19) Europäisches Patentamt / European Patent Office / Office européen des brevets

(11) **EP 4 216 290 A1**

(12) **EUROPEAN PATENT APPLICATION**
published in accordance with Art. 153(4) EPC

(43) Date of publication:
26.07.2023 Bulletin 2023/30

(21) Application number: 21869215.0

(22) Date of filing: 03.09.2021

(51) International Patent Classification (IPC):
*H01L 33/02* (2010.01)    *H01L 33/48* (2010.01)
*G09F 9/00* (2006.01)    *G09F 9/30* (2006.01)
*G09F 9/33* (2006.01)

(52) Cooperative Patent Classification (CPC):
G09F 9/00; G09F 9/30; G09F 9/33; H01L 33/02;
H01L 33/48

(86) International application number:
PCT/JP2021/032529

(87) International publication number:
WO 2022/059528 (24.03.2022 Gazette 2022/12)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 17.09.2020 JP 2020156726

(71) Applicant: Nichia Corporation
Anan-shi, Tokushima 774-8601 (JP)

(72) Inventor: AKIMOTO, Hajime
Anan-shi, Tokushima 774-8601 (JP)

(74) Representative: Winter, Brandl - Partnerschaft
mbB
Alois-Steinecker-Straße 22
85354 Freising (DE)

(54) **PRODUCTION METHOD FOR IMAGE DISPLAY DEVICE AND IMAGE DISPLAY DEVICE**

(57) An image display device manufacturing method according to an embodiment includes preparing a semiconductor layer, bonding the semiconductor layer to a first surface of a light-transmitting substrate, etching the semiconductor layer to form, on the first surface, a light-emitting element including a light-emitting surface and an upper surface provided on a side opposite to the light-emitting surface, forming a first insulating film covering the first surface and the light-emitting element, forming a circuit element on the first insulating film, forming a second insulating film covering the first insulating film and the circuit element, forming a first via passing through the first insulating film and the second insulating film, and forming a first wiring layer on the second insulating film. The first via is provided between the first wiring layer and the upper surface, and allows electrical connection between the first wiring layer and the upper surface.

FIG. 1

## Description

[Technical Field]

An embodiment of the present invention relates to an image display device manufacturing method and an image display device.

[Background Art]

Realization of a thin image display device having high brightness, a wide viewing angle, high contrast, and low power consumption has been desired. To accommodate such market demands, advancements have been made in the development of a display device that utilizes a self-light-emitting element.

The emergence of a display device that uses, as a self-light-emitting element, a micro light-emitting diode (LED), which is a fine light-emitting element, is expected. As a manufacturing method of a display device that uses a micro LED, a method of sequentially transferring individually formed micro LEDs to a drive circuit has been introduced. Nevertheless, as the number of micro LED elements increases as image quality advances, such as full high definition, 4K, and 8K, in the individual formation and the sequential transfer of a large number of micro LEDs to a substrate on which a drive circuit and the like are formed, a significant amount of time is required for the transfer process. Furthermore, connection failure or the like between a micro LED and the drive circuit or the like may occur, resulting in a decrease in yield.

There is known a technique of growing a semiconductor layer including a light-emitting layer on a Si substrate, forming an electrode on the semiconductor layer, and then bonding the semiconductor layer to a circuit substrate on which a drive circuit is formed (refer to Patent Document 1, for example).

[Citation List]

[Patent Literature]

[Patent Document 1]
JP 2002-141492 A

[Summary of Invention]

[Technical Problem]

An embodiment of the present invention provides an image display device manufacturing method and an image display device that reduce a transfer process of a light-emitting element and improve yield.

[Solution to Problem]

An image display device manufacturing method according to an embodiment of the present invention includes preparing a semiconductor layer including a light-emitting layer, bonding the semiconductor layer to a first surface of a light-transmitting substrate, etching the semiconductor layer to form, on the first surface, a light-emitting element including a light-emitting surface and an upper surface provided on a side opposite to the light-emitting surface, forming a first insulating film covering the first surface and the light-emitting element, forming a circuit element on the first insulating film, forming a second insulating film covering the first insulating film and the circuit element, forming a first via passing through the first insulating film and the second insulating film, and forming a first wiring layer on the second insulating film. The first via is provided between the first wiring layer and the upper surface, and allows electrical connection between the first wiring layer and the upper surface.

An image display device according to an embodiment of the present invention includes a light-transmitting member including a first surface, a light-emitting element, on the first surface, including a light-emitting surface and an upper surface on a side opposite to the light-emitting surface, a first insulating film covering the first surface and the light-emitting element, a circuit element provided on the first insulating film, a second insulating film covering the first insulating film and the circuit element, a first via passing through the first insulating film and the second insulating film, and a first wiring layer provided on the second insulating film. The first via is provided between the first wiring layer and the upper surface, and allows electrical connection between the first wiring layer and the upper surface.

An image display device according to an embodiment of the present invention includes a light-transmitting member including a first surface, a first semiconductor layer, on the first surface, including a light-emitting surface that can form a plurality of light-emitting regions, a plurality of light-emitting layers spaced apart on the first semiconductor layer, a plurality of second semiconductor layers respectively provided on the plurality of light-emitting layers and having a conductivity type different from a conductivity type of the first semiconductor layer, a first insulating film covering the first surface, the first semiconductor layer, the plurality of light-emitting layers, and the plurality of second semiconductor layers, a plurality of transistors spaced apart from one another on the first insulating film, a second insulating film covering the first insulating film and the plurality of transistors, a plurality of first vias passing through the first insulating film and the second insulating film, and a first wiring layer provided on the second insulating film. The plurality of second semiconductor layers and the plurality of light-emitting layers are separated by the first insulating film. The plurality of first vias are disposed between the first wiring layer and the plurality of respective second semiconductor layers, and allow electrical connection between the first wiring layer and the plurality of respective second semiconductor layers.

An image display device according to an embodiment of the present invention includes a light-transmitting member including a first surface, a plurality of light-emitting elements, on the first surface, each including a light-emitting surface and an upper surface on a side opposite to the light-emitting surface, a first insulating film covering the first surface and the plurality of light-emitting elements, a circuit element provided on the first insulating film, a second insulating film covering the first insulating film and the circuit element, a plurality of first vias passing through the first insulating film and the second insulating film, and a first wiring layer provided on the second insulating film. Each of the plurality of first vias is provided between the first wiring layer and the upper surface, and allows electrical connection between the first wiring layer and the upper surface.

[Advantageous Effects of Invention]

According to an embodiment of the present invention, an image display device manufacturing method that reduces a transfer process of a light-emitting element and improves yield is realized.

According to an embodiment of the present invention, an image display device that reduces a transfer process of a light-emitting element and improves yield is realized.

[Brief Description of Drawings]

[FIG. 1]

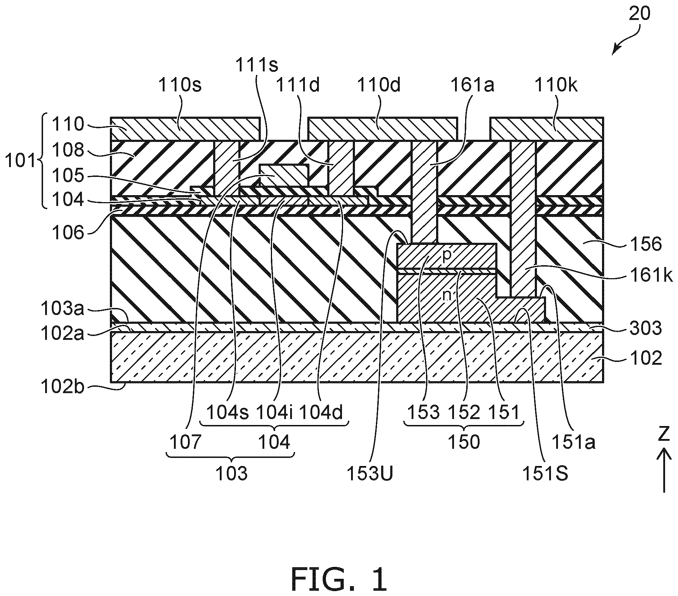

FIG. 1 is a schematic cross-sectional view exemplifying a portion of an image display device according to a first embodiment.
[FIG. 2]

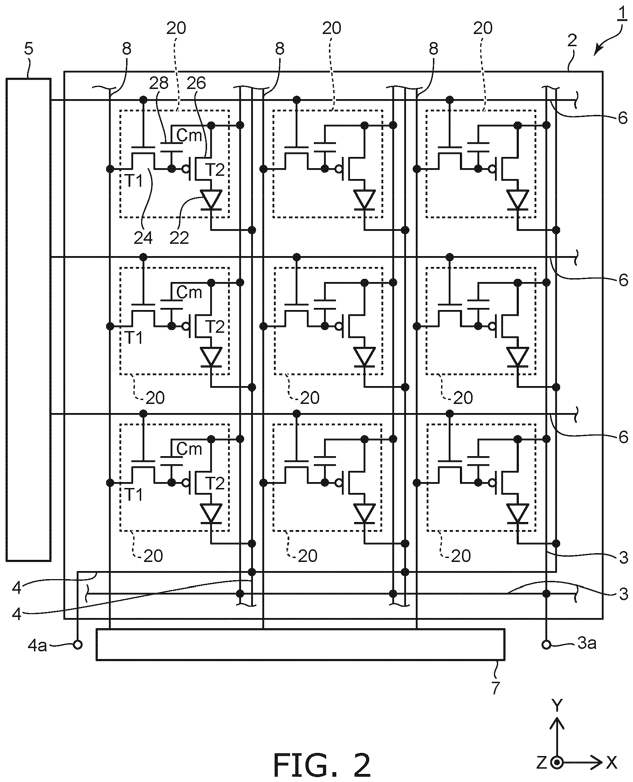

FIG. 2 is a schematic block diagram exemplifying the image display device according to the first embodiment.
[FIG. 3]

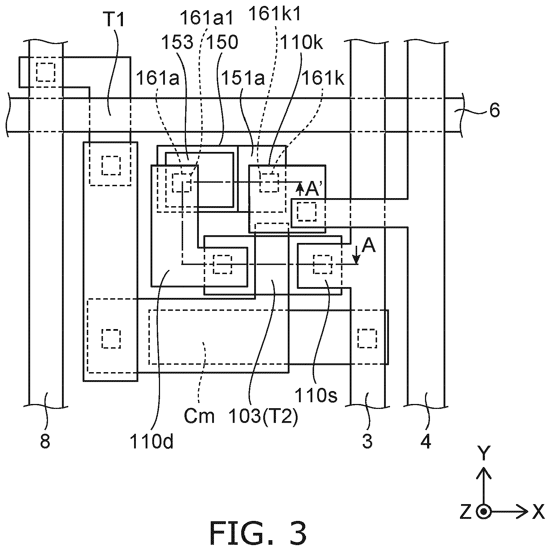

FIG. 3 is a schematic plan view exemplifying a portion of the image display device according to the first embodiment.
[FIG. 4A]

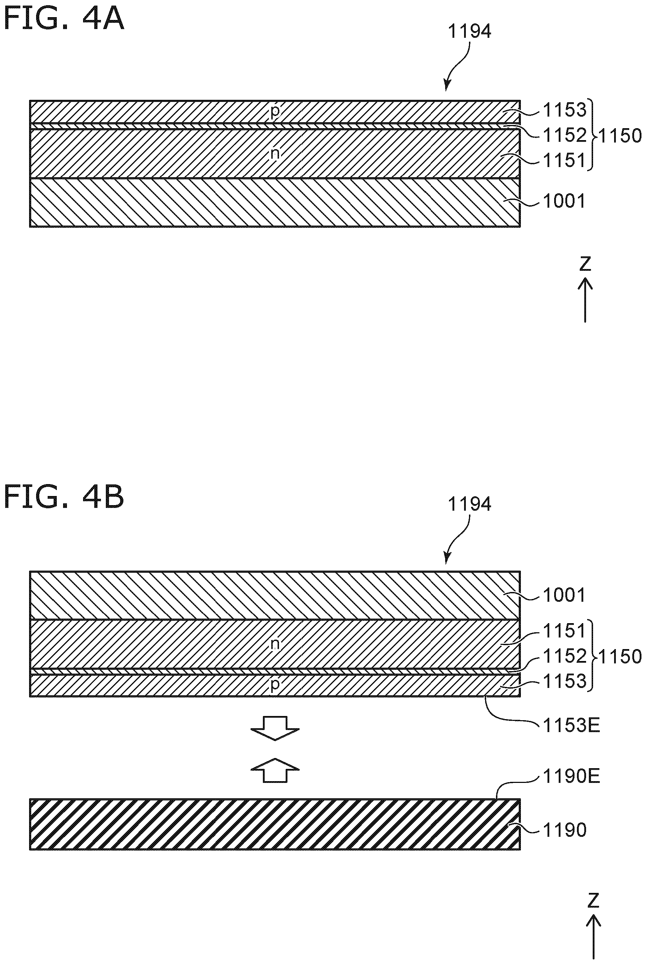

FIG. 4A is a schematic cross-sectional view exemplifying a portion of a manufacturing method of the image display device according to the first embodiment.
[FIG. 4B]
FIG. 4B is a schematic cross-sectional view exemplifying a portion of the manufacturing method of the image display device according to the first embodiment.
[FIG. 5A]

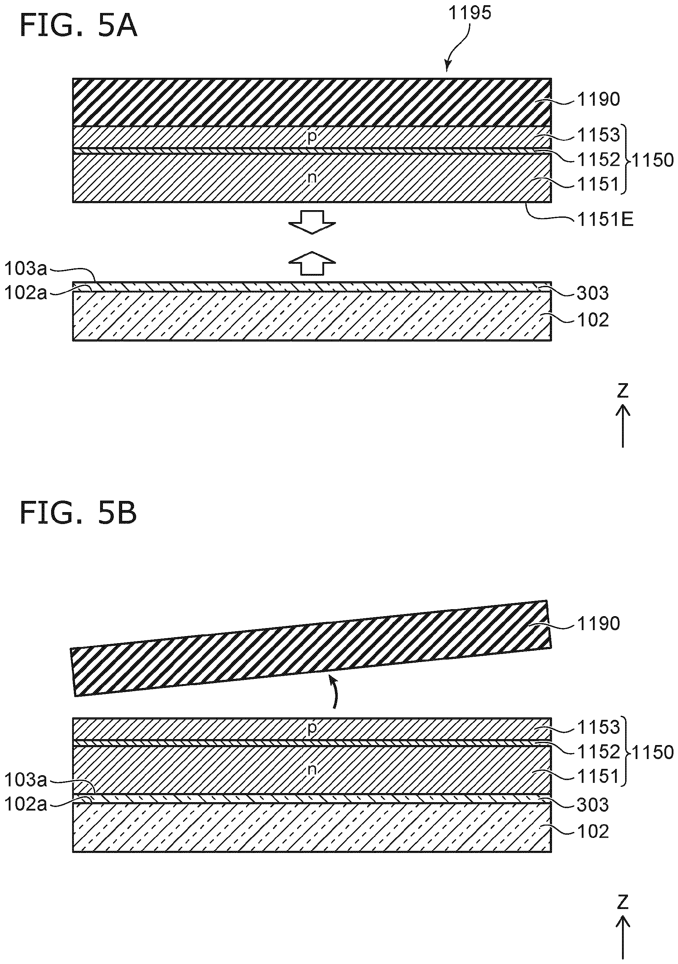

FIG. 5A is a schematic cross-sectional view exemplifying a portion of the manufacturing method of the image display device according to the first embodiment.
[FIG. 5B]
FIG. 5B is a schematic cross-sectional view exemplifying a portion of the manufacturing method of the image display device according to the first embodiment.
[FIG. 6]

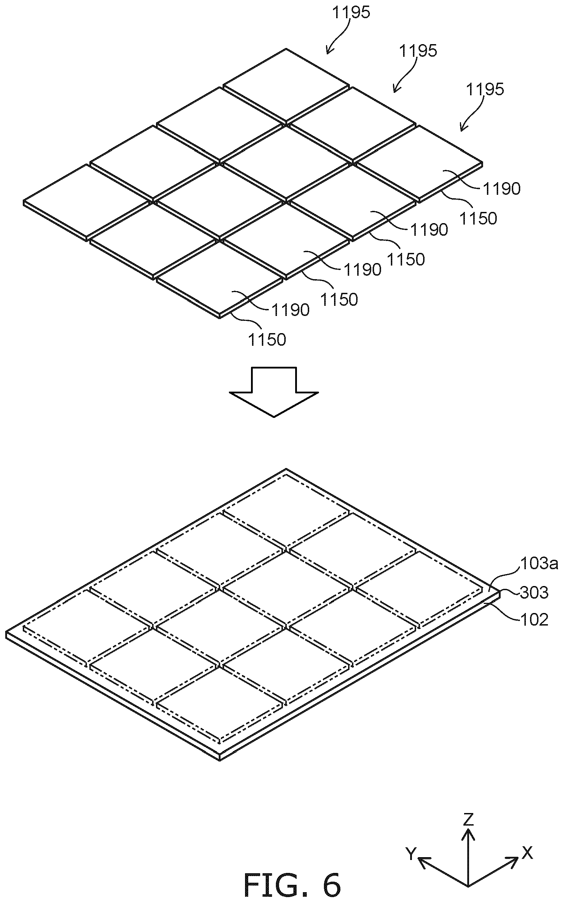

FIG. 6 is a schematic perspective view exemplifying a portion of the manufacturing method of the image display device according to the first embodiment.
[FIG. 7A]

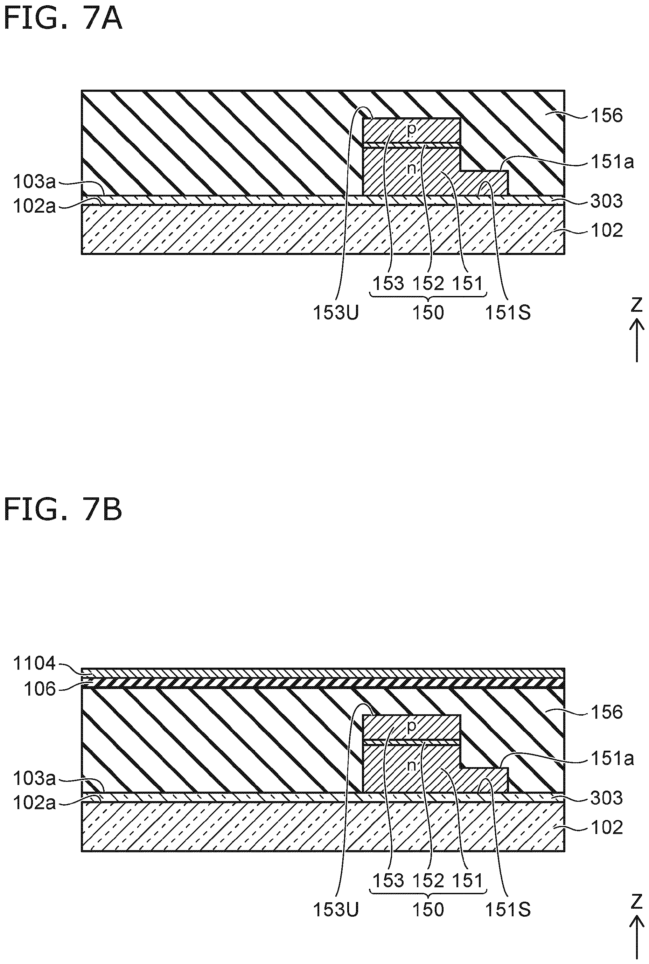

FIG. 7A is a schematic cross-sectional view exemplifying a portion of the manufacturing method of the image display device according to the first embodiment.
[FIG. 7B]
FIG. 7B is a schematic cross-sectional view exemplifying a portion of the manufacturing method of the image display device according to the first embodiment.
[FIG. 8A]

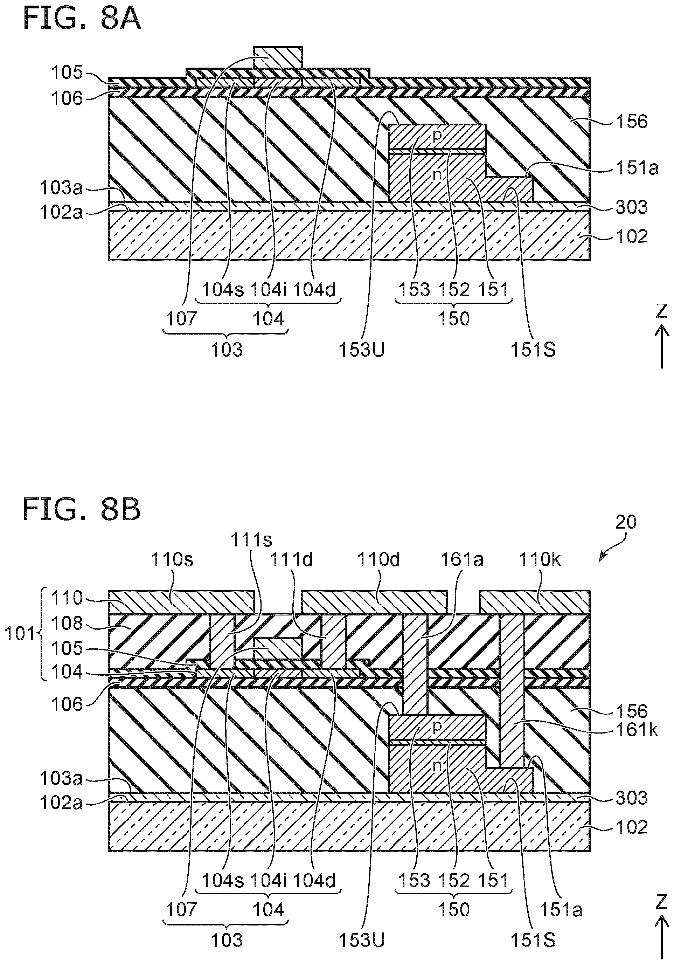

FIG. 8A is a schematic cross-sectional view exemplifying a portion of the manufacturing method of the image display device according to the first embodiment.
[FIG. 8B]
FIG. 8B is a schematic cross-sectional view exemplifying a portion of the manufacturing method of the image display device according to the first embodiment.
[FIG. 9]

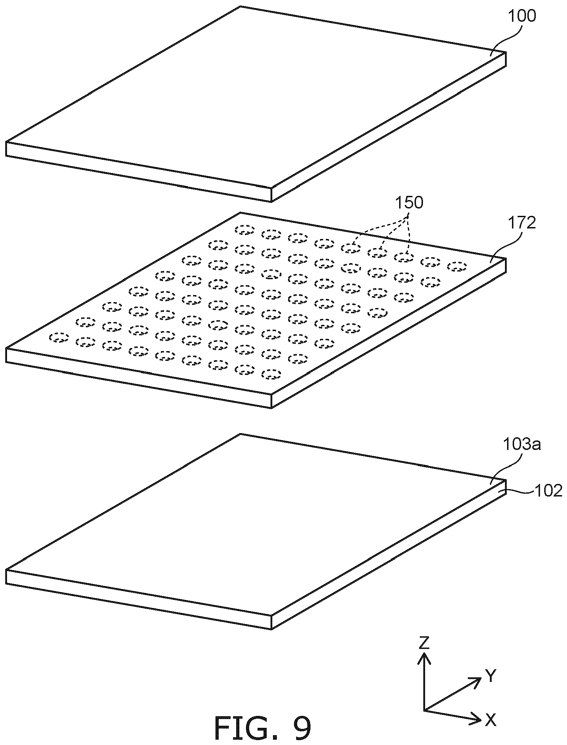

FIG. 9 is a schematic perspective view exemplifying the image display device according to the first embodiment.
[FIG. 10]

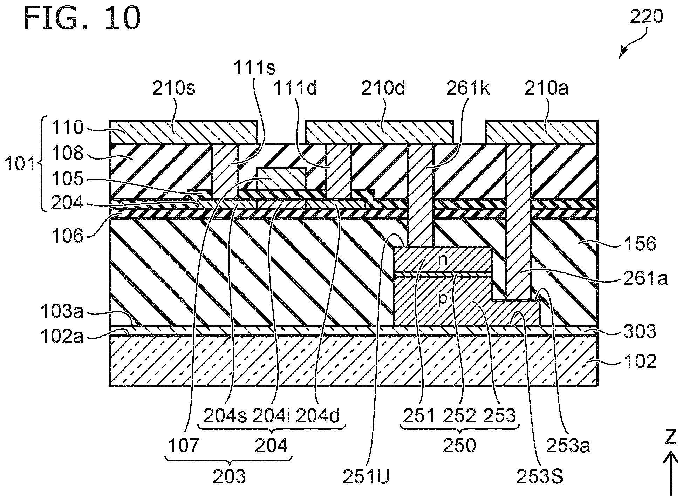

FIG. 10 is a schematic cross-sectional view exemplifying a portion of an image display device according to a second embodiment.
[FIG. 11]

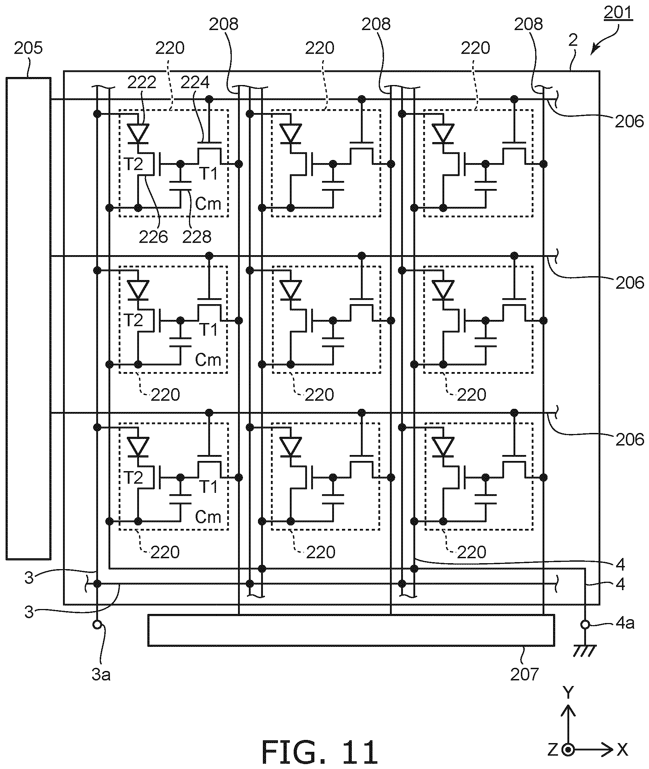

FIG. 11 is a schematic block diagram exemplifying the image display device according to the second embodiment.
[FIG. 12A]

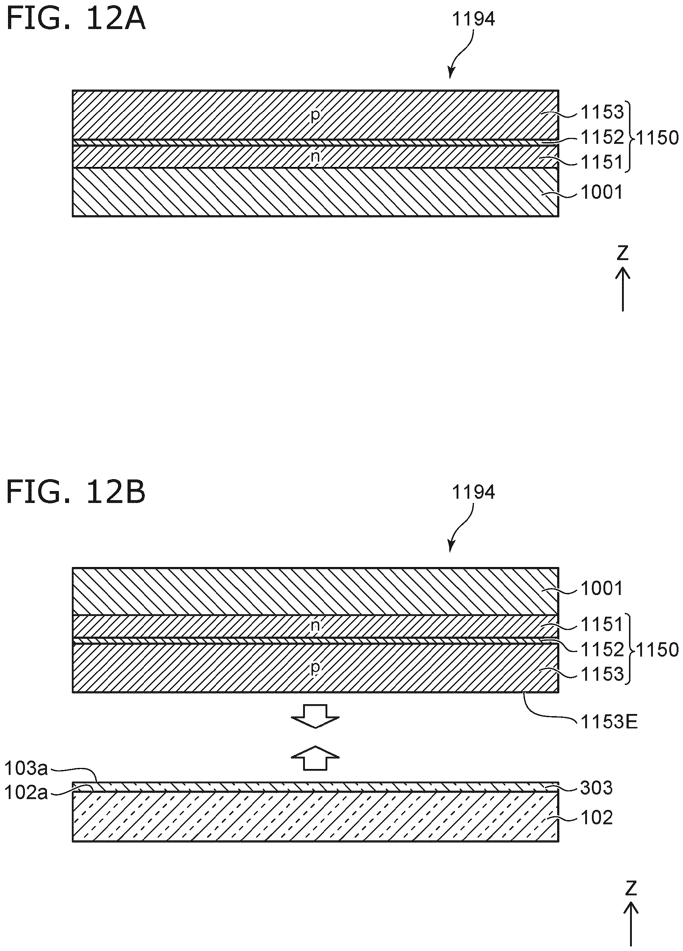

FIG. 12A is a schematic cross-sectional view exemplifying a portion of a manufacturing method of the image display device according to the second embodiment.
[FIG. 12B]
FIG. 12B is a schematic cross-sectional view exemplifying a portion of the manufacturing method of the image display device according to the second embodiment.
[FIG. 13]

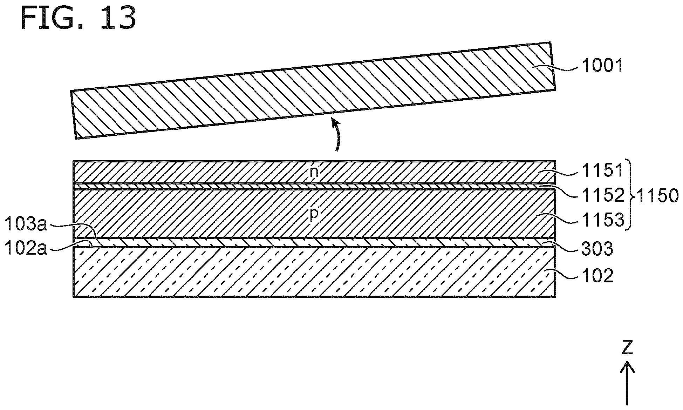

FIG. 13 is a schematic cross-sectional view exemplifying a portion of the manufacturing method of the image display device according to the second embodiment.

[FIG. 14A]

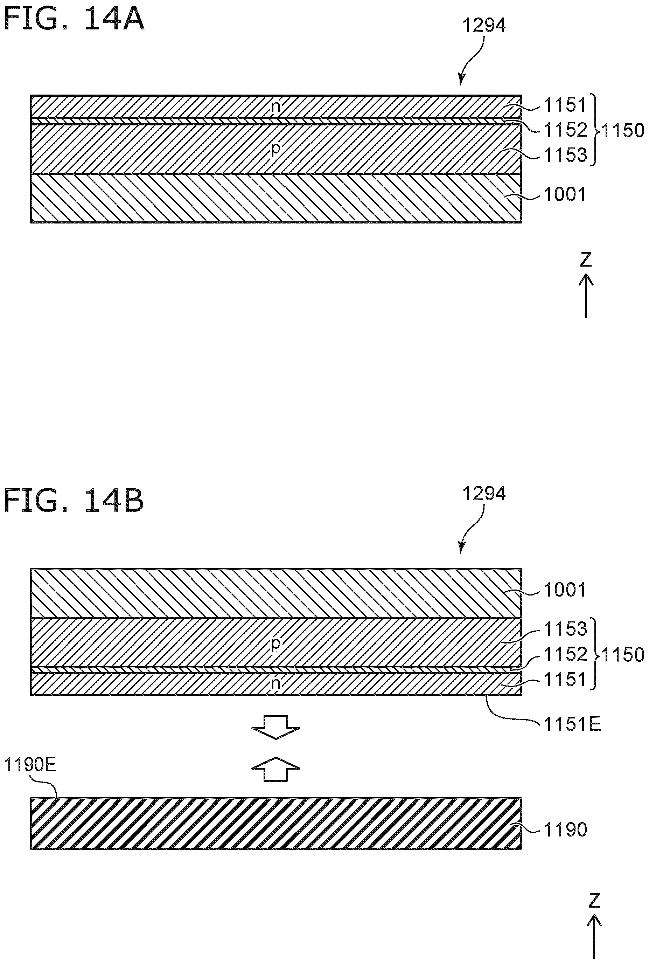

FIG. 14A is a schematic cross-sectional view exemplifying a portion of the manufacturing method of the image display device according to the second embodiment.

[FIG. 14B]

FIG. 14B is a schematic cross-sectional view exemplifying a portion of the manufacturing method of the image display device according to the second embodiment.

[FIG. 15A]

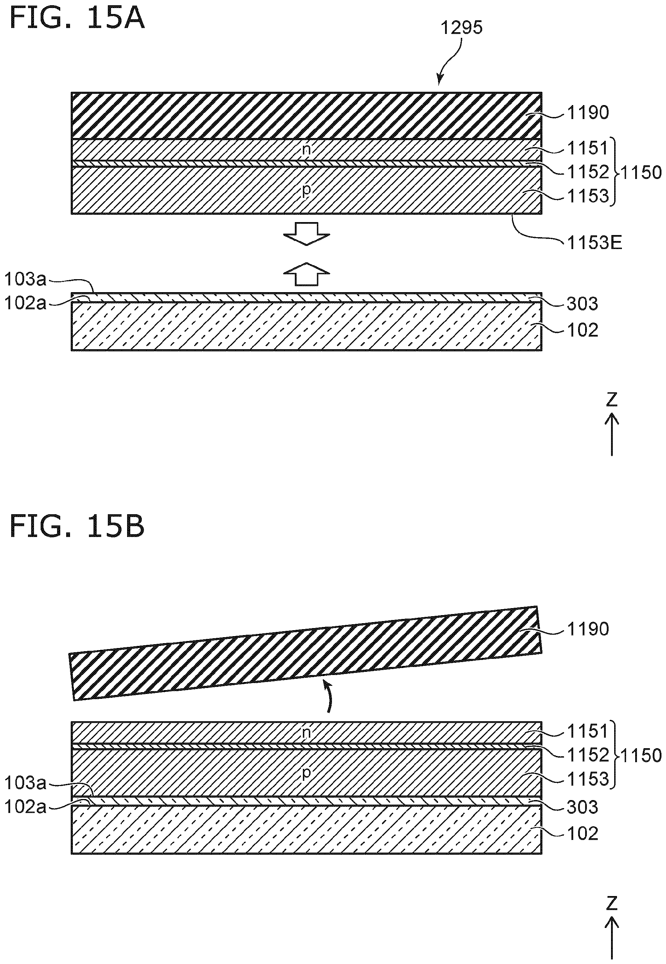

FIG. 15A is a schematic cross-sectional view exemplifying a portion of the manufacturing method of the image display device according to the second embodiment.

[FIG. 15B]

FIG. 15B is a schematic cross-sectional view exemplifying a portion of the manufacturing method of the image display device according to the second embodiment.

[FIG. 16A]

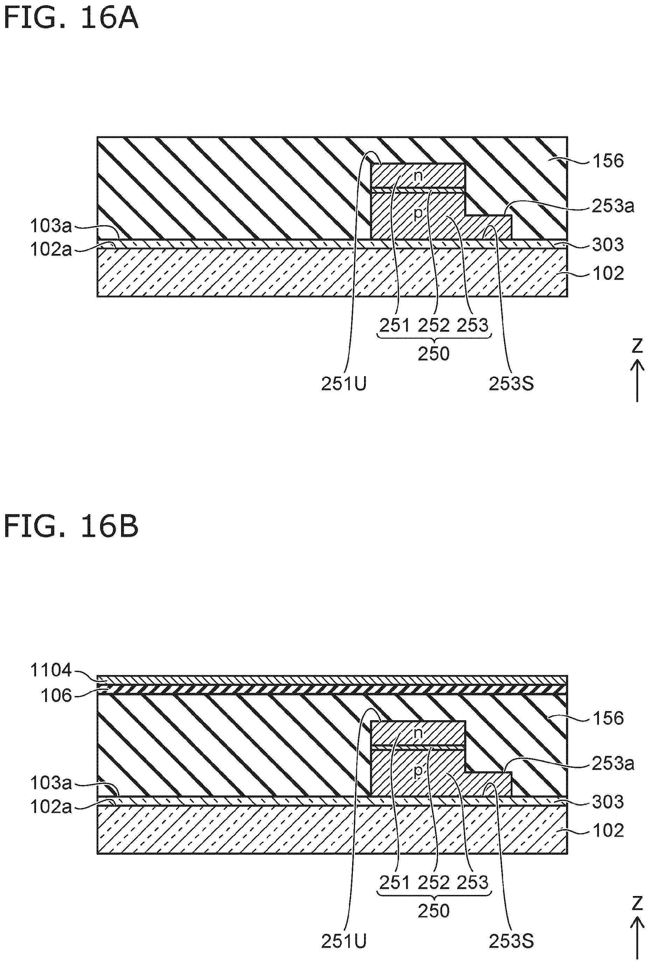

FIG. 16A is a schematic cross-sectional view exemplifying a portion of the manufacturing method of the image display device according to the second embodiment.

[FIG. 16B]

FIG. 16B is a schematic cross-sectional view exemplifying a portion of the manufacturing method of the image display device according to the second embodiment.

[FIG. 17A]

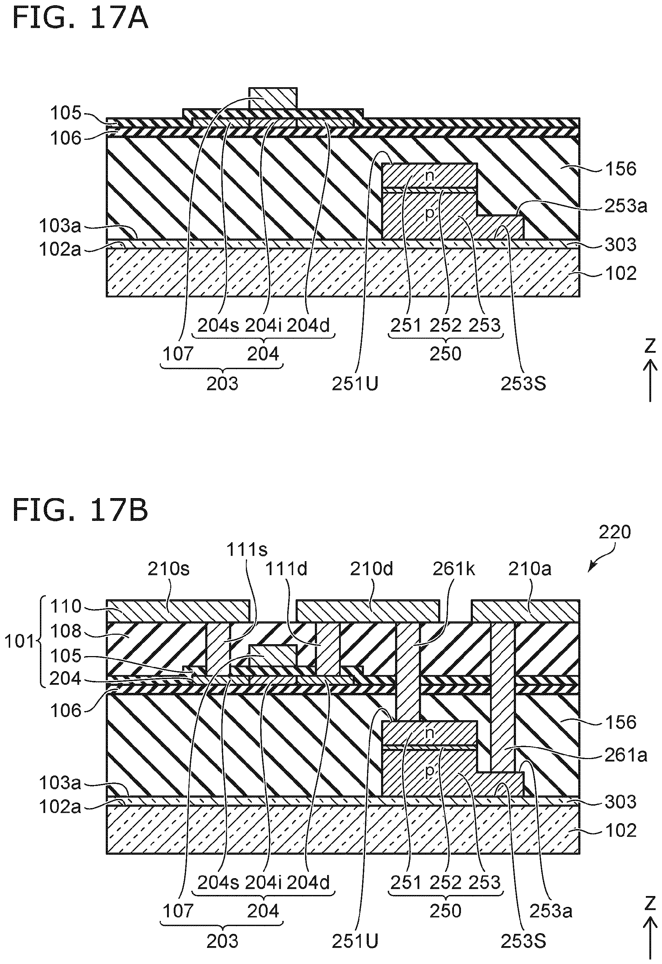

FIG. 17A is a schematic cross-sectional view exemplifying a portion of the manufacturing method of the image display device according to the second embodiment.

[FIG. 17B]

FIG. 17B is a schematic cross-sectional view exemplifying a portion of the manufacturing method of the image display device according to the second embodiment.

[FIG. 18]

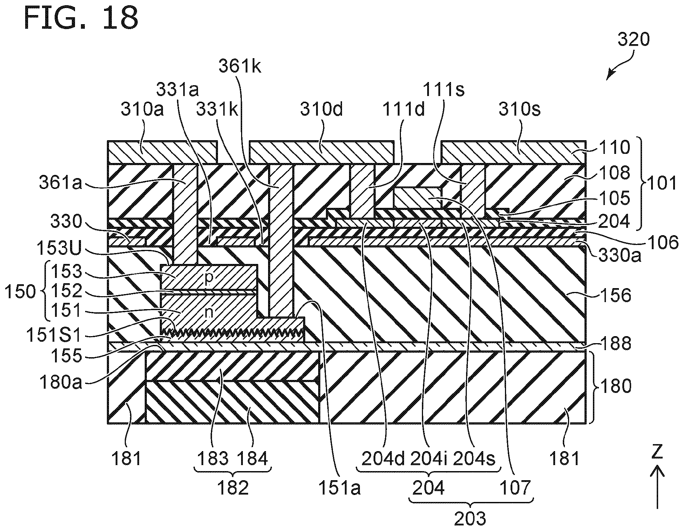

FIG. 18 is a schematic cross-sectional view exemplifying a portion of an image display device according to a third embodiment.

[FIG. 19]

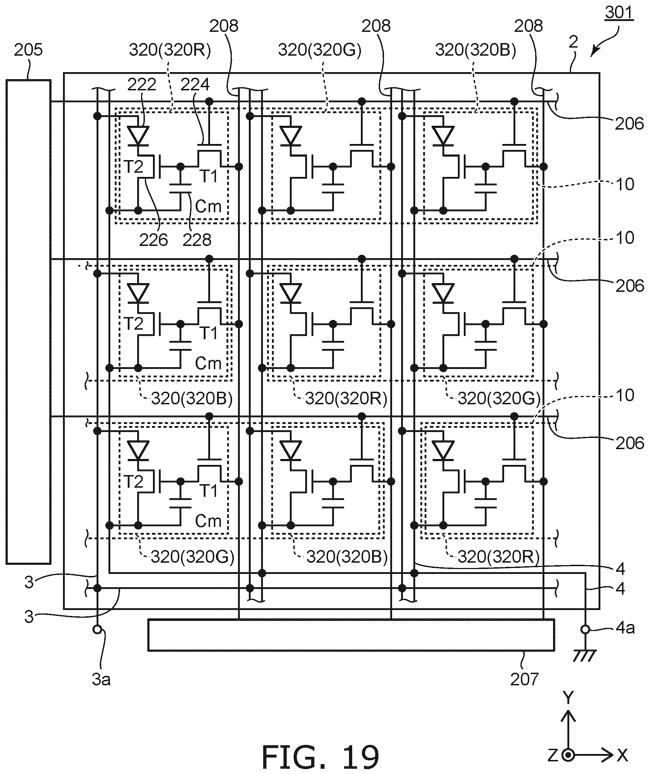

FIG. 19 is a schematic block diagram exemplifying the image display device according to the third embodiment.

[FIG. 20A]

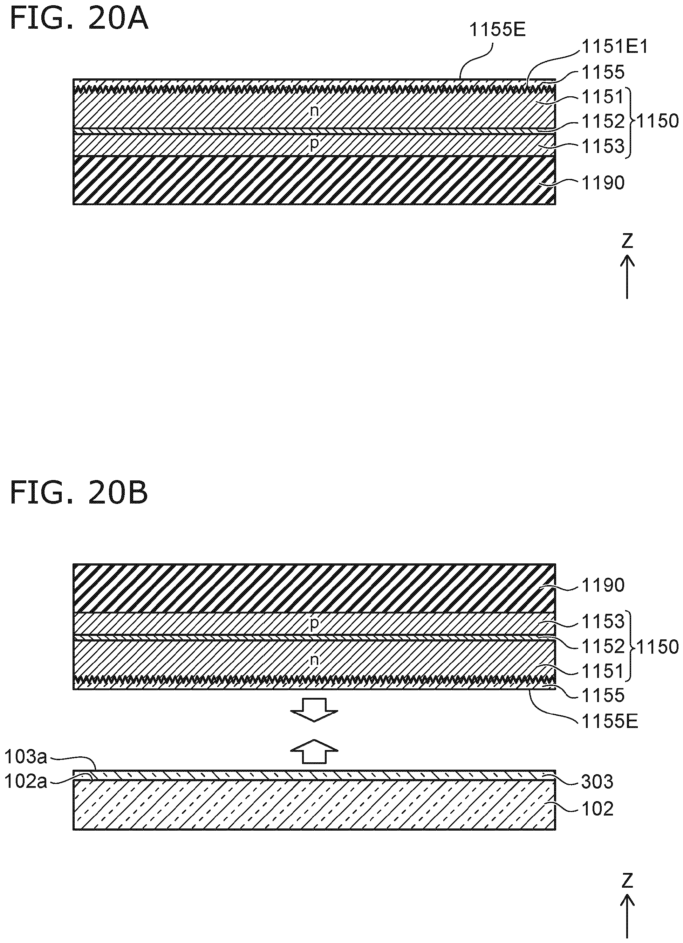

FIG. 20A is a schematic cross-sectional view exemplifying a portion of a manufacturing method of the image display device according to the third embodiment.

[FIG. 20B]

FIG. 20B is a schematic cross-sectional view exemplifying a portion of the manufacturing method of the image display device according to the third embodiment.

[FIG. 21A]

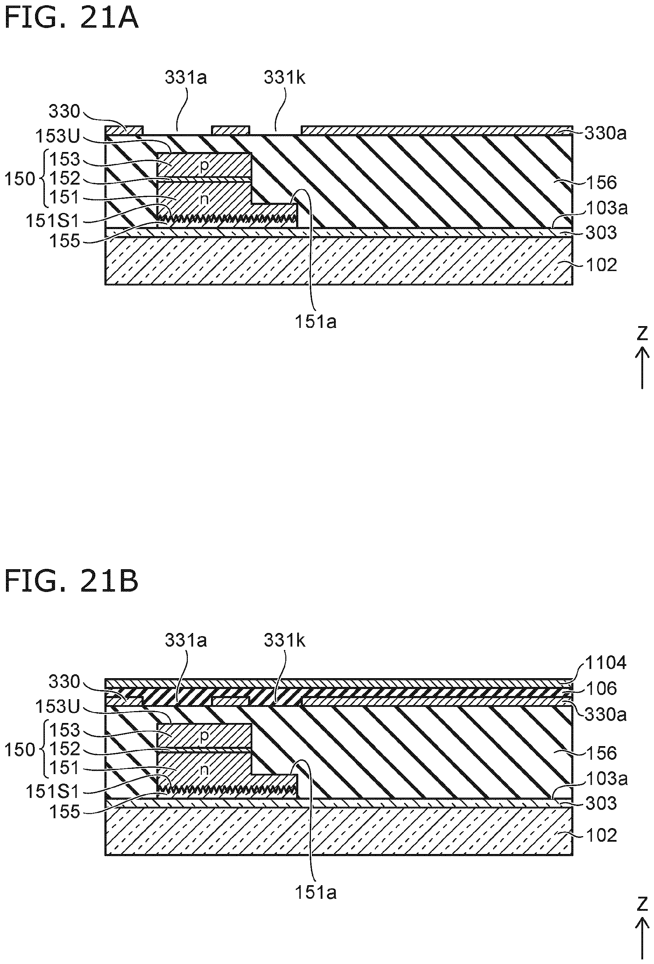

FIG. 21A is a schematic cross-sectional view exemplifying a portion of the manufacturing method of the image display device according to the third embodiment.

[FIG. 21B]

FIG. 21B is a schematic cross-sectional view exemplifying a portion of the manufacturing method of the image display device according to the third embodiment.

[FIG. 22A]

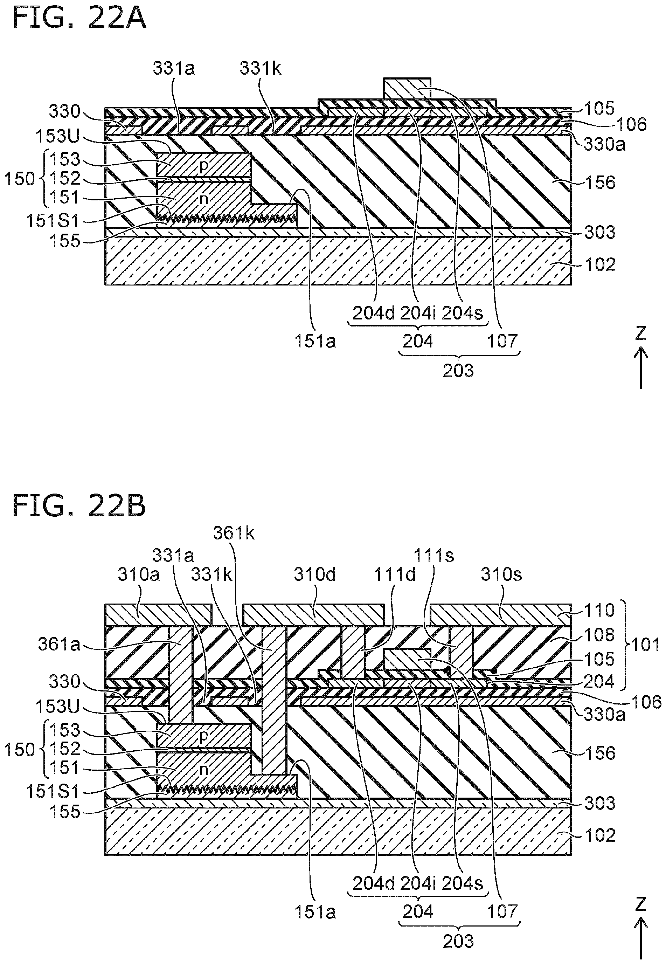

FIG. 22A is a schematic cross-sectional view exemplifying a portion of the manufacturing method of the image display device according to the third embodiment.

[FIG. 22B]

FIG. 22B is a schematic cross-sectional view exemplifying a portion of the manufacturing method of the image display device according to the third embodiment.

[FIG. 23A]

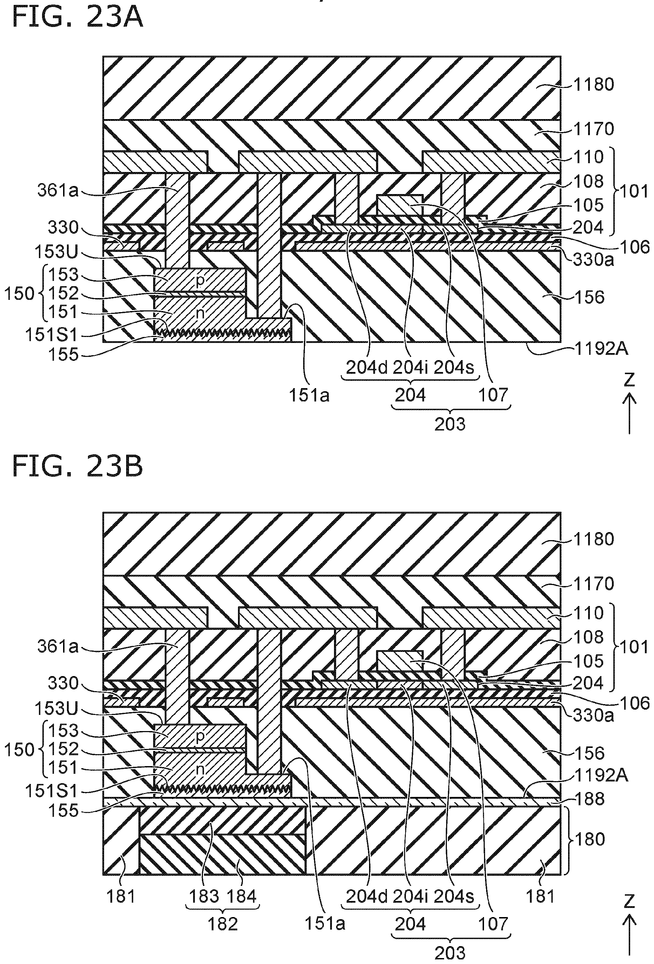

FIG. 23A is a schematic cross-sectional view exemplifying a portion of the manufacturing method of the image display device according to the third embodiment.

[FIG. 23B]

FIG. 23B is a schematic cross-sectional view exemplifying a portion of the manufacturing method of the image display device according to the third embodiment.

[FIG. 24A]

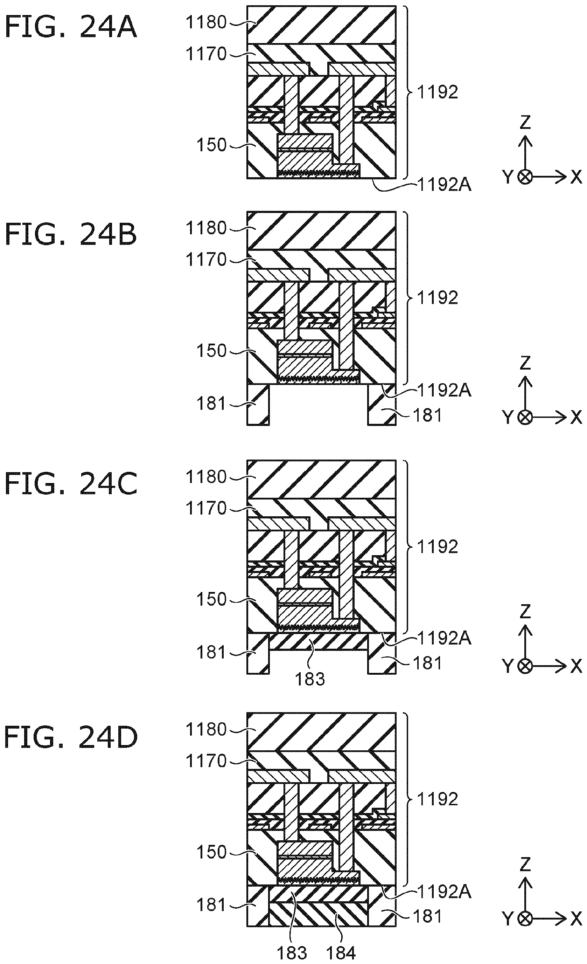

FIG. 24A is a schematic cross-sectional view exemplifying a portion of the manufacturing method of the image display device according to the third embodiment.

[FIG. 24B]

FIG. 24B is a schematic cross-sectional view exemplifying a portion of the manufacturing method of the image display device according to the third embodiment.

[FIG. 24C]

FIG. 24C is a schematic cross-sectional view exemplifying a portion of the manufacturing method of the image display device according to the third embodiment.

[FIG. 24D]

FIG. 24D is a schematic cross-sectional view exemplifying a portion of the manufacturing method of the image display device according to the third embodiment.

[FIG. 25]

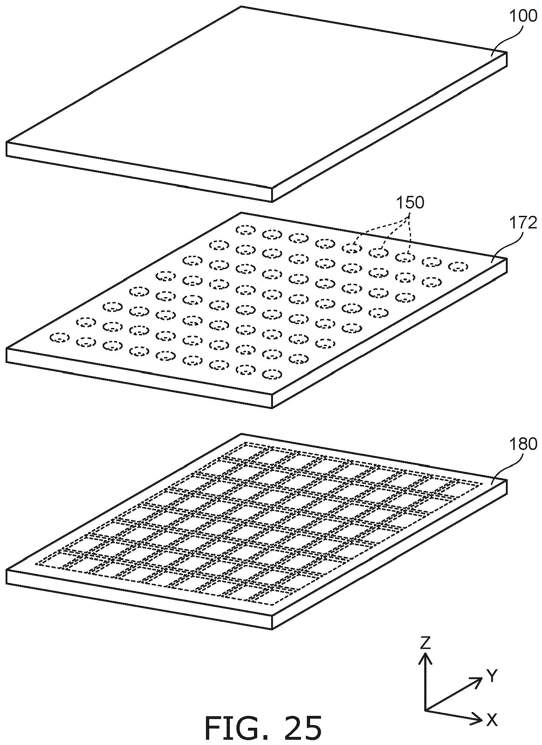

FIG. 25 is a schematic perspective view exemplifying the image display device according to the third embodiment.

[FIG. 26]

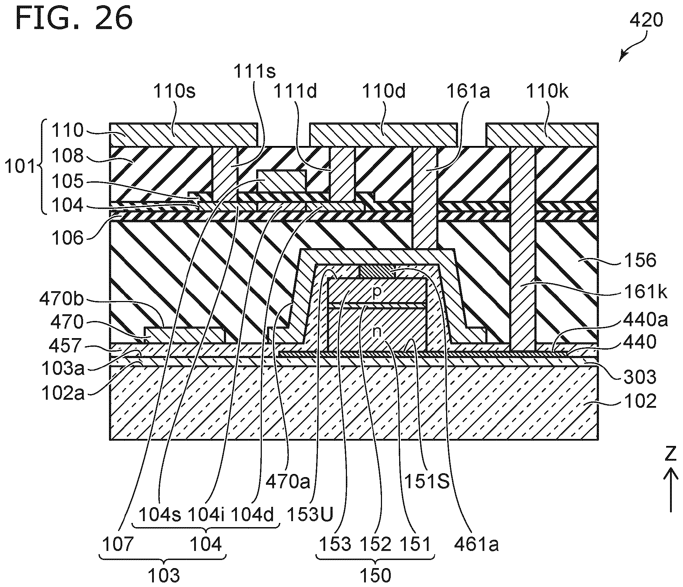

FIG. 26 is a schematic cross-sectional view exemplifying a portion of an image display device according to a fourth embodiment.

[FIG. 27A]

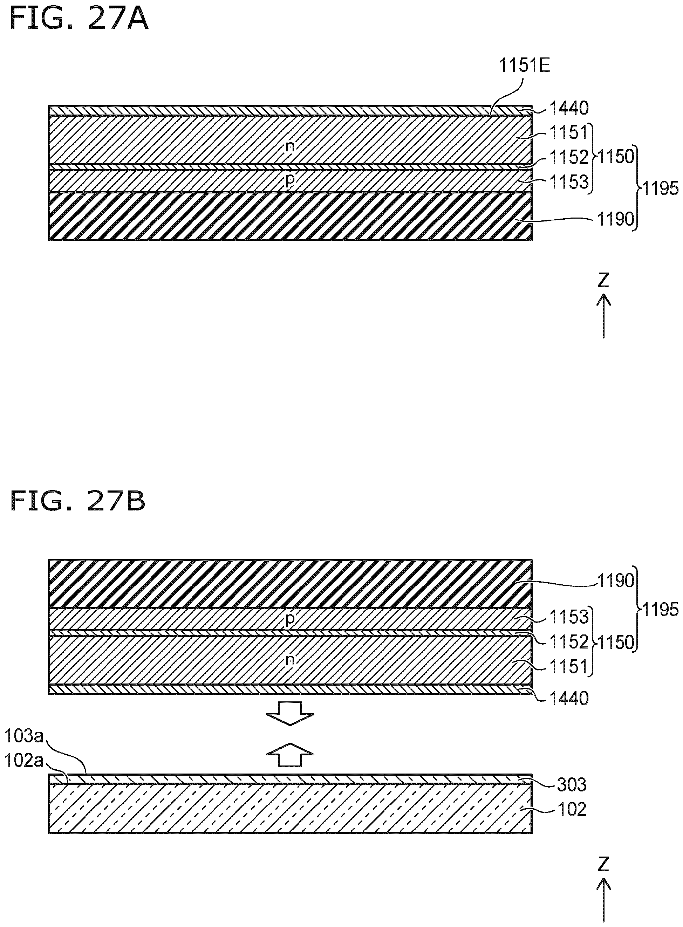

FIG. 27A is a schematic cross-sectional view exemplifying a portion of a manufacturing method of the image display device according to the fourth embodiment.

[FIG. 27B]
FIG. 27B is a schematic cross-sectional view exemplifying a portion of the manufacturing method of the image display device according to the fourth embodiment.

[FIG. 28A]

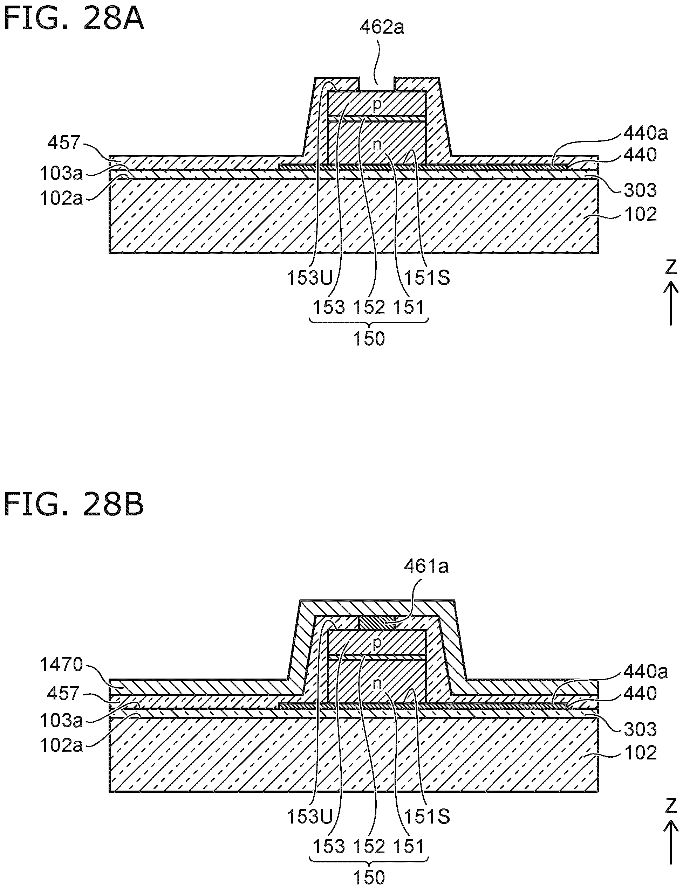

FIG. 28A is a schematic cross-sectional view exemplifying a portion of the manufacturing method of the image display device according to the fourth embodiment.

[FIG. 28B]
FIG. 28B is a schematic cross-sectional view exemplifying a portion of the manufacturing method of the image display device according to the fourth embodiment.

[FIG. 29A]

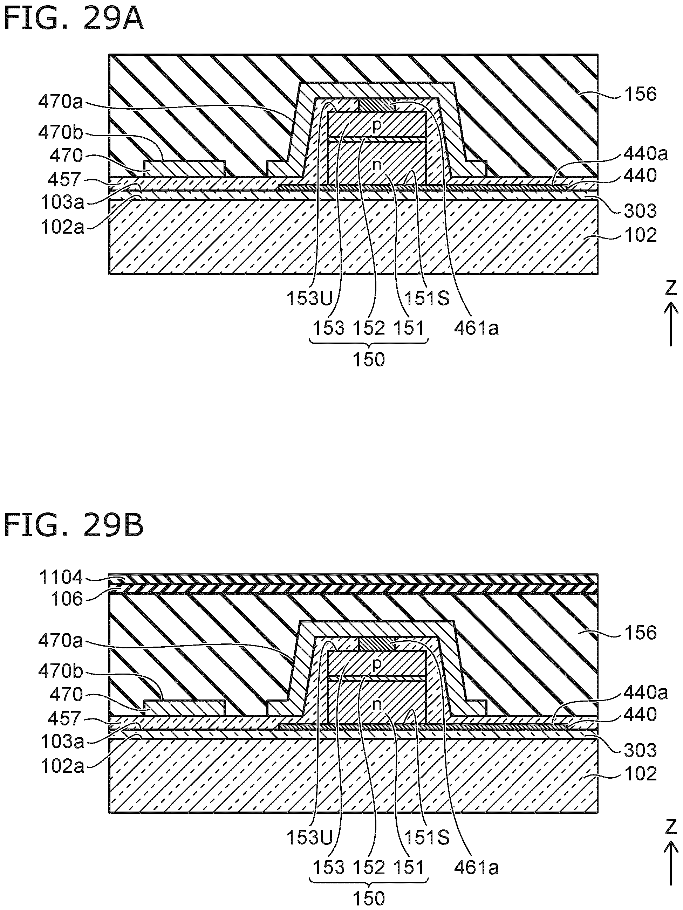

FIG. 29A is a schematic cross-sectional view exemplifying a portion of the manufacturing method of the image display device according to the fourth embodiment.

[FIG. 29B]
FIG. 29B is a schematic cross-sectional view exemplifying a portion of the manufacturing method of the image display device according to the fourth embodiment.

[FIG. 30A]

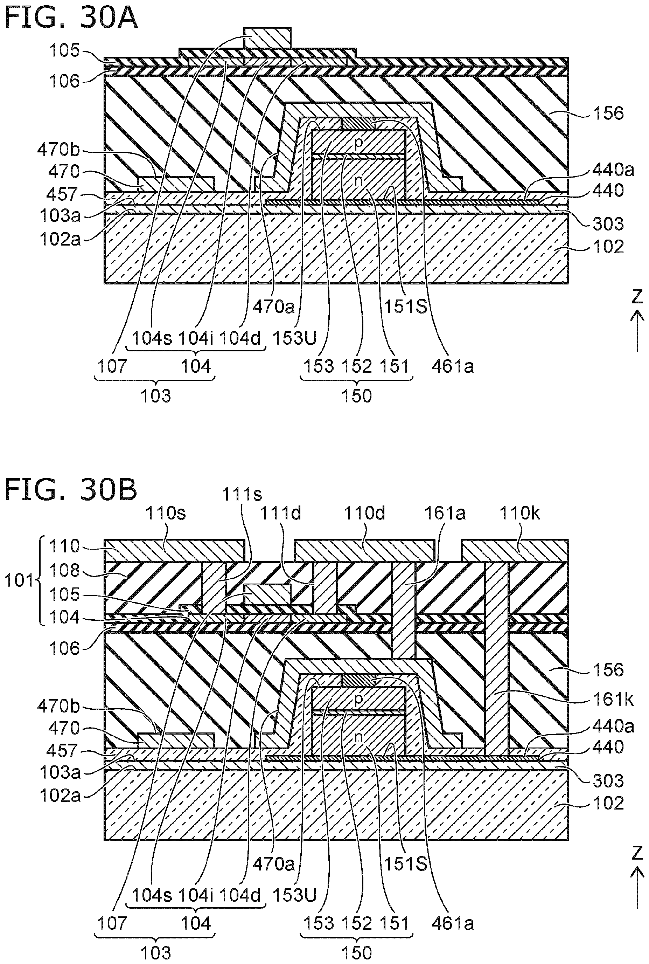

FIG. 30A is a schematic cross-sectional view exemplifying a portion of the manufacturing method of the image display device according to the fourth embodiment.

[FIG. 30B]
FIG. 30B is a schematic cross-sectional view exemplifying a portion of the manufacturing method of the image display device according to the fourth embodiment.

[FIG. 31]

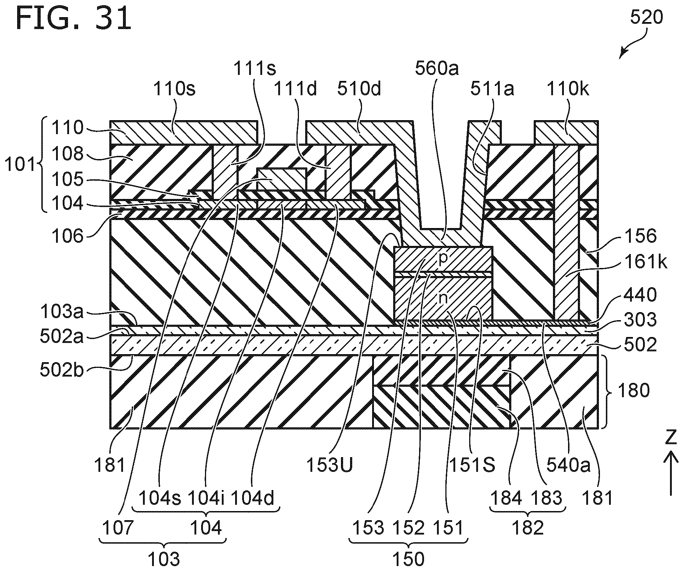

FIG. 31 is a schematic cross-sectional view exemplifying a portion of an image display device according to a fifth embodiment.

[FIG. 32]

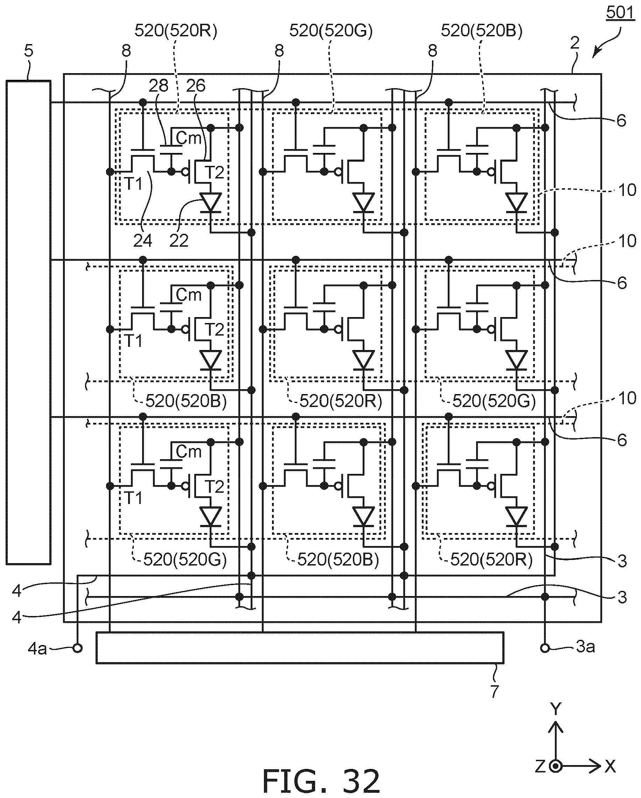

FIG. 32 is a schematic block diagram exemplifying the image display device according to the fifth embodiment.

[FIG. 33A]

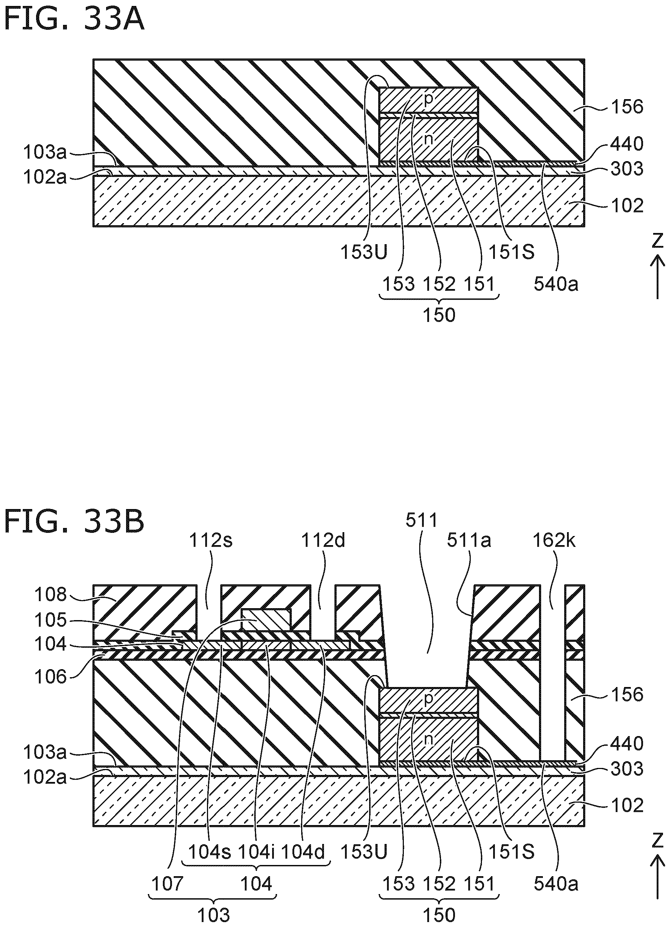

FIG. 33A is a schematic cross-sectional view exemplifying a portion of a manufacturing method of the image display device according to the fifth embodiment.

[FIG. 33B]
FIG. 33B is a schematic cross-sectional view exemplifying a portion of the manufacturing method of the image display device according to the fifth embodiment.

[FIG. 34A]

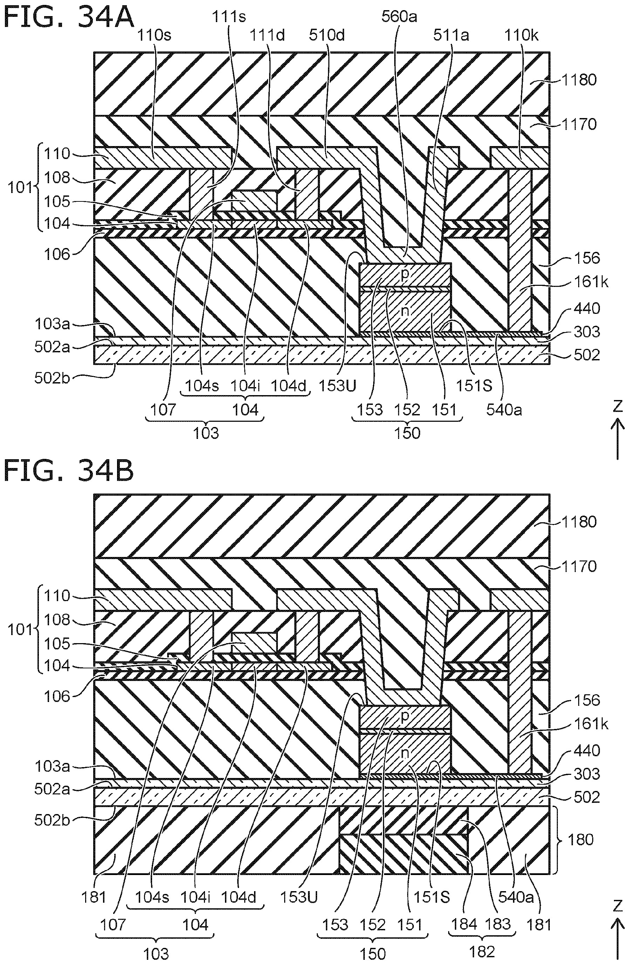

FIG. 34A is a schematic cross-sectional view exemplifying a portion of the manufacturing method of the image display device according to the fifth embodiment.

[FIG. 34B]
FIG. 34B is a schematic cross-sectional view exemplifying a portion of the manufacturing method of the image display device according to the fifth embodiment.

[FIG. 35]

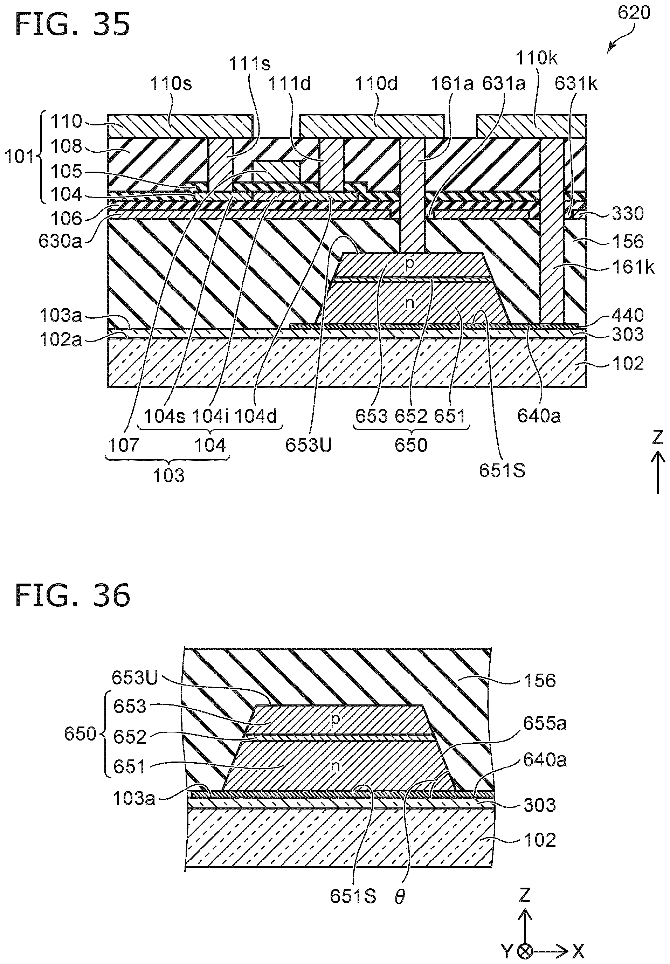

FIG. 35 is a schematic cross-sectional view exemplifying a portion of an image display device according to a sixth embodiment.

[FIG. 36]
FIG. 36 is a schematic cross-sectional view exemplifying a portion of the image display device according to the sixth embodiment.

[FIG. 37]

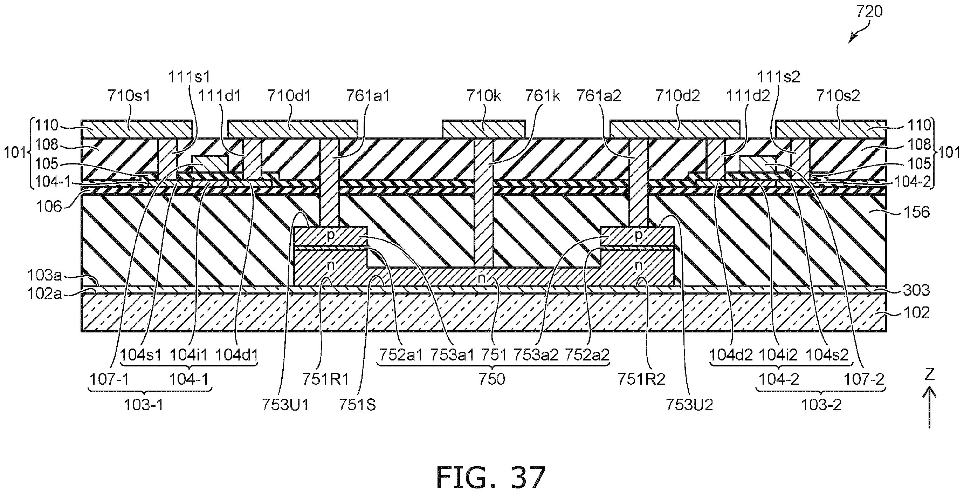

FIG. 37 is a schematic cross-sectional view exemplifying a portion of an image display device according to a seventh embodiment.

[FIG. 38]

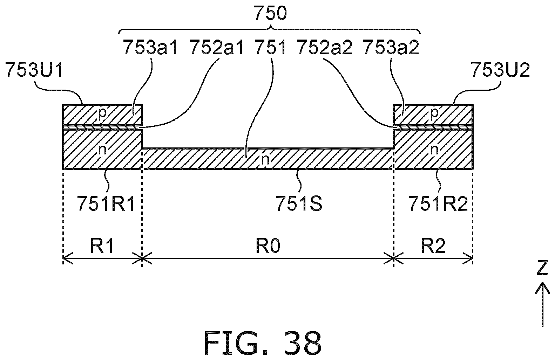

FIG. 38 is a schematic cross-sectional view exemplifying a portion of the image display device according to the seventh embodiment.

[FIG. 39]

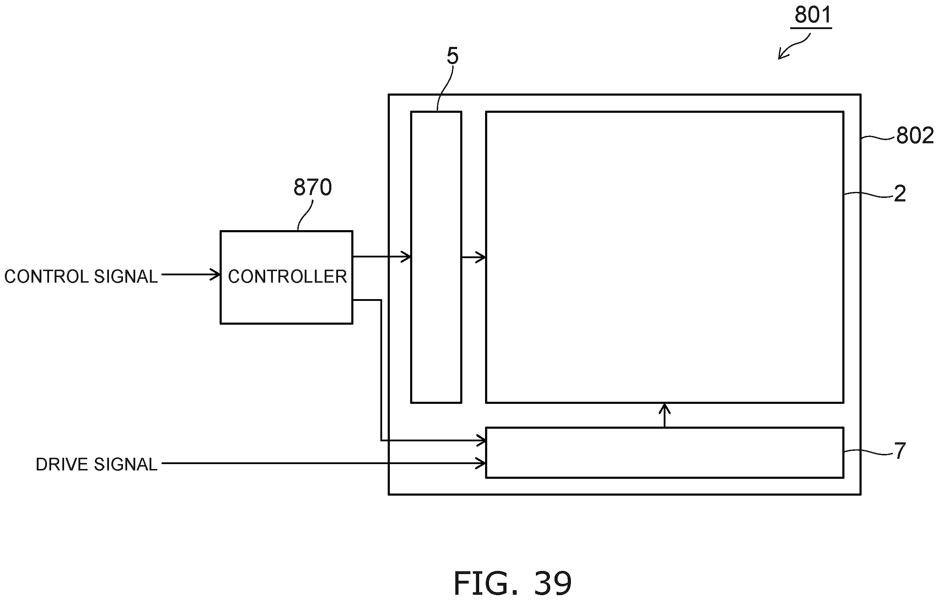

FIG. 39 is a block diagram exemplifying an image display device according to an eighth embodiment.

[FIG. 40]

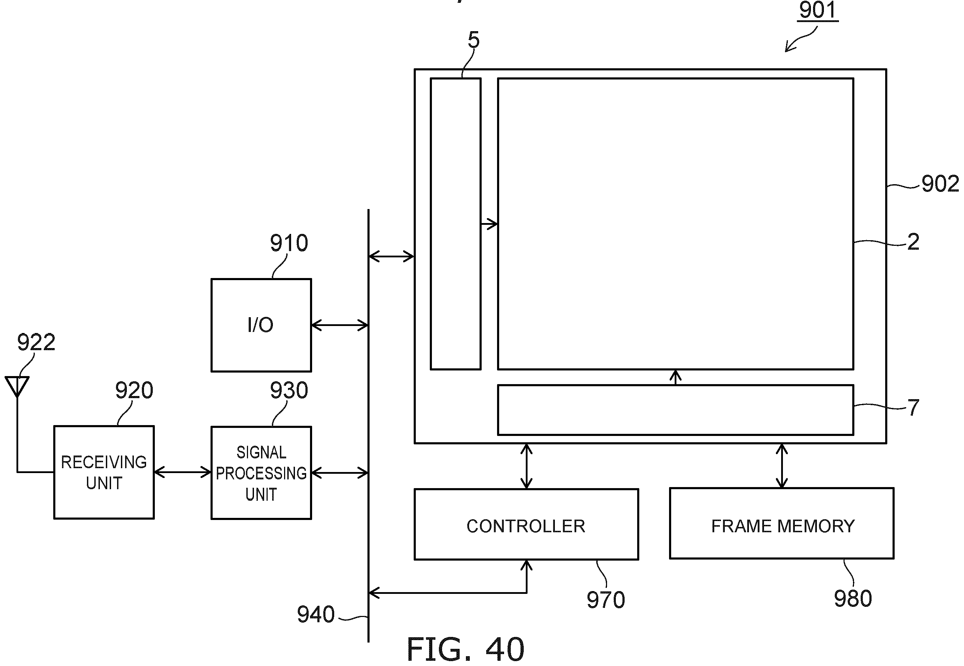

FIG. 40 is a block diagram exemplifying an image display device according to a modified example of the eighth embodiment.

[Description of Embodiments]

Embodiments of the present invention will be described below with reference to the drawings. Note that the drawings are schematic or conceptual, and the relationships between thicknesses and widths of portions, the proportions of sizes between portions, and the like are not necessarily the same as the actual values thereof. Further, the dimensions and the proportions may be illustrated differently between the drawings, even in a case in which the same portion is illustrated.

Note that, in the specification and the drawings, elements similar to those described in relation to a drawing thereinabove are denoted using like reference signs, and a detailed description is omitted as appropriate.

First Embodiment

FIG. 1 is a schematic cross-sectional view exemplifying a portion of an image display device according to the present embodiment.

FIG. 1 schematically illustrates a configuration of a sub-pixel 20 of the image display device according to the present embodiment. Of the present embodiment and other embodiments described below, a second embodiment, a fourth embodiment, a sixth embodiment, and a seventh embodiment illustrate examples of cases in which a color filter is not mounted. Thus, in a case in which these image display devices are monochrome or the like, for example, a sub-pixel is a single pixel. In the present specification, regardless of whether one pixel is formed by one sub-pixel or one pixel is formed by a plurality of sub-pixels, a light-emitting device including one light-emitting element is referred to as a sub-pixel.

In the following, description may sometimes be made using a three-dimensional coordinate system of XYZ. A light-emitting element 150 is arrayed in a two-dimensional planar shape, as illustrated in FIG. 9 described below. The light-emitting element 150 is provided for every sub-pixel 20. The two-dimensional plane in which the sub-pixels 20 are arrayed is defined as an XY plane. The sub-pixels 20 are arrayed in an X-axis direction and a Y-axis direction. FIG. 1 illustrates an aligned section view taken along the lines AA' in FIG. 3 described below, and is a cross-sectional view in which cross sections in a plurality of planes perpendicular to the XY plane are connected together on one plane. In other drawings as well, in a cross-sectional view of a plurality of planes perpendicular to the XY plane, the Z axis perpendicular to the XY plane is illustrated without illustrating the X axis and the Y axis, as in FIG. 1. That is, in these drawings, the plane perpendicular to the Z axis is the XY plane.

In the following, a positive direction of the Z axis may be referred to as "above" or "upward" and a negative direction of the Z axis may be referred to as "below" or "downward," but the direction along the Z axis is not necessarily limited to the direction in which gravity is applied. A length in the direction along the Z axis may be referred to as a height.

The sub-pixel 20 includes a light-emitting surface 151S substantially parallel to the XY plane. The light-emitting surface 151S is a surface that emits light mainly in the negative direction of the Z axis perpendicular to the XY plane. In the present embodiment and all embodiments described below, the light-emitting surface emits light in the negative direction of the Z axis.

As illustrated in FIG. 1, the sub-pixel 20 of the image display device includes a substrate 102, the light-emitting element 150, a first interlayer insulating film 156, a transistor (circuit element) 103, a second interlayer insulating film 108, a via 161a, and a first wiring layer 110.

In the present embodiment, the substrate 102 includes two surfaces, and a bonding layer 303 is provided on one surface 102a. The bonding layer 303 includes a first surface 103a. The first surface 103a is a flat surface substantially parallel to the XY plane. In a case in which a color filter is provided in the image display device of the present embodiment, the color filter is formed on the other surface 102b of the substrate 102. The other surface 102b is a surface on a side opposite to the one surface 102a. In the other embodiments described below as well, in a case in which a color filter is not provided, the color filter may be provided on, of the two surfaces of the substrate, the surface on the side opposite to the surface on which the light-emitting element is formed, as described above.

The substrate 102 is a light-transmitting substrate and is, for example, a glass substrate. The bonding layer 303 is formed of a material having light transmittance, and is a layer formed of an oxide or a nitride of an inorganic material such as $SiO_2$, for example. The bonding layer 303 provides a flat surface for arraying a number of light-emitting elements 150 on the first surface 103a. The bonding layer 303 facilitates bonding in a wafer bonding process of the manufacturing method of the image display device according to the present embodiment.

The light-emitting element 150 is provided on the first surface 103a. The light-emitting element 150 is driven by the transistor 103 provided with the first interlayer insulating film 156 interposed therebetween. The transistor 103 is a thin film transistor (TFT) and is formed on the first interlayer insulating film 156. The process of forming circuit elements including the TFT on a large glass substrate is established for the manufacture of a liquid crystal panel, an organic electroluminescent (EL) panel, and the like, resulting in the advantage that an existing plant can be utilized.

Below, the configuration of the sub-pixels 20 will be described in detail.

The light-emitting element 150 includes the light-emitting surface 151S provided on the first surface 103a. The light-emitting element 150 includes an upper surface 153U provided on a side opposite to the light-emitting surface 151S. In this example, outer peripheral shapes of the light-emitting surface 151S and the upper surface 153U in XY plan view are square or rectangular, and the light-emitting element 150 is an element having a prism shape including the light-emitting surface 151S on the first surface 103a. A cross section of the prism shape may be a polygon with five or more sides. The light-emitting element 150 is not limited to an element having a prism shape, and may be an element having a column shape.

The light-emitting element 150 includes an n-type semiconductor layer 151, a light-emitting layer 152, and a p-type semiconductor layer 153. The n-type semiconductor layer 151, the light-emitting layer 152, and the p-type semiconductor layer 153 are layered in this order from the light-emitting surface 151S toward the upper surface 153U. The light-emitting surface 151S, which is the n-type semiconductor layer 151, is provided in contact with the first surface 103a. Accordingly, the light-emitting element 150 emits light in the negative direction of the Z axis, through the bonding layer 303 and the substrate 102.

The n-type semiconductor layer 151 includes a connecting portion 151a. The connecting portion 151a protrudes over the first surface 103a in one direction from the n-type semiconductor layer 151. A height of the connecting portion 151a from the first surface 103a is the same as a height of the n-type semiconductor layer 151 from the first surface 103a, or is lower than the height of the n-type semiconductor layer 151 from the first surface 103a. The connecting portion 151a is a portion of the n-type semiconductor layer 151. The connecting portion 151a is connected to one end of a via 161k, and thus the n-type semiconductor layer 151 is electrically connected to the via 161k through the connecting portion 151a.

In a case in which the light-emitting element 150 has a shape of a prism, the shape of the light-emitting element 150 in XY plan view is, for example, substantially square or rectangular. In a case in which the shape of the light-emitting element 150 in XY plan view is a polygon, including a square, corner portions of the light-emitting element 150 may be rounded. In a case in which the shape of the light-emitting element 150 in XY plan view is a column, the shape of the light-emitting element 150 in XY plan view is not limited to being circular, and may be, for example, elliptical. With appropriate selection of the shape, the arrangement, and the like of the light-emitting element in plan view, a degree of freedom of the wiring line layout and the like is improved.

As the light-emitting element 150, a gallium nitride compound semiconductor including a light-emitting layer such as $In_XAl_YGa_{1-X-Y}N$ (where $0 \leq X$, $0 \leq Y$, $X + Y < 1$), for example, is preferably used. Hereinafter, the gallium nitride compound semiconductor described above may be simply referred to as gallium nitride (GaN). The light-emitting element 150 in one embodiment of the present invention is a so-called light-emitting diode. A wavelength of light emitted by the light-emitting element 150 need only be a wavelength in a range of the visible light region from the near-ultraviolet region, and is, for example, in a range about 467 nm $\pm$ 30 nm. The light emitted by the light-emitting elements 150 has a wavelength of about 410 nm $\pm$ 30 nm corresponding to blue violet emission. The wavelength of the light emitted by the light-emitting element 150 is not limited to the values described above and may be an appropriate value.

The first interlayer insulating film (first insulating film) 156 covers the first surface 103a and the light-emitting element 150. The first interlayer insulating film 156 electrically separates the light-emitting elements 150 disposed adjacent to each other. The first interlayer insulating film 156 electrically separates the light-emitting element 150 from a circuit element such as the transistor 103. The first interlayer insulating film 156 provides a flat surface for forming a circuit 101 including a circuit element such as the transistor 103. The first interlayer insulating film 156 covers the light-emitting element 150, thereby protecting the light-emitting element 150 from thermal stress and the like in a case in which the transistor 103 or the like is formed.

The first interlayer insulating film 156 is preferably formed of an organic insulating material. The organic insulating material used for the first interlayer insulating film 156 is preferably a white resin. With the first interlayer insulating film 156 being a white resin, laterally emitted light of the light-emitting element 150, and return light caused by the interface between the bonding layer 303 and the substrate 102 and the like can be reflected. Therefore, a light emission efficiency of the light-emitting element 150 is substantially improved. Further, the first interlayer insulating film 156 has light reflectivity, making it possible to reflect light scattered upward from the light-emitting element 150 and the like, thereby suppressing light from reaching the transistor 103.

The white resin is formed by dispersing scattering microparticles having a Mie scattering effect in a transparent resin such as a silicon-based resin such as spin-on glass (SOG) or a novolac phenolic resin. The scattering microparticles are colorless or white, and have a diameter of about one-tenth to several times the wavelength of the light emitted by the light-emitting element 150. The scattering microparticles preferably used have a diameter of about one-half of the wavelength of the light. Examples of such scattering microparticles include $TiO_2$, $Al_2O_3$, and ZnO.

Alternatively, the white resin can also be formed by utilizing a number of fine pores or the like dispersed within a transparent resin. In a case in which the first interlayer insulating film 156 is whitened, a $SiO_2$ film or the like layered on SOG or the like and formed by atomic layer deposition (ALD) or chemical vapor deposition (CVD), for example, may be used.

The first interlayer insulating film 156 may be a black resin. With the first interlayer insulating film 156 being a black resin, the scattering of light within the subpixel 20 is suppressed, and stray light is more effectively suppressed. An image display device in which stray light is suppressed can display a sharper image.

A TFT lower layer film 106 is formed across the first interlayer insulating film 156. The TFT lower layer film 106 ensures flatness when the transistor 103 is formed, and protects a TFT channel 104 of the transistor 103 from contamination and the like during heat treatment. The TFT lower layer film 106 is an insulating film such as $SiO_2$, for example.

The transistor 103 is formed on the TFT lower layer film 106. In addition to the transistors 103, circuit elements such as another transistor and a capacitor are formed on the TFT lower layer film 106, and constitute the circuit 101 by a wiring line and the like. For example, in FIG. 2 described below, the transistor 103 corresponds to a drive transistor 26. In addition, in FIG. 2, a selection transistor 24, a capacitor 28, and the like are circuit elements. The circuit 101 is a circuit that includes the TFT channel 104, an insulating layer 105, the second interlayer insulating film 108, vias 111s, 111d, and the first wiring layer 110.

The transistor 103 is a p-channel TFT in this example. The transistor 103 includes the TFT channel 104 and a gate 107. The TFT channel 104 is preferably formed by a low temperature polysilicon (LTPS) process.

In the LTPS process, the TFT channel 104 is formed by poly crystallizing and activating a region of amorphous Si formed on the TFT lower layer film 106. For example, laser annealing by a laser is used for the polycrystallization and activation of the region of amorphous Si. A TFT formed by the LTPS process has sufficiently high mobility.

The TFT channel 104 includes regions 104s, 104i, 104d. The regions 104s, 104i, 104d are all provided on the TFT lower layer film 106. The region 104i is provided between the region 104s and the region 104d. The regions 104s, 104d are doped with a p-type impurity such as boron ions ($B^+$) or boron fluoride ions ($BF^{2+}$) and are in ohmic connection with the vias 111s, 111d.

The gate 107 is provided on the TFT channel 104 with the insulating layer 105 interposed therebetween. The insulating layer 105 insulates the TFT channel 104 and the gate 107 and provides insulation from other adjacent circuit elements. When a potential lower than that of the region 104s is applied to the gate 107, a channel is formed in the region 104i, making it possible to control a current flowing between the regions 104s, 104d.

The insulating layer 105 is, for example, $SiO_2$. The insulating layer 105 may be a multi-layer insulating layer including $SiO_2$, $Si_3N_4$, or the like in accordance with the covered region.

The gate 107 may be formed of, for example, polycrystalline Si, or may be formed of a metal with a high melting point, such as W or Mo. When formed of a polycrystalline Si film, the gate 107 is formed by, for example, CVD.

The second interlayer insulating film 108 is provided on the gate 107 and the insulating layer 105. The second interlayer insulating film 108 is formed of the same material as that of the first interlayer insulating film 156, for example. That is, the second interlayer insulating film 108 is formed of an organic film such as a white resin or $SiO_2$ or the like. The second interlayer insulating film 108 functions as a flattening film for forming the first wiring layer 110.

The vias 111s, 111d pass through the second interlayer insulating film 108 and the insulating layer 105. The first wiring layer 110 is formed on the second interlayer insulating film 108. The first wiring layer 110 includes a plurality of wiring lines that can differ in electrical potential. In this example, the first wiring layer 110 includes wiring lines 110s, 110d, 110k. These wiring lines 110s, 110d, 110k are separated.

A portion of the wiring line 110s is provided above the region 104s. Another portion of the wiring line 110s is connected to a power source line 3 illustrated in FIG. 2 described below, for example. A portion of the wiring line (first wiring line) 110d is provided above the region 104d. Another portion of the wiring line 110d is provided above the upper surface 153U. A portion of the wiring line (second wiring line) 110k is provided above the connecting portion 151a. Another portion of the wiring line 110k is connected to a ground line 4 illustrated in the circuit in FIG. 2 described below, for example.

In the cross-sectional view of FIG. 1 and thereafter, unless otherwise indicated, the reference sign representing a wiring layer is displayed next to the wiring line constituting the wiring layer.

The via 111s is provided between the wiring line 110s and the region 104s and allows electrical connection between the wiring line 110s and the region 104s. The via 111d is provided between the wiring line 110d and the region 104d and allows electrical connection between the wiring line 110d and the region 104d.

The wiring line 110s is connected to the region 104s through the via 111s. The region 104s is a source region of the transistor 103. Accordingly, the source region of the transistor 103 is electrically connected to the power source line 3 illustrated in the circuit in FIG. 2 described below, for example, through the via 111s and the wiring line 110s.

The wiring line 110d is connected to the region 104d through the via 111d. The region 104d is a drain region of the transistor 103.

The via (first via) 161a passes through the second interlayer insulating film 108, the insulating layer 105, the TFT lower layer film 106, and the first interlayer insulating film 156. The via 161a is provided between the wiring line (first wiring line) 110d and the upper surface 153U, and allows electrical connection between the wiring line 110d and the p-type semiconductor layer 153. Accordingly, the p-type semiconductor layer 153 is electrically connected to the drain region of the transistor 103 through the via 161a, the wiring line 110d, and the via 111d.

The via (second via) 161k passes through the second interlayer insulating film 108, the insulating layer 105, the TFT lower layer film 106, and the first interlayer insulating film 156. The via 161k is provided between the wiring line (second wiring line) 110k and the connecting portion 151a, and allows electrical connection between the wiring line 110k and the connecting portion 151a. Accordingly, the n-type semiconductor layer 151 is electrically connected to the ground line 4 illustrated in the circuit in FIG. 2, for example, through the connecting portion 151a, the via 161k, and the wiring line 110k.

The first wiring layer 110 and the vias 111s, 111d, 161k are formed of Al, an Al alloy, or a layered film of Al and Ti or the like, for example. In a layered film of Al and Ti, for example, Al is layered on a thin film of Ti, and Ti is further layered on Al.

A protective layer covering these for protection from the external environment may be provided across the second interlayer insulating film 108 and the first wiring layer 110.

FIG. 2 is a schematic block diagram exemplifying an image display device according to the present embodiment.

As illustrated in FIG. 2, an image display device 1 according to the present embodiment includes a display region 2. The sub-pixels 20 are arrayed in the display region 2. The sub-pixels 20 are arrayed, for example, in a lattice pattern. For example, n sub-pixels 20 are arrayed along the X axis, and m sub-pixels 20 are arrayed along the Y axis.

The image display device 1 further includes the power source line 3 and the ground line 4. The power source line 3 and the ground line 4 are wired in a lattice pattern along the array of the sub-pixels 20. The power source line 3 and the ground line 4 are electrically connected to each sub-pixel 20, and power is supplied to each sub-pixel 20 from a direct current power source connected between a power source terminal 3a and a ground (GND) terminal 4a. The power source terminal 3a and the GND terminal 4a are respectively provided at end portions of the power source line 3 and the ground line 4, and are connected to a direct current power source circuit provided outside the display region 2. A positive voltage is supplied to the power source terminal 3a based on the GND terminal 4a.

The image display device 1 further includes a scanning line 6 and a signal line 8. The scanning line 6 is wired in a direction parallel to the X axis. That is, the scanning line 6 is wired along the array of the sub-pixels 20 in a row direction. The signal line 8 is wired in a direction parallel to the Y axis. That is, the signal line 8 is wired along the array of the sub-pixels 20 in a column direction.

The image display device 1 further includes a row selection circuit 5 and a signal voltage output circuit 7. The row selection circuit 5 and the signal voltage output circuit 7 are provided along an outer edge of the display region 2. The row selection circuit 5 is provided in the Y-axis direction of the outer edge of the display region 2. The row selection circuit 5 is electrically connected to the sub-pixel 20 of each column via the scanning line 6, and supplies a selection signal to each sub-pixel 20.

The signal voltage output circuit 7 is provided in the X-axis direction of the outer edge of the display region 2. The signal voltage output circuit 7 is electrically connected to the sub-pixel 20 of each row via the signal line 8, and supplies a signal voltage to each sub-pixel 20.

The sub-pixel 20 includes a light-emitting element 22, the selection transistor 24, the drive transistor 26, and the capacitor 28. In FIGS. 2 and 3 described below, the selection transistor 24 may be denoted as T1, the drive transistor 26 may be denoted as T2, and the capacitor 28 may be denoted as Cm.

The light-emitting element 22 is connected in series with the drive transistor 26. In the present embodiment, the drive transistor 26 is a p-channel TFT, and an anode electrode of the light-emitting element 22 is connected to a drain electrode of the drive transistor 26. The main electrodes of the drive transistor 26 and the selection transistor 24 are a drain electrode and a source electrode. The anode electrode of the light-emitting element 22 is connected to the p-type semiconductor layer. A cathode electrode of the light-emitting element 22 is connected to the n-type semiconductor layer. The series circuit of the light-emitting element 22 and the drive transistor 26 is connected between the power source line 3 and the ground line 4. The drive transistor 26 corresponds to the transistor 103 in FIG. 1, and the light-emitting element 22 corresponds to the light-emitting element 150 in FIG. 1. The current flowing to the light-emitting element 22 is determined by the voltage applied across the gate-source of the drive transistor 26, and the light-emitting element 22 emits light at a brightness corresponding to the current flowing to the light-emitting element 22.

The selection transistor 24 is connected between a gate electrode of the drive transistor 26 and the signal line 8 via the main electrode. A gate electrode of the selection transistor 24 is connected to the scanning line 6. The capacitor 28 is connected between the gate electrode of the drive transistor 26 and the power source line 3.

The row selection circuit 5 selects one row from the array of m rows of the sub-pixels 20 to supply a selection signal to the scanning line 6. The signal voltage output circuit 7 supplies a signal voltage having the required analog voltage value to each sub-pixel 20 in the selected row. The signal voltage is applied across the gate-source of the drive transistor 26 of the sub-pixels 20 of the selected row. The signal voltage is held by the capacitor 28. The drive transistor 26 introduces a current corresponding to the signal voltage to the light-emitting element 22. The light-emitting element 22 emits light at a brightness in accordance with the flowing current.

The row selection circuit 5 supplies the selection signal by sequentially switching the selected row. That is, the row selection circuit 5 scans the rows in which the sub-pixels 20 are arrayed. A current corresponding to the signal voltage flows in the light-emitting element 22 of the sub-pixels 20 sequentially scanned, and light is emitted. The brightness of the sub-pixel 20 is determined by the current flowing in the light-emitting element 22. The sub-pixel 20 emits light on a gray scale based on the determined brightness, and the image is displayed in the display region 2.

FIG. 3 is a schematic plan view exemplifying a portion of the image display device according to the present embodiment.

In FIG. 3, the AA' lines represent cut lines in a cross-sectional view of FIG. 1 and the like.

In the present embodiment, the light-emitting element 150 and the drive transistor 103 are layered in the Z axis direction with the first interlayer insulating film 156 interposed therebetween. The light-emitting element 150 corresponds to the light-emitting element 22 in FIG. 2. The drive transistor 103 corresponds to the drive transistor 26 in FIG. 2, and is also denoted as T2.

As illustrated in FIG. 3, a cathode electrode of the light-emitting element 150 is provided by the connecting portion 151a. The connecting portion 151a is provided in a lower layer underlying the transistor 103 and the first wiring layer 110. The connecting portion 151a is electrically connected to the wiring line 110k through the via 161k. More specifically, one end of the via 161k is connected to the connecting portion 151a. The other end of the via 161k is connected to the wiring line 110k through a contact hole 161k1.

An anode electrode of the light-emitting element 150 is provided by the p-type semiconductor layer 153 illustrated in FIG. 1. The upper surface 153U of the p-type semiconductor layer 153 is connected to the wiring line 110d through the via 161a. More specifically, one end of the via 161a is connected to the upper surface 153U. The other end of the via 161a is connected to the wiring line 110d through a contact hole 161a1.

The other end of the wiring line 110d is connected to a drain electrode of the transistor 103 through the via 111d illustrated in FIG. 1. The drain electrode of the transistor 103 is the region 104d illustrated in FIG. 1. A source electrode of the transistor 103 is connected to the wiring line 110s through the via 111s illustrated in FIG. 1. The source electrode of the transistor 103 is the region 104s illustrated in FIG. 1. In this example, the first wiring layer 110 includes the power source line 3, and the wiring line 110s is connected to the power source line 3.

In this example, the ground line 4 is further provided in an upper layer overlying the first wiring layer 110. Although not illustrated in FIG. 1, an interlayer insulating film is further provided on the first wiring layer 110. The ground line 4 is provided on the interlayer insulating film in the uppermost layer and insulated from the power source line 3.

In this way, the light-emitting element 150 can be electrically connected to the first wiring layer 110 provided in an upper layer overlying the light-emitting element 150 by using the vias 161k, 161a.

A manufacturing method of the image display device 1 according to the present embodiment will now be described.

FIGS. 4A to 5B are schematic cross-sectional views exemplifying portions of the manufacturing method of the image display device according to the present embodiment.

As illustrated in FIG. 4A, in the manufacturing method of the image display device 1 of the present embodiment, a semiconductor growth substrate 1194 is prepared. The semiconductor growth substrate 1194 includes a crystal growth substrate 1001 and a semiconductor layer 1150. The crystal growth substrate 1001 is a Si substrate or a sapphire substrate, for example. Preferably, a Si substrate is used as the crystal growth substrate 1001. Further, in a case in which a low temperature crystal growth process such as a low temperature sputtering method is used as described below, a glass substrate or the like that is less expensive can be used.

The semiconductor layer 1150 is formed on the crystal growth substrate 1001. The semiconductor layer 1150 includes an n-type semiconductor layer 1151, a light-emitting layer 1152, and a p-type semiconductor layer 1153. The n-type semiconductor layer 1151, the light-emitting layer 1152, and the p-type semiconductor layer 1153 are layered in this order from the crystal growth substrate 1001 side.

For formation of the semiconductor layer 1150, a chemical vapor deposition (CVD) method, for example, is used, and metal-organic chemical vapor deposition (MOCVD) method is suitably used. Alternatively, epitaxial crystal growth of the semiconductor layer 1150 is possible even at a process temperature of 700°C or less by using a low temperature sputtering method. By using such a low temperature sputtering method, a glass substrate or a device having low heat resistance can be used, making it possible to reduce manufacturing costs.

The semiconductor layer 1150 includes, for example GaN, and more specifically includes $In_XAl_YGa_{1-X-Y}N$ ($0 \leq X$, $0 \leq Y$, and $X + Y < 1$) or the like.

In the early stage of crystal growth, crystal defects may occur due to inconsistency of crystal lattice constants, and a crystal with a crystal defect exhibits an n-shape. Therefore, as in this example, in a case in which the semiconductor layer 1150 is formed from the n-type semiconductor layer 1151 on the crystal growth substrate 1001, a margin in terms of the production process can be increased, resulting in the advantage that yield is readily improved.

In a case in which the semiconductor layer 1150 is formed on the crystal growth substrate 1001, the semiconductor layer 1150 may be formed with a buffer layer not illustrated in FIG. 4A interposed therebetween. A nitride such as AlN, for example, is used for the buffer layer. By growing the crystal of the semiconductor layer 1150 on the crystal growth substrate 1001 with a buffer layer interposed therebetween, mismatch at the interface can be mitigated between the GaN crystal and the crystal growth substrate 1001. It is expected, therefore, that the quality of the crystal of the semiconductor layer 1150 is improved. On the other hand, in the present embodiment, the n-type semiconductor layer 1151 is bonded to the first surface 103a, and thus the process of removing the buffer layer before the bonding is added. In the case of the other embodiments described below as well, the semiconductor layer 1150 may be formed with a buffer layer interposed therebetween.

As illustrated in FIG. 4B, a support substrate 1190 is prepared. The support substrate 1190 is formed of, for example, quartz glass or Si. The semiconductor growth substrate 1194 is disposed with an exposed surface 1153E of the p-type semiconductor layer 1153 facing one surface 1190E of the support substrate 1190. The semiconductor layer 1150 is joined to the support substrate 1190. After the support substrate 1190 is joined to the semiconductor layer 1150, the crystal growth substrate 1001 is removed. To remove the crystal growth substrate 1001, wet etching or laser lift-off, for example, is used.

As illustrated in FIG. 5A, the semiconductor layer 1150 of a substrate 1195 is bonded to the first surface 103a of the substrate 102. The surface bonded to the first surface 103a is an exposed surface 1151E of the n-type semiconductor layer 1151. Subsequently, as illustrated in FIG. 5B, the support substrate 1190 is removed. For removal of the support substrate 1190 as well, wet etching or laser lift-off is used.

In the process of substrate bonding, for example, each of the substrates are heated and then bonded together by thermal compression bonding. In addition to the above, the bonding surface of each substrate may be flattened using chemical mechanical polishing (CMP) or the like, and the bonding surfaces may be cleaned by a plasma treatment in a vacuum and brought into close contact.

In a case in which the semiconductor layer 1150 is bonded to the substrate 102, sometimes one semiconductor layer 1150 is be bonded to one substrate 102 and sometimes a plurality of the semiconductor layers 1150 are bonded to one substrate 102. When one semiconductor layer 1150 is bonded to one substrate 102, a size of the substrate 102 can be, for example, a rectangular shape or a square shape in a range from several 10s of mm square to 150 mm square. In this case, the semiconductor layer 1150 formed on the substrate 1195 can be sized in accordance with the size of the substrate 102.

When a plurality of the semiconductor layers 1150 are bonded to one substrate 102, a substantially rectangular glass substrate of about 1500 mm x 1800 mm can be used, for example. The semiconductor layer 1150 formed on the substrate 1195 has a rectangular shape or a square shape in a range from about several 10s of mm square to 150 mm square, and can be, upon conversion into wafer dimensions, a size in a range from about 4 inches to 6 inches, for example. The size of the substrate 102 is selected as appropriate in accordance with a size of the image display device and the like.

FIG. 6 is a schematic perspective view exemplifying a portion of the manufacturing method of the image display device according to the present embodiment.

FIG. 6 schematically illustrates an example when a plurality of the semiconductor layers 1150 are bonded to one substrate 102.

The view above the arrow in FIG. 6 illustrates that the plurality of substrates 1195 are disposed in a lattice pattern. The view below the arrow in FIG. 6 illustrates that the substrate 102 is disposed with the bonding layer 303 formed thereon. FIG. 6 illustrates by the arrow that the plurality of substrates 1195 disposed in lattice pattern are bonded at positions outlined by two-dot chain lines.

The quality of the crystal at or near end portions of the semiconductor layer 1150 deteriorates, making it necessary to take care not to form the light-emitting element 150 at or near the end portions of the semiconductor layer 1150.

As illustrated in FIG. 6, the end portions of the semiconductor layer 1150 substantially match end portions of the support substrate 1190. Therefore, the plurality of substrates 1195 are disposed in a lattice pattern facing the substrate 102 without causing, to the extent possible, a gap to occur between the substrates 1195 adjacent to each other, as indicated by solid lines in FIG. 6, for example. The semiconductor layer 1150 is bonded onto the first surface 103a of the substrate 102 as indicated by the two-dot chain lines in FIG. 6.

In a case in which a plurality of the semiconductor layers 1150 are bonded to one substrate 102, the substrate 102 on which the plurality of semiconductor layers 1150 are bonded can be divided to create image display devices of a quantity and a size corresponding to the number of divisions. The end portions of the semiconductor layer 1150 having a deteriorated crystal quality are preferably end portions of the display region, and thus the unit of division of the substrate 102 is preferably set to match the shape of the substrate 1195.

The process up to formation of the semiconductor growth substrate 1194 and the process of performing the processing after formation of the substrate 1195 may be executed at the same plant or at different plants. For example, the substrate 1195 may be manufactured by a first plant, and the substrate 1195 may be transported to a second plant different from the first plant to execute the bonding process.

The method of bonding the semiconductor layer 1150 to the substrate 102 is not limited to the above, and may be the following method. That is, the semiconductor layer 1150 is formed on the crystal growth substrate 1001, subsequently accommodated in a container, and then stored after, for example, mounting the support substrate 1190 in the container. After storage, the semiconductor layer 1150 is removed from the container and bonded to the substrate 102. Alternatively, the semiconductor layer 1150 is stored in the container without being mounted to the support substrate 1190. After storage, the semiconductor layer 1150 is removed from the container and then bonded to the substrate 102.

FIGS. 7A to 8B are schematic cross-sectional views exemplifying portions of the manufacturing method of the image display device according to the present embodiment.

As illustrated in FIG. 7A, the semiconductor layer 1150 illustrated in FIG. 5B is processed into a desired shape by etching, forming the light-emitting element 150. In the light-emitting element 150, the connecting portion 151a is formed, and subsequently other portions are formed by further etching. As a result, it makes it possible to form the light-emitting element 150 including the connecting portion 151a that protrudes over the first surface 103a from the n-type semiconductor layer 151 in the positive direction of the X axis. For the formation of the light-emitting element 150, a dry etching process, for example, is used, and anisotropic ion etching (reactive ion etching (RIE)) is suitably used.

The first interlayer insulating film (first insulating film) 156 covers the first surface 103a and the light-emitting element 150.

As illustrated in FIG. 7B, the TFT lower layer film 106 is formed on the first interlayer insulating film 156 by CVD, for example. A Si layer 1104 is formed on the TFT lower layer film 106 thus formed. The Si layer 1104 is a layer of amorphous Si at the time of film formation, and is subsequently scanned a plurality of times after film formation with an excimer laser pulse, for example, thereby forming the polycrystallized Si layer 1104.

As illustrated in FIG. 8A, the transistor 103 is formed at a desired position on the TFT lower layer film 106. For example, in the LTPS process, the transistor 103 is formed as follows.

The polycrystallized Si layer 1104 illustrated in FIG. 7B is processed into an island shape, forming the TFT channel 104. The insulating layer 105 covers the TFT lower layer film 106 and the TFT channel 104. The insulating layer 105 functions as a gate insulating film. On the TFT channel 104, the gate 107 is formed with the insulating layer 105 interposed therebetween. The transistor 103 is formed by selectively doping the gate 107 with and thermally activating an impurity such as $B^+$. The regions 104s, 104d are p-type active regions, and respectively function as a source region and a drain region of the transistor 103. The region 104i is an n-type active region and functions as a channel.

As illustrated in FIG. 8B, the second interlayer insulating film (second insulating film) 108 covers the insulating layer 105 and the gate 107. For formation of the second interlayer insulating film 108, an appropriate manufacturing method is applied in accordance with a material of the second interlayer insulating film 108. For example, in a case in which the second interlayer insulating film 108 is formed of $SiO_2$, a technique such as ALD or CVD is used.

A degree of flatness of the second interlayer insulating film 108 need only be to the extent that the first wiring layer 110 can be formed, and a flattening process need not necessarily be performed. In a case in which a flattening process is not applied to the second interlayer insulating film 108, the number of processes can be reduced. For example, in a case in which a location exists where a thickness of the second interlayer insulating film 108 is thin around the light-emitting element 150, a depth of via holes for the vias 161a, 161k can be made shallower, making it possible to ensure a sufficient opening diameter. As a result, it is easier to ensure electrical connections through the vias, making it possible to suppress a reduction in yield caused by poor electrical properties.

The vias 161a, 161k are formed through the second interlayer insulating film 108, the insulating layer 105, the TFT lower layer film 106, and the first interlayer insulating film 156. The via 161a reaches the upper surface 153U. The via 161k reaches the connecting portion 151a.

The vias 111s, 111d pass through the second interlayer insulating film 108 and the insulating layer 105. The via 111s reaches the region 104s. The via 111d reaches the region 104d. For via hole formation for forming the vias 161a, 161k, 111s, and 111d, RIE is used, for example.

The first wiring layer 110 is formed on the second interlayer insulating film 108. The wiring lines 110k, 110d, 110s are formed. The wiring line 110k is connected to one end of the via 161k. The wiring line 110d is connected to one end of the via 161a and one end of the via 111d. The wiring line 110s is connected to one end of the via 111s. The first wiring layer 110 may be formed simultaneously with formation of the vias 161k, 161a, 111d, 111s.

In this way, the sub-pixels 20 are formed and the image display device is formed.

FIG. 9 is a schematic perspective view exemplifying the image display device according to the present embodiment.

As illustrated in FIG. 9, the image display device of the present embodiment is provided with a light-emitting circuit portion 172 including a number of the light-emitting elements 150 on the substrate 102. The light-emitting circuit portion 172 is a structure including the light-emitting elements 150 and the first interlayer insulating film 156 covering these. A drive circuit portion 100 is provided on the light-emitting circuit portion 172. The drive circuit portion 100 is a structure including the circuit 101, the second interlayer insulating film, and the TFT lower layer film 106 illustrated in FIG. 1. As described above, the light-emitting circuit portion 172 and the drive circuit portion 100 are electrically connected by the vias 161a, 161k.

The configuration illustrated in FIG. 9 is an example of the image display device of the present embodiment in a case in which a color filter is not provided, and is applied in cases in which a color filter is not provided in other embodiments described below.

Effects of the image display device 1 of the present embodiment will now be described.

In the manufacturing method of the image display device 1 according to the present embodiment, the semiconductor layer 1150 is bonded to the substrate 102 and subsequently etched to form the light-emitting elements 150. Subsequently, the light-emitting element 150 is covered with the first interlayer insulating film 156, and the circuit 101 including circuit elements such as the transistor 103 that drives the light-emitting element 150 is created on the first interlayer insulating film 156. As a result, the manufacturing process is significantly shortened compared to individually transferring separated pieces of the light-emitting elements to the substrate 102.

For example, the number of sub-pixels exceeds 24 million in an image display device with 4K image quality, and exceeds 99 million in the case of an image display device with 8K image quality. To individually form and mount onto a circuit substrate such a large number of light-emitting elements requires an enormous amount of time. This makes it difficult to realize an image display device that uses micro LEDs at a realistic cost. Further, individually mounting a large number of light-emitting elements reduces yield due to connection failure and the like during mounting, and thus further increases in cost cannot be avoided. However, the manufacturing method of the image display device of the present embodiment has effects such as the following.

As described above, in the manufacturing method of the image display device 1 according to the present embodiment, the entire semiconductor layer 1150 is bonded to the substrate 102 and the light-emitting elements are subsequently formed by etching, and thus the transfer process is completed in one undertaking. Therefore, the manufacturing method of the image display device 1 in the present embodiment can shorten the time of the transfer process and reduce the number of processes compared to the manufacturing methods in the related art.

Furthermore, the semiconductor layer 1150 is bonded to the substrate 102 at the wafer level without being separated into pieces in advance or forming electrodes at positions corresponding to the circuit elements. Therefore, alignment at the bonding stage is unnecessary. Accordingly, the bonding process can be easily performed in a short period of time. Without the need for position alignment at the time of bonding, the size of the light-emitting element 150 is readily reduced, which is suitable for a high-definition display.

In the present embodiment, for example, a glass substrate formed as described above is covered with the first interlayer insulating film 156, making it possible to form a drive circuit or a scanning circuit including a TFT or the like on a flattened surface using an LTPS process or the like. As a result, there is an advantage that a manufacturing process and a plant of an existing flat panel display can be utilized.

In the present embodiment, the light-emitting element 150 formed in a lower layer underlying the transistor 103 and the like can be electrically connected to a power source line, a ground line, a drive transistor, and the like formed in an upper layer by forming the vias 161a, 161k passing through the first interlayer insulating film 156, the TFT lower layer film 106, the insulating layer 105, and the second interlayer insulating film 108. By using this technically established multilayer wiring technique, a uniform connection structure can easily be achieved and thus yield can be improved. Accordingly, a reduction in yield due to connection failure of a light-emitting element or the like is suppressed.

In the image display device 1 according to the present embodiment, the light-emitting elements 150 are covered by the first interlayer insulating film 156. In a case in which the first interlayer insulating film 156 is formed of a material having high light reflectivity, such as a white resin, the scattering and the like of the light-emitting element 150 in a direction other than the direction of the light-emitting surface 151S can be reflected toward the light-emitting surface 151S side. Therefore, the scattered light or the like is suppressed from reaching the transistor 103, preventing malfunction of the transistor 103.

Second Embodiment

FIG. 10 is a schematic cross-sectional view exemplifying a portion of an image display device according to the present embodiment.

As illustrated in FIG. 10, the image display device of the present embodiment includes a sub-pixel 220, and the sub-pixel 220 differs from that of the other embodiment described above in that a p-type semiconductor layer 253 provides a light-emitting surface 253S. In the present embodiment, the configuration of a light-emitting element 250 differs from that of the other embodiment described above, and thus the configuration of a transistor 203 that drives the light-emitting element 250 also differs. Components that are the same as those of the other embodiment are denoted by the same reference signs, and detailed descriptions thereof will be omitted as appropriate.

The sub-pixel 220 of the image display device of the present embodiment includes the substrate 102, the light-emitting element 250, the first interlayer insulating film 156, the transistor 203, the second interlayer insulating film 108, a via 261k, and the first wiring layer 110.

The light-emitting element 250 is provided on the first surface 103a. The light-emitting element 250 includes the light-emitting surface 253S provided on the first surface 103a. The light-emitting surface 253S is in contact with the first surface 103a. The light-emitting element 250 includes an upper surface 251U provided on a side opposite to the light-emitting surface 253S. The light-emitting element 250 is an element having a prism shape or a column shape, as in the other embodiment described above.

The light-emitting element 250 includes the p-type semiconductor layer 253, a light-emitting layer 252, and an n-type semiconductor layer 251. The p-type semiconductor layer 253, the light-emitting layer 252, and the n-type semiconductor layer 251 are layered in this order from the light-emitting surface 253S toward the upper surface 251U. In the present embodiment, the light-emitting surface 253S is provided by the p-type semiconductor layer 253.

The light-emitting element 250 includes a connecting portion 253a. The connecting portion 253a protrudes over the first surface 103a in one direction from the p-type semiconductor layer 253. A height of the connecting portion 253a from the first surface 103a is the same as or lower than a height of the p-type semiconductor layer 253 from the first surface 103a. The connecting portion 253a is a portion of the p-type semiconductor layer 253. The connecting portion 253a is connected to one end of a via 261a and electrically connects the p-type semiconductor layer 253 to the via 261a.

The light-emitting element 250 has the same shape as that of the light-emitting element 150 of the other embodiment described above in XY plan view. An appropriate shape is selected according to the layout of the circuit elements and the like.

The light-emitting element 250 is a light-emitting diode similar to that of the light-emitting element 150 of the other embodiment described above. That is, light emitted by the light-emitting element 250 has a wavelength of, for example, about 467 nm ± 30 nm corresponding to blue light emission or about 410 nm ± 30 nm corresponding to blue violet light emission. The wavelength of the light emitted by the light-emitting element 250 is not limited to the values described above and may be an appropriate value.

The transistor 203 is formed on the TFT lower layer film 106. The transistor 203 is an n-channel TFT. The transistor 203 includes a TFT channel 204 and the gate 107. Preferably, the transistor 203 is formed by an LTPS process or the like as in the other embodiment described above. In the present embodiment, the circuit 101 includes the TFT channel 204, the insulating layer 105, the second interlayer insulating film 108, the vias 111s, 111d, and the first wiring layer 110.

The TFT channel 204 includes regions 204s, 204i, 204d. The regions 204s, 204i, 204d are provided on the TFT lower layer film 106. The regions 204s, 204d are doped with an n-type impurity such as phosphorus ions (P⁻). The region 204s is ohmic connected to the via 111s. The region 204d is ohmic connected to the via 111d.

The gate 107 is provided on the TFT channel 204 with the insulating layer 105 interposed therebetween. The insulating layer 105 insulates the TFT channel 204 and the gate 107.

In the transistor 203, when a voltage greater than that of the region 204s is applied to the gate 107, a channel is formed in the region 204i. A current flowing between the regions 204s, 204d is controlled by the voltage across the region 204s of the gate 107. The TFT channel 204 and the gate 107 are formed of a material and by a manufacturing method that are the same as those of the TFT channels 104 and the gate 107 in the other embodiment described above.

The first wiring layer 110 includes wiring lines 210s, 210d, 210a. A portion of the wiring line (second wiring line) 210a is provided above the connecting portion 253a. Another portion of the wiring line 201a is connected to the power source line 3 illustrated in FIG. 11 described below, for example.

The vias 111s, 111d pass through the second interlayer insulating film 108 and the insulating layer 105. The via 111s is provided between the wiring line 210s and the region 204s. The via 111s allows electrical connection between the wiring line 210s and the region 204s. The via 111d is provided between the wiring line 210d and the region 204d. The via 111d allows electrical connection between the wiring line 210d and the region 204d. The vias 111s, 111d are formed of a material and by a manufacturing method that are the same as those in the other embodiment described above.

The via 261k passes through the second interlayer insulating film 108, the insulating layer 105, the TFT lower layer film 106, and the first interlayer insulating film 156. The via 261k is provided between the wiring line 210d and the upper surface 251U, and allows electrical connection between the wiring line 210d and the upper surface 251U. Accordingly, the n-type semiconductor layer 251 is electrically connected to a drain region of the transistor 203 through the via 261k, the wiring line 210d, and the via 111d.

The via 261a passes through the second interlayer insulating film 108, the insulating layer 105, the TFT lower layer film 106, and the first interlayer insulating film 156. The via 261a is provided between the wiring line 210a and the connecting portion 253a, and allows electrical connection between the wiring line 210a and the connecting portion 253a. Accordingly, the p-type semiconductor layer 253 is electrically connected to the power source line 3 of the circuit in FIG. 11, for example, through the connecting portion 253a, the via 261a, and the wiring line 210a.

FIG. 11 is a schematic block diagram exemplifying the image display device according to the present embodiment.

As illustrated in FIG. 11, an image display device 201 of the present embodiment includes the display region 2, a row selection circuit 205, and a signal voltage output circuit 207. In the display region 2, the sub-pixels 220 are arrayed in a lattice pattern on the XY plane, for example, as in the other embodiment described above.

The sub-pixel 220 includes a light-emitting element 222, a selection transistor 224, a drive transistor 226, and a capacitor 228. In FIG. 11, the selection transistor 224 may be denoted as T1, the drive transistor 226 may be denoted as T2, and the capacitor 228 may be denoted as Cm.

In the present embodiment, the light-emitting element 222 is provided on the power source line 3 side, and the drive transistor 226 connected in series with the light-emitting element 222 is provided on the ground line 4 side. That is, the drive transistor 226 is connected to a potential side lower than that of the light-emitting element 222. The drive transistor 226 is an n-channel transistor.

The selection transistor 224 is connected between a gate electrode of the drive transistor 226 and a signal line 208. The capacitor 228 is connected between the gate electrode of the drive transistor 226 and the ground line 4.

The row selection circuit 205 and the signal voltage output circuit 207 supply a signal voltage of a polarity different from that of the other embodiment described above to the signal line 208 in order to drive the drive transistor 226 that is an n-channel transistor.

In the present embodiment, the polarity of the drive transistor 226 is the n-channel, and thus the polarity of the signal voltage and the like differ from those of the other embodiment described above. That is, the row selection circuit 205 supplies a selection signal to a scanning line 206, sequentially selecting one row from the array of m rows of the sub-pixels 220. The signal voltage output circuit 207 supplies a signal voltage having the required analog voltage value for each sub-pixel 220 in the selected row. The drive transistor 226 of the sub-pixels 220 of the selected row introduces a current corresponding to the signal voltage to the light-emitting element 222. The light-emitting element 222 emits light at a brightness corresponding to the current flowing in the light-emitting element 222.

A manufacturing method of the image display device according to the present embodiment will now be described.

FIGS. 12A to 13 are schematic cross-sectional views exemplifying portions of the manufacturing method of the image display device of the present embodiment.

As illustrated in FIG. 12A, in the manufacturing method of the image display device of the present embodiment, the semiconductor growth substrate 1194 is prepared. The semiconductor growth substrate 1194 has the same configuration as that previously described in connection with FIG. 4A.

As illustrated in FIG. 12B, the semiconductor layer 1150 of the semiconductor growth substrate 1194 is bonded to the substrate 102. In this bonding process, the exposed surface 1153E of the p-type semiconductor layer 1153 is bonded to the first surface 103a.

As illustrated in FIG. 13, the crystal growth substrate 1001 is removed by wet etching or laser lift-off.

FIGS. 14A to FIG. 15B are schematic cross-sectional views exemplifying portions of the manufacturing method of the image display device according to the present embodiment.

In the processes illustrated in FIGS. 14A to 15B, unlike the processes illustrated in FIGS. 12A to 13, the semiconductor layer 1150 is transferred to the support substrate 1190 and subsequently bonded to the substrate 102.

As illustrated in FIG. 14A, a semiconductor growth substrate 1294 is prepared. The semiconductor growth substrate 1294 has a configuration different than that of the semiconductor growth substrate 1194 illustrated in FIGS. 4A and 12A. In the semiconductor growth substrate 1294, the semiconductor layer 1150 is layered in the order of the p-type semiconductor layer 1153, the light-emitting layer 1152, and the n-type semiconductor layer 1151 from the crystal growth substrate 1001 side.

As illustrated in FIG. 14B, the support substrate 1190 is prepared. The exposed surface 1151E of the n-type semiconductor layer 1151 is joined to one surface 1190E of the support substrate 1190.

As illustrated in FIG. 15A, a substrate 1295 is prepared with the semiconductor layer 1150 bonded to the support substrate 1190. The substrate 1295 is bonded to the substrate 102. The surface bonded to the first surface 103a of the substrate 102 is the exposed surface 1153E of the p-type semiconductor layer 1153.

As illustrated in FIG. 15B, the support substrate 1190 is removed. To remove the support substrate 1190, wet etching or laser lift-off is used, as in the other embodiment described above. In this way, the semiconductor layer 1150 can be bonded to the substrate 102.

FIGS. 16A to 17B are schematic cross-sectional views exemplifying portions of the manufacturing method of the image display device according to the present embodiment.

As illustrated in FIG. 16A, the semiconductor layer 1150 illustrated in FIGS. 13 and 15B is processed into a desired shape, forming the light-emitting element 250. In forming the light-emitting element 250, similarly to the other embodiments described above, the connecting portion 253a is formed, and other portions are formed. To form the light-emitting element 250, an etching process similar to that of the other embodiment described above is used.

The first interlayer insulating film 156 covers the first surface 103a and the light-emitting element 250.

As illustrated in FIG. 16B, the TFT lower layer film 106 is formed across the first interlayer insulating film 156. On the TFT lower layer film 106, a layer of amorphous Si is formed, and then the Si layer 1104 polycrystallized by laser annealing using an excimer laser or the like is formed.

As illustrated in FIG. 17A, the polycrystallized Si layer 1104 illustrated in FIG. 16B is processed into an island shape as with the transistor 103 illustrated in FIG. 3, forming the TFT channel 204. The insulating layer 105 covers the TFT lower layer film 106 and the TFT channel 204. On the TFT channel 204, the gate 107 is formed with the insulating layer 105 interposed therebetween. The transistor 203 is formed by selectively doping the gate 107 with and thermally activating an impurity such as P$^-$. The regions 204s, 204d are n-type active regions, and respectively function as a source region and the drain region of the transistor 203. The region 204i is a p-type active region and functions as a channel.

As illustrated in FIG. 17B, the second interlayer insulating film 108 covers the insulating layer 105 and the gate 107. The vias 261k, 261a passes through the second interlayer insulating film 108, the insulating layer 105, the TFT lower layer film 106, and the first interlayer insulating film 156. The via 261k reaches the upper surface 251U. The via 261a reaches the connecting portion 253a.

The vias 111s, 111d pass through the second interlayer insulating film 108 and the insulating layer 105. The via 111s reaches the region 204s. The via 111d reaches the region 204d.

The first wiring layer 110 is formed on the second interlayer insulating film 108. The wiring lines 210a, 210d, 210s are formed. The wiring line 210a is connected to one end of the via 261a. The wiring line 210d is connected to one end of the via 261k and one end of the via 111d. The wiring line 210s is connected to the other end of the via 111s. The first wiring layer 110 may be formed simultaneously with formation of the vias 261a, 261k, 111d, 111s.

In this way, the sub-pixels 220 are formed and the image display device 201 illustrated in FIG. 11 is formed.

Effects of the image display device of the present embodiment will now be described.

In the image display device of the present embodiment, similarly to the other embodiment described above, the time of the transfer process for forming the light-emitting element 250 can be shortened and the number of processes can be reduced. In addition, in the crystal growth process of the semiconductor layer 1150, the transfer to the support substrate 1190 can be made unnecessary in a case in which crystal growth is performed from the n-type semiconductor layer 1151, and thus the number of processes can be reduced.

In the image display device 201 according to the present embodiment, the p-type semiconductor layer 253 can be the light-emitting surface 253S, increasing a degree of freedom in the circuit configuration and improving a design efficiency of the product.

Third Embodiment

FIG. 18 is a schematic cross-sectional view exemplifying a portion of an image display device according to the present embodiment.

The present embodiment differs from the other embodiments described above in that the light-emitting element 150 with the n-type semiconductor layer 151 as a light-emitting surface 151S1 is driven by the transistor 203 that is an n type. In the present embodiment, a sub-pixel 320 includes a light-blocking layer 330. In the present embodiment, the sub-pixel 320 is provided with a color filter 180 on the light-emitting surface 151S1 side. Components that are the same as those of the other embodiments described above are denoted by the same reference signs, and detailed descriptions thereof will be omitted as appropriate.

As illustrated in FIG. 18, the sub-pixel 320 of the image display device of the present embodiment includes the color filter 180, the light-emitting element 150, the first interlayer insulating film 156, the transistor 203, the second interlayer insulating film 108, the light-blocking layer 330, a via 361a, and the first wiring layer 110. The transistor 203 is an n-channel TFT. The light-emitting element 150 provides the light-emitting surface 151S1 by the n-type semiconductor layer 151. In the present embodiment, the light-emitting surface 151S1 is roughened.

The color filter 180 includes a light-blocking portion 181 and the color conversion unit 182. In this manner, the color filter (wavelength conversion member) 180 includes the color conversion unit 182 having light transmittance, and thus is a light-transmitting member. The color conversion unit 182 is provided directly below the light-emitting surface 151S1 of the light-emitting element 150 in accordance with the shape of the light-emitting surface 151S1. In the color filter 180, a portion other than the color conversion unit 182 is the light-blocking portion 181. The light-blocking portion 181 is a so-called black matrix, and can reduce bleeding caused by the color mixing of light emitted from the adjacent color conversion unit 182 and the like, and thus display a sharp image.

The color conversion unit 182 is one layer or two or more layers. In FIG. 18, a case in which the color conversion unit 182 is two layers is illustrated. Whether the color conversion unit 182 is one layer or two layers is determined by the color, that is, wavelength, of the light emitted by the sub-pixel 320. In a case in which the light emission color of the sub-pixel 320 is red, preferably the color conversion unit 182 is the two layers of a color conversion layer 183 and a filter layer 184 through which red light passes. In a case in which the light emission color of the sub-pixel 320 is green, preferably the color conversion unit 182 is the two layers of the color conversion layer 183 and the filter layer 184 through which green light passes. In a case in which the light emission color of the sub-pixel 320 is blue, one layer is preferred.

In a case in which the color conversion unit 182 is two layers, a first layer is the color conversion layer 183, and a second layer is the filter layer 184. The color conversion layer 183 of the first layer is closer to the light-emitting element 150. The filter layer 184 is layered on the color conversion layer 183.

The color conversion layer 183 converts the wavelength of the light emitted by the light-emitting element 150 to a desired wavelength. In a case in which the sub-pixel 320 emits red light, the color conversion layer 183 converts light having a wavelength of 467 nm $\pm$ 30 nm, which is the wavelength of the light-emitting element 150, to light having a wavelength of about 630 nm $\pm$ 20 nm, for example. In a case in which the sub-pixel 320 emits green light, the color conversion layer 183 converts light having a wavelength of 467 nm $\pm$ 30 nm, which is the wavelength of the light-emitting element 150, to light having a wavelength of about 532 nm $\pm$ 20 nm, for example.

The filter layer 184 blocks the wavelength component of the remaining blue light emission without color conversion by the color conversion layer 183.

In a case in which the color of the light emitted by the sub-pixel 320 is blue, the sub-pixel 320 may output the light via the color conversion layer 183 or may output the light as is and not via the color conversion layer 183. In a case in which the light emitted by the light-emitting element 150 has the wavelength of about 467 nm $\pm$ 30 nm, the sub-pixel 320 may output the light not via the color conversion layer 183. In a case in which the light emitted by the light-emitting element 150 is set to have the wavelength of 410 nm $\pm$ 30 nm, it is preferable to provide the one layer of the color conversion layer 183 in order to convert the wavelength of the light to be output to about 467 nm $\pm$ 30 nm.

Even in the case of the sub-pixel 320 having a blue color, the sub-pixel 320 may include the filter layer 184. With the filter layer 184 through which blue light is transmitted provided to the blue sub-pixel 320, minute reflection of external light other than the blue light generated at a front surface of the light-emitting element 150 is suppressed.

The color filter 180 includes a first surface 180a. On the first surface 180a, a transparent thin film adhesive layer 188 is provided. The light-emitting element 150 and the first interlayer insulating film 156 are provided on the first surface 180a with the transparent thin film adhesive layer 188 interposed therebetween.

In the light-emitting element 150, the light-emitting surface 151S1 is roughened. A transparent flattening film 155 is provided between the light-emitting surface 151S1 and the transparent thin film adhesive layer 188. The transparent flattening film 155 flattens the roughened light-emitting surface 151S1.

The light-emitting element 150 has a prism shape or a column shape including the light-emitting surface 151S1 and the upper surface 153U. The light-emitting surface 151S1 is in contact with the transparent thin film adhesive layer 188 with the transparent flattening film 155 interposed therebetween. The upper surface 153U is a surface provided on a side opposite to the light-emitting surface 151S1.

The light-emitting element 150 includes the n-type semiconductor layer 151, the light-emitting layer 152, and the p-type semiconductor layer 153. The n-type semiconductor layer 151, the light-emitting layer 152, and the p-type semiconductor layer 153 are layered in this order from the light-emitting surface 151S1 toward the upper surface 153U.

The light-emitting element 150 includes the connecting portion 151a. The connecting portion 151a protrudes over the first surface 180a in one direction from the n-type semiconductor layer 151, with the transparent thin film adhesive layer 188 interposed therebetween. The transparent flattening film 155 is also provided between the connecting portion 151a and the transparent thin film adhesive layer 188. The connecting portion 151a is a portion of the n-type semiconductor layer 151. The connecting portion 151a is the same as that in the other embodiments described above in being connected to one end of a via 361k and having the function of connecting, through the via 361k, the n-type semiconductor layer 151 to the first wiring layer 110 in an upper layer overlying the light-emitting element 150. The configuration of the light-emitting element 150 is the same as that of the first embodiment described above, except that the light-emitting surface 151S1 is roughened, and thus further detailed description thereof will be omitted.

In the present embodiment, the n-channel transistor 203 is formed on the TFT lower layer film 106. The transistor 203 is a TFT. The configuration and the like are the same as in the second embodiment described above, and thus detailed description thereof will be omitted.

In the present embodiment, the light-blocking layer 330 is provided between the first interlayer insulating film 156 and the second interlayer insulating film 108.

In this example, the light-blocking layer 330 is provided on the entire surface of the first interlayer insulating film 156, except for a portion. The light-blocking layer 330 can be formed of any light-blocking material, conductive or not, but is formed, for example, of a metal material with having light reflectivity. The light-blocking layer 330 may be formed of a black resin. When the light-blocking layer 330 is formed of a black resin, the vias can be formed together with the first interlayer insulating film 156 and the like without forming through holes larger than the diameter of the vias in advance.

The vias 361a, 361k pass through the first interlayer insulating film 156 and the second interlayer insulating film 108, and thus the light-blocking layer 330 is provided with through holes 331a and 331k having a diameter larger than the diameter of the vias 361a and 361k. The via 361a passes through the through hole 331a and the via 361k passes through the through hole 331k.

The light-blocking layer 330 includes a first portion 330a, and the TFT channel 204 is provided on the first portion 330a. The first portion 330a includes a region including an outer periphery of the TFT channel 204 when the TFT channel 204 is projected onto the first portion 330a in XY plan view. Even in a case in which scattered light and the like is emitted upward from the light-emitting element 150 provided below the TFT channel 204, the scattered light and the like is blocked by the first portion 330a and cannot substantially reach the TFT channel, and thus malfunction of the transistor 203 can be suppressed by the first portion 330a.

The light-blocking layer 330 is desirably provided across the entire surface of the first interlayer insulating film 156 as in this example, from the perspective of light-blocking properties, but the light-blocking layer 330 is not limited to physically being a single member. For example, the light-blocking layer 330 may be separated into a portion directly below the TFT channel 204 and a portion directly above the light-emitting element 150. In this example, the light-blocking layer 330 is not connected to any potential, but may be connected to a specific potential such as a ground potential or a power source potential. When the light-blocking layer 330 includes a plurality of separated portions, all portions may be connected to a common potential, or each portion may be connected to different potential.

The via 111s is provided between a wiring line 310s and the region 204s and allows electrical connection between the wiring line 310s and the region 204s. The via 111d is provided between a wiring line 310d and the region 204d and allows electrical connection between the wiring line 310d and the region 204d.

The wiring line 310s is connected to the region 204s through the via 111s. The region 204s corresponds to the source region of the transistor 203. Accordingly, the source region of the transistor 203 is electrically connected to the ground line 4 through the via 111s and the wiring line 310s.

The wiring line 310d is connected to the region 204d through the via 111d. The region 204d is the drain region of the transistor 203.

The via 361k passes through the second interlayer insulating film 108, the insulating layer 105, the TFT lower layer film 106, and the first interlayer insulating film 156. The via 361k is provided between the wiring line 310d and the connecting portion 151a, and allows electrical connection between the wiring line 310d and the connecting portion 151a. Accordingly, the drain region of the transistor 203 is electrically connected to the n-type semiconductor layer 151 through the via 111d, the wiring line 310d, the via 361k, and the connecting portion 151a.

The via 361a passes through the second interlayer insulating film 108, the insulating layer 105, the TFT lower layer film 106, and the first interlayer insulating film 156. The via 361a is provided between a wiring line 310a and the upper surface 153U, and allows electrical connection between the wiring line 310a and the upper surface 153U. Accordingly, the p-type semiconductor layer 153 is electrically connected to the power source line 3 of the circuit in FIG. 19 described below, for example, through the via 361a and the wiring line 310a.

FIG. 19 is a schematic block diagram exemplifying the image display device according to the present embodiment.

As illustrated in FIG. 19, in an image display device 301 of the present embodiment, the sub-pixels 320 are arrayed in the display region 2. The sub-pixels 320 are arrayed, for example, in a lattice pattern. For example, n sub-pixels 320 are arrayed along the X axis, and m sub-pixels 320 are arrayed along the Y axis.

The pixel 10 includes a plurality of the sub-pixels 320 that emit different colors of light. A sub-pixel 320R emits red light. A sub-pixel 320G emits green light. A sub-pixel 320B emits blue light. The three types of sub-pixels 320R, 320G, 320B emit light at a desired brightness, and thus the light emission color and brightness of one pixel 10 are determined.

One pixel 10 includes the three sub-pixels 320R, 320G, 320B, and the sub-pixels 320R, 320G, 320B are arrayed in a linear shape on the X axis, for example. In each pixel 10, sub-pixels of the same color may be arrayed in the same column or, as in this example, sub-pixels of different colors may be arrayed on a per column basis.

In the image display device 301 of the present embodiment, the configuration of the power source line 3, the ground line 4, the scanning line 206, and the signal line 208 is the same as that of the second embodiment described above. The image display device 301 differs from that of the second embodiment in that three types of sub-pixels emit light, each at a set brightness, thereby determining the light emission color and brightness of one pixel 10. The circuit configuration is the same as in the example illustrated in FIG. 11 for the second embodiment, except that the configuration of the signals and the like for the above may differ, and thus detailed description thereof will be omitted.

A manufacturing method of the image display device according to the present embodiment will now be described.

FIGS. 20A to 23B are schematic cross-sectional views exemplifying portions of the manufacturing method of the image display device of the present embodiment.

In the manufacturing method of the image display device according to the present embodiment, the processes up to transferring the semiconductor layer to the support substrate and preparing the substrate 1195 illustrated in FIG. 5A are the same as those of the first embodiment described above. Hereinafter, description will be made starting from the process following FIG. 4B in which the substrate 1195 is formed.

As illustrated in FIG. 20A, the n-type semiconductor layer 1151 illustrated in FIG. 4B is roughened to form the roughened exposed surface 1151E1. A transparent flattening film 1155 is formed across the exposed surface 1151E1, and an exposed surface 1155E of the transparent flattening film 1155 is flattened. For flattening of the exposed surface 1155E, CMP is used, for example.

As illustrated in FIG. 20B, the semiconductor layer 1150 is bonded to the substrate 102. The bonded surfaces are the exposed surface 1155E of the transparent flattening film 1155 for the semiconductor layer 1150, and the first surface 103a of the bonding layer 303 for the substrate 102.

As illustrated in FIG. 21A, the semiconductor layer 1150 illustrated in FIG. 20B is etched into a desired shape, forming the light-emitting element 150. The formation process of the light-emitting element 150 is the same as that of the other embodiments described above. For the transparent flattening film 155, the transparent flattening film 1555 before processing, which is illustrated in FIG. 20B, is processed and formed simultaneously with the formation of the light-emitting element 150.

The first interlayer insulating film 156 covers the first surface 103a and the light-emitting element 150. In a case in which the transparent flattening film 155 is exposed on the lateral surface of the light-emitting element 150, the first interlayer insulating film 156 covers the transparent flattening film 155 as well.

The light-blocking layer 330 is formed on the first interlayer insulating film 156. In the process of forming the light-blocking layer 330, the through holes 331a, 331k are formed by etching or the like. Portions of the light-blocking layer 330 other than the through holes 331a, 331k remain on the first interlayer insulating film 156, and the first portion 330a is provided at a location where the transistor is formed in a subsequent process. In a case in which the light-blocking layer 330 is made of an insulating material such as a black resin, insulation between the light-blocking layer 330 and the vias is not required, and thus the through holes 331a, 331k do not need to be formed.

As illustrated in FIG. 21B, the TFT lower layer film 106 is formed on the light-blocking layer 330 by CVD or the like. The locations where the through holes 331a, 331k are formed are embedded in the TFT lower layer film 106, and a front surface of the TFT lower layer film 106 is flattened. On the flattened TFT lower layer film 106, the polycrystallized Si layer 1104 is formed.

As illustrated in FIG. 22A, the Si layer 1104 illustrated in FIG. 21B is processed, and the TFT channel 204 is formed, the insulating layer 105 is formed, the gate 107 is formed, and each region 204s, 204d, 204i of the TFT channel 204 is formed. These manufacturing processes are the same as those of the second embodiment described above. Preferably, an LTPS process is used.

As illustrated in FIG. 22B, the vias 111s, 111d, 361k, 361a are formed, and the first wiring layer 110 is formed. These manufacturing processes are the same as those of the second embodiment described above.

As illustrated in FIG. 23A, an adhesive layer 1170 is formed on the second interlayer insulating film 108 and the first wiring layer 110, and then a reinforcing substrate 1180 is adhered to the adhesive layer 1170. Subsequently, the substrate 102 illustrated in FIG. 22B is removed along with the bonding layer 303, exposing a formation surface 1192A of the color filter 180. To remove the substrate 102 and the bonding layer 303, wet etching or laser lift-off is used.

As illustrated in FIG. 23B, the color filter 180 is adhered to the formation surface 1192A with the transparent thin film adhesive layer 188 interposed therebetween.

The purpose of removal of the substrate 102 and the bonding layer 303 is to reduce the transmission loss of light emitted from the light-emitting surface 151S1. Therefore, during removal of the substrate 102 and the bonding layer 303, removal is not limited to removal of these in their entirety, and a portion of the substrate 102 may be removed to form the color filter 180, for example. Removal of a portion of the substrate 102 refers to thinning the substrate 102 by etching or the like. Alternatively, the substrate 102 may be configured in advance to have a multilayer structure with a transparent resin or the like, and a portion of the layers may be peeled, thereby substantially thinning the substrate 102.

FIGS. 24A to 24D are schematic cross-sectional views exemplifying portions of the manufacturing method of the image display device of the present embodiment.

FIGS. 24A to 24D illustrate a method of forming the color filter by an inkjet method. This manufacturing process is applied in place of the process illustrated in FIG. 23B described above.

As illustrated in FIG. 24A, the substrate 102 and the bonding layer 303 are removed, and a structure 1192 in which the formation surface 1192A is exposed is prepared. As explained in FIG. 23A, the structure 1192 includes the light-emitting element 150, the first interlayer insulating film 156, the light-blocking layer 330, the TFT lower layer film 106, the TFT channel 204, the insulating layer 105, the gate 107, the vias 111s, 111d, 361k, 361a, and the first wiring layer 110.

As illustrated in FIG. 24B, the light-blocking portion 181 is formed on a region of the formation surface 1192A of the color filter, the region not including the light-emitting surface 151S1. The light-blocking portion 181 is formed using, for example, screen printing or a photolithography technique.

As illustrated in FIG. 24C, a phosphor corresponding to the light emission color is ejected from an inkjet nozzle to form the color conversion layer 183. The phosphor colors the region where the light-blocking portion 181 is not formed. As the phosphor, for example, a fluorescent coating that uses a typical phosphor material, a perovskite phosphor material, or a quantum dot phosphor material is used. Use of a perovskite phosphor material or a quantum dot phosphor material makes it possible to realize each light emission color, high chromaticity, and high color reproducibility, and is thus preferred. After the drawing by the inkjet nozzle, drying is performed at an appropriate temperature and for an appropriate time. A thickness of the coating film at the time of coloring is set thinner than a thickness of the light-blocking portion 181.

As already described, in a case in which the color conversion unit is not to be formed for a blue light-emitting sub-pixel, the color conversion layer 183 is not formed. Further, for a blue light-emitting sub-pixel, in a case in which the color conversion unit need only be a single layer when the blue color conversion layer is formed, a thickness of the coating film of the blue phosphor is preferably about the same as the thickness of the light-blocking portion 181.

As illustrated in FIG. 24D, the coating for the filter layer 184 is ejected from an inkjet nozzle. The coating is applied so as to overlap the coating film of the phosphor. A total thickness of the coating film of the phosphor and the coating is a thickness of the filter layer 184 layered on the color conversion layer 183, and is about the same as the thickness of the light-blocking portion 181.

Whether the color filter is a film type or an inkjet type, desirably the color conversion layer 183 is thick to the extent possible in order to improve color conversion efficiency. On the other hand, when the color conversion layer 183 is too thick, the emitted light of the color-converted light is approximated to Lambertian, whereas blue light that is not color converted is limited in emission angle by the light-blocking portion 181. Therefore, a problem arises in that a viewing angle dependency occurs in the display color of the displayed image. To combine the distribution of light of the sub-pixels provided with the color conversion layer 183 with the light distribution of blue light not color converted, a thickness of the color conversion layer 183 is desirably about one-half of an opening size of the light-blocking portion 181.

For example, in the case of a high-definition image display device of about 250 ppi, a pitch of the sub-pixel 20 is about 30 $\mu$m, and thus the thickness of the color conversion layer 183 is desirably about 15 $\mu$m. Here, in a case in which the color conversion material is formed of phosphor particles having a spherical shape, preferably the material is layered in a closely packed structural shape in order to suppress light leakage from the light-emitting element 150. To that end, at least the layer of particles needs to have three layers. Accordingly, a particle size of the phosphor material constituting the color conversion layer 183 is, for example, preferably about 5 $\mu$m or less, and even more preferably about 3 $\mu$m or less. Perovskite phosphor materials, quantum dot phosphor materials, and the like readily degrade by oxygen and moisture, and thus the color conversion layer 183 is preferably sealed with an inorganic film such as $SiO_2$.

FIG. 25 is a schematic perspective view exemplifying the image display device according to the present embodiment.

As illustrated in FIG. 25, the image display device of the present embodiment is provided with the light-emitting circuit portion 172, including a number of light-emitting elements 150, on the color filter 180. The drive circuit portion 100 is provided on the light-emitting circuit portion 172. The drive circuit portion 100 is a structure including the circuit 101 illustrated in FIG. 18. As described above, the light-emitting circuit portion 172 and the drive circuit portion 100 are electrically connected by the vias 361a, 361k.

Although, in the present embodiment, the color filter 180 can make configuration of a full-color image display device 301, as in the other embodiments described above, and the image display device may be configured without a color filter. In this case, for example, the substrate 102 and the bonding layer 303 may not be removed, and the substrate 102 and the bonding layer 303 may remain as they are.

Effects of the image display device 301 of the present embodiment will now be described.

According to the manufacturing method of the image display device 301 of the present embodiment, in addition to the effects of making it possible to shorten the time required for the transfer process for forming the light-emitting element 150 and reduce the number of processes as in the other embodiments described above, the light-emitting surface 151S1 is formed of the n-type semiconductor layer 151 having a resistance lower than that of the p-type, making it possible to thickly form the n-type semiconductor layer 151 and sufficiently roughen the light-emitting surface 151S1.

In the image display device 301 of the present embodiment, the emitted light is diffused by roughening the light-emitting surface 151S1, making it possible to use even a small-sized light-emitting element 150 as a light source having a sufficient light-emitting area.

In the image display device 301 of the present embodiment, the light-emitting element 150 including the light-emitting surface 151S1 as the n-type semiconductor layer 151 can be driven by the n-channel transistor 203. This makes it possible to increase the degree of freedom of the circuit configuration and improve the design efficiency.

In the image display device 301 of the present embodiment, the light-blocking layer 330 is provided between the first interlayer insulating film 156 and the second interlayer insulating film 108. That is, the light-blocking layer 330 is provided between the light-emitting element 150 and the transistor 203. Therefore, even when scattered light or the like is emitted upward from the light-emitting element 150, the emitted light is unlikely to reach the TFT channel 204, making it possible to prevent malfunction of the transistor 203.

The light-blocking layer 330 can be formed of a conductive material such as a metal, and can be connected to either potential. For example, a portion of the light-blocking layer 330 can be placed directly below a switching element such as the transistor 203 and connected to a ground potential, a power source potential, or the like, thereby assisting with noise suppression.

The light-blocking layer 330 is not limited in application to that of the present embodiment, and can be applied in common to the sub-pixels of the other embodiments described above and other embodiments described below. When applied to the other embodiments, the same effects as described above can be achieved.

In the example described above, the configuration and the manufacturing method of the light-emitting element including a roughened light-emitting surface has been described. In a light-emitting element including a connecting portion, the roughened light-emitting surface can be applied as in the present embodiment. Specific applications include the light-emitting element 150 in the case of the first embodiment, the light-emitting element 250 in the case of the second embodiment, and a semiconductor layer 750 in the case of a seventh embodiment described below. By applying the roughening of the light-emitting surface to the components of these light-emitting elements, a device having the effects described above can be achieved. Further, the roughened light-emitting surface can be applied to the light-emitting elements in each case of a fourth embodiment, a fifth embodiment, and a sixth embodiment by changing the light-emitting element from a vertical type to a horizontal type including a connecting portion.

Fourth Embodiment

FIG. 26 is a schematic cross-sectional view exemplifying a portion of an image display device of the present embodiment.

The present embodiment differs from the other embodiments described above in including a second wiring layer 440 between the light-emitting element 150 and the first surface 103a. Further, the present embodiment differs from the other embodiments described above in including a third wiring layer 470 on the light-emitting element 150. In other respects, components that are the same as those of the other embodiments described above are denoted by the same reference signs, and detailed descriptions thereof will be omitted as appropriate.

As illustrated in FIG. 26, a sub-pixel 420 of the image display device of the present embodiment includes the substrate 102, the second wiring layer 440, the light-emitting element 150, the third wiring layer 470, the first interlayer insulating film 156, the transistor 103, the second interlayer insulating film 108, the via 161a, and the first wiring layer 110.

The second wiring layer 440 is provided on the first surface 103a. The second wiring layer 440 includes a wiring line 440a. The wiring line 440a is provided between the light-emitting element 150 and the first surface 103a. The second wiring layer 440 includes a plurality of the wiring lines 440a in accordance with the plurality of light-emitting elements 150 and, in this example, the wiring lines 440a are separated.

The second wiring layer 440 is formed of a conductive film having light transmittance. The conductive film is, for example, a transparent conductive film, such as ITO or ZnO. The wiring line 440a is also formed of the same material.

The second wiring layer 440 and the wiring line 440a are in contact with the first surface 103a. The light-emitting element 150 is in contact with the wiring line 440a at the light-emitting surface 151S, and is electrically connected to the wiring 440a. An outer periphery of the wiring line 440a includes, in XY plan view, an outer periphery of the light-emitting element 150 when the light-emitting element 150 is projected onto the wiring line 440a. The wiring line 440a protrudes over the first surface 103a in one direction from directly below the light-emitting surface 151S. The region in which the wiring line 440a protrudes is connected to one end of the via 161k. Accordingly, the n-type semiconductor layer 151 is electrically connected to the ground line 4 of the circuit in FIG. 2 described above, for example, through the wiring line 440a, the via 161k, and the wiring line 110k.

A resin layer 457 is provided on the first surface 103a, the light-emitting element 150, and the second wiring layer 440. The resin layer 457 is, for example, a transparent resin. The third wiring layer 470 is provided on the resin layer 457. The third wiring layer 470 can include a plurality of wiring lines. For example, one portions of the plurality of wiring lines can be physically separated and have electrically different potentials. Other portions of the plurality of wiring lines are physically connected. In this example, the third wiring layer 470 includes wiring lines 470a, 470b that are separated.

The wiring line (first light-blocking electrode) 470a is provided upwardly and laterally across the light-emitting element 150, and covers the upper surface 153U and the lateral surfaces of the light-emitting element 150. The wiring line 470a covers most of the light-emitting element other than the light-emitting surface 15 1S, and thus blocks light scattered and light reflected laterally and upwardly of the light-emitting element 150. A connecting electrode 461a is provided between the upper surface 153U and the wiring line 470a, and allows electrical connection between the upper surface 153U and the wiring line 470a. The wiring line 470a functions as a light-blocking electrode.

In a case in which the resin layer 457 is a transparent resin, the scattered light and the like emitted upwardly and laterally of the light-emitting element 150 is reflected toward the light-emitting surface 151S side by the wiring line 470a. Therefore, a substantial light emission efficiency of the light-emitting element 150 is improved. When the resin layer 457 is a material having high light reflectivity such as a white resin, the wiring line 470a is further provided on the resin layer 457, and thus greater light reflectivity can be achieved.

The via 161a is provided between the wiring line 110d and the wiring line 470a, and allows electrical connection the wiring line 110d and the wiring line 470a. Accordingly, the p-type semiconductor layer 153 is electrically connected to the drain region of the transistor 103 through the connecting electrode 461a, the wiring line 470a, the via 161a, the wiring line 110d, and the via 111d.

The via 161k is provided between the wiring line 110k and the wiring line 440a, and allows electrical connection between the wiring line 110k and the wiring line 440a. Accordingly, the n-type semiconductor layer 151 is electrically connected to the ground line 4 of the circuit in FIG. 2, for example, through the wiring line 440a, the via 161k, and the wiring line 110k.

The first interlayer insulating film 156 covers the resin layer 457 and the third wiring layer 470. The configuration of the TFT lower layer film 106 and the circuit 101 provided on the first interlayer insulating film 156 is the same as that of the other embodiments described above, and the detailed description thereof will be omitted.

A manufacturing method of the image display device according to the present embodiment will now be described.

FIGS. 27A to 30B are schematic cross-sectional views exemplifying a manufacturing method of the image display device of the present embodiment.

In the manufacturing method of the image display device of the present embodiment, the processes described using FIGS. 4A and 4B in the first embodiment are applied, and the following description applies to the processes following those in FIG. 4B.

As illustrated in FIG. 27A, the substrate 1195 is prepared, and a conductive film 1440 having light transmittance is formed on the semiconductor layer 1150. The conductive film 1440 is formed on the exposed surface 1151E of the n-type semiconductor layer 1151.

As illustrated in FIG. 27B, the semiconductor layer 1150 is bonded to the first surface 103a with the conductive film 1440 interposed therebetween.

As illustrated in FIG. 28A, the conductive film 1440 illustrated in FIG. 27B is processed by etching to form the second wiring layer 440 including the wiring lines 440a. The semiconductor layer 1150 illustrated in FIG. 27B is processed by etching, forming the light-emitting element 150.

The resin layer 457 covers the first surface 103a, the light-emitting element 150, and the wiring layer 440. An opening 462a is formed in the resin layer 457, exposing a portion of the upper surface 153U of the light-emitting element 150.

As illustrated in FIG. 28B, a metal layer 1470 covers the resin layer 457. The opening 462a illustrated in FIG. 28A may be filled to form the connecting electrode 461a simultaneously with formation of the metal layer 1470, or the opening 462a may be filled to form the connecting electrode 461a before formation of the metal layer 1470.

As illustrated in FIG. 29A, the metal layer 1470 illustrated in FIG. 28B is processed by etching to form the third wiring layer 470. During formation of the third wiring layer 470, the wiring lines 470a, 470b are formed. The first interlayer insulating film 156 covers the resin layer 457 and the third wiring layer 470.

As illustrated in FIG. 29B, the TFT lower layer film 106 is formed on the first interlayer insulating film 156, and the polycrystallized Si layer 1104 is formed on the TFT lower layer film 106.

As illustrated in FIG. 30A, the TFT channel 104, the insulating layer 105, the gate 107, and the regions 104s, 104d, 104i are formed using an LTPS process or the like.

As illustrated in FIG. 30B, the via 111s, 111d, 161a, 161k are formed, and the first wiring layer 110 is formed on the second interlayer insulating film 108. The via 161k is formed by filling a via hole that reaches the wiring line 440a with a conductive material.

As for the details of each manufacturing process in FIGS. 29A to 30B, the techniques already described in the manufacturing methods of the image display devices of the other embodiments can be applied.

In this way, the sub-pixels 420 are formed.

Effects of the image display device of the present embodiment will now be described.

The image display device of the present embodiment, similarly to the other embodiments described above, has the effect of making it possible to shorten the time of the transfer process for forming the light-emitting element 150 and reduce the number of processes. In addition, the image display device of the present embodiment has the following effects.

The second wiring layer 440 and the wiring line 440a are formed by a conductive film having light transmittance, such as ITO, facilitating processing and making it possible to shorten the series of manufacturing processes of the light-emitting element 150 and the second wiring layer 440 in some cases.

In the present embodiment, the second wiring layer 440 and the wiring line 440a are used to draw electrodes on the light-emitting surface 151S side, making it possible to form a vertical-type light-emitting element 150. The vertical-type light-emitting element 150 has the advantage of making it possible to reduce, in the current flowing through the semiconductor layer, components in a direction along the XY plane, and thus set the current in a direction substantially along the Z axis, thereby reducing losses in the semiconductor layer.

In the image display device of present embodiment, the sub-pixel 420 includes the third wiring layer 470. The third wiring layer 470 is electrically separated from the light-emitting element 150 by the resin layer 457. The third wiring layer 470 includes the wiring line 470a, and the wiring line 470a covers the upper surface 153U and the lateral surfaces of the light-emitting element 150 with the resin layer 457 interposed therebetween. Therefore, the light scattered upwardly and laterally of the light-emitting element 150 and the like can be blocked. Even though the transistor 103 is provided above the light-emitting element 150, the light scattered upwardly and laterally of the light-emitting element 150 and the like is blocked by the wiring line 470a, and thus the scattered light and the like is suppressed from reaching the transistor 103. As a result, malfunction of the transistor 103 due to scattered light or the like of the light-emitting element 150 is prevented.

Fifth Embodiment

FIG. 31 is a schematic cross-sectional view exemplifying a portion of an image display device according to the present embodiment.

The present embodiment differs from the other embodiments described above in that a light-blocking electrode 560a covering the upper surface 153U of the light-emitting element 150 is provided, and the light-blocking electrode 560a is connected to a wiring line 510d formed on a wall surface of a through hole 511a. In this example, the color filter 180 is provided on a substrate 502 obtained by thinning a substrate having transmissivity, such as a glass substrate. In other respects, the components are the same as those of the other embodiments and are denoted by the same reference signs, and detailed descriptions thereof will be omitted as appropriate.

As illustrated in FIG. 31, a sub-pixel 520 of the image display device of the present embodiment includes the substrate 502, the second wiring layer 440, the light-emitting element 150, the light-blocking electrode 560a, the first interlayer insulating film 156, the transistor 103, the second interlayer insulating film 108, the via 161a, the first wiring layer 110, and the color filter 180. In the present embodiment, the light-emitting element 150 is provided on a wiring line 540a of the second wiring layer 440, and is electrically connected to the wiring line 540a in the light-emitting surface 151S.

The substrate 502 is a substrate having transmissivity, and is, for example, a glass substrate. The substrate 502 may be, in addition to a glass substrate, a resin substrate having transmissivity. The bonding layer 303 is provided on one surface 502a of the substrate 502. The bonding layer 303 is the same as those in the other embodiments described above. In a case in which the substrate 502 is a resin substrate, the substrate 502 facilitates the bonding with the semiconductor layer and is formed of an inorganic compound such as a Si compound such as $SiO_2$.

The color filter 180 is provided on the other surface 502b of the substrate 502. The color filter 180 is the same as those in the other embodiments described above.

The through hole 511a is provided above the light-emitting element 150. The through hole 511a passes through the second interlayer insulating film 108, the insulating layer 105, the TFT lower layer film 106, and the first interlayer insulating film 156, and reaches the upper surface 153U. An inner periphery of the through hole 511a is the same as an outer periphery of the upper surface 153U or slightly inward of the outer periphery of the upper surface 153U.

The light-blocking electrode (second light-blocking electrode) 560a is provided across the upper surface 153U. The light-blocking electrode 560a is provided at a bottom portion of the through hole 511a, and thus an outer periphery of the light-blocking electrode 560a substantially matches the inner periphery of the through hole 511a. Accordingly, the light-blocking electrode 560a covers all of the upper surface 153U or most of the upper surface 153U. The light-blocking electrode 560a blocks the light scattered upwardly of the light-emitting element 150 and the like. Therefore, the upwardly scattered light and the like is suppressed from reaching the transistor 103, preventing malfunction of the transistor 103. The light-blocking electrode 560a is formed of a highly reflective material such as Ag, or an ITO film is provided between the light-blocking electrode 560a and the upper surface 153U, thereby making it possible to improve light reflectivity. By improving the light reflectivity, light scattered toward the upper surface 153U side and the like toward the light-emitting surface 151S side can be reflected, and thus the substantial light emission efficiency of the light-emitting element 150 can be improved. Note that the light-blocking electrode 560a can be formed integrally with the wiring line 510d formed on the wall surface of the through hole 511a, and thus the light-blocking electrode 560a and the wiring line 510d correspond to the via (first via) 161a and the like in the other embodiments described above.

The first wiring layer 110 includes the wiring line 510d. The wiring line 510d is provided on the second interlayer insulating film 108, and is provided on the wall surface of the through hole 511a and connected to the light-blocking electrode 560a. The wiring line 510d is connected to the drain region of the transistor 103 through the via 111d, and thus the p-type semiconductor layer 153 is electrically connected to the drain region of the transistor 103 through the light-blocking electrode 560a, the wiring line 510d, and the via 111d.

Other components such as the transistor 103 and the like are the same as those in the other embodiments described above, and thus detailed description thereof will be omitted.

FIG. 32 is a schematic block diagram exemplifying the image display device according to the present embodiment.

As illustrated in FIG. 32, in an image display device 501 of the present embodiment, the sub-pixels 520 are arrayed in the display region 2. The sub-pixels 520 are arrayed, for example, in a lattice pattern. For example, n sub-pixels 520 are arrayed along the X axis, and m sub-pixels 520 are arrayed along the Y axis.

The pixel 10 includes a plurality of the sub-pixels 520 that emit different colors of light. A sub-pixel 520R emits red light. A sub-pixel 520G emits green light. A sub-pixel 520B emits blue light. The three types of sub-pixels 520R, 520G, 520B emit light at a desired brightness, and thus the light emission color and brightness of one pixel 10 are determined. The arrangement and the like of each color are the same as those in the third embodiment.

In the image display device 501 of the present embodiment, the configuration of the power source line 3, the ground line 4, the scanning line 6, and the signal line 8 is the same as that of the first embodiment described above. The image display device 501 differs from that of the first embodiment in that three types of sub-pixels emit light, each at a set brightness, thereby determining the light emission color and brightness of one pixel 10. The circuit configuration is the same as in the example illustrated in FIG. 2 for the first embodiment, except that the configuration of the signals and the like for the above may differ, and thus detailed description thereof will be omitted.

A manufacturing method of the image display device according to the present embodiment will now be described.

FIGS. 33A to 34B are schematic cross-sectional views exemplifying portions of the manufacturing method of the image display device of the present embodiment.

In the manufacturing method of the image display device of the present embodiment, the processes described using FIGS. 27A and 27B in the fourth embodiment are applied, and the following description applies to the processes following those in FIG. 27B.

As illustrated in FIG. 33A, the conductive film 1440 having light transmittance and illustrated in FIG. 27B is processed by etching to form the second wiring layer 440 and the wiring line 540a. The first interlayer insulating film 156 covers the first surface 103a, the light-emitting element 150, and the second wiring layer 440.

As illustrated in FIG. 33B, the through hole 511a passes through the second interlayer insulating film 108, the insulating layer 105, the TFT lower layer film 106, and the first interlayer insulating film 156 provided above the upper surface 153U of the light-emitting element 150, and reaches the upper surface 153U. With formation of the through hole 511a, a portion of the upper surface 153U is exposed from the opening 511.

The upper surface 153U exposed by the opening 511 of the through hole 511a is preferably exposed in its entirety, but is set in accordance with a formation accuracy of the through hole 511a. For example, the inner periphery of the through hole 511a is set to be slightly smaller than the outer periphery of the upper surface 153U.

A via hole 162k passes through the second interlayer insulating film 108, the insulating layer 105, the TFT lower layer film 106, and the first interlayer insulating film 156 and reaches the wiring line 540a. A via hole 112d passes through the second interlayer insulating film 108 and the insulating layer 105 and reaches the region 104d. A via hole 112s passes through the second interlayer insulating film 108 and the insulating layer 105 and reaches the region 104s. The via holes 162k, 112d, 112s are formed simultaneously, for example. The through hole 511a may also be formed simultaneously with or may be formed separately from the via holes 162k, 112d, 112s.

As illustrated in FIG. 34A, the via holes 162k, 112d, 112s illustrated in FIG. 33B are filled with a conductive material to form the vias 161k, 111d, 111s. At the time of formation of the vias 161k, 111d, 111s, the bottom portion of the through hole 511a, that is, the upper surface 153U, may be covered with a conductive material.

The first wiring layer 110 is formed on the second interlayer insulating film 108. In the formation of the first wiring layer 110, the conductive layer forming the first wiring layer 110 is formed on the second interlayer insulating film 108 and processed by etching to form the first wiring layer 110 including the wiring lines 110k, 510d, 110s. In addition to across the second interlayer insulating film 108, the conductive layer is formed across the exposed upper surface 153U and the wall surface of the through hole 511a.

In this way, the wiring line 110k connected to the via 161k is formed, the wiring line 510d connected to the via 111d is formed, and the wiring line 110s connected to the via 111s is formed. The wiring line 510d is provided across the wall surface of the through hole 511a, and thus is connected to the upper surface 153U as well.

The adhesive layer 1170 is provided and, by the adhesive layer 1170, the reinforcing substrate 1180 is adhered on the second interlayer insulating film 108 and the first wiring layer 110. Subsequently, the substrate 102 illustrated in FIG. 33B is thinned by wet etching or the like and processed into the thin substrate 502.

As illustrated in FIG. 34B, the color filter 180 is provided on the other surface (second surface) 502b of the substrate 502. The color filter 180, in this example, is formed by the ink-jet illustrated in FIGS. 24A to 24D for the other embodiments described above. In the case of a color filter of a film format, the color filter 180 can be provided on the surface 502b with a transparent thin film adhesive layer interposed therebetween.

In a case in which the substrate 502 is a resin substrate having transmissivity, the substrate 502 may be a resin layer formed on a glass substrate, for example. After the light-emitting element and the like are formed on the substrate 502, which is a resin layer, the glass substrate may be removed by wet etching or the like, and subsequently the color filter 180 may be formed on the surface 502b from which the glass substrate was removed.

Effects of the image display device of the present embodiment will now be described.

The image display device of the present embodiment, similarly to the image display devices of the other embodiments described above, achieves the effect of making it possible to shorten the time of the transfer process for forming the light-emitting element 150 and reduce the number of processes. In addition, the light-blocking electrode 560a is provided across the upper surface 153U, making it possible to block the light emitted by the light-emitting element 150 and scattering upward, and the like. The light-blocking electrode 560a suppresses the light from reaching the transistor 103 provided above the light-emitting element 150, thereby preventing the transistor 103 from malfunctioning.

In the present embodiment, the light-blocking electrode 560a can be formed along with formation of the vias and formation of the first wiring layer 110, eliminating the need to add a process for forming the light-blocking electrode 560a. Therefore, the manufacturing process can be shortened, and the period from material introduction to product completion can be shortened.

Sixth Embodiment

FIG. 35 is a schematic cross-sectional view exemplifying a portion of an image display device according to the present embodiment.

In the present embodiment, the configuration of a light-emitting element 650 differs from those of the other embodiments. The other components are the same as those of the other embodiments described above. The same components are denoted by the same reference signs, and detailed description thereof will be omitted as appropriate.

As illustrated in FIG. 35, the second wiring layer 440 includes a wiring line 640a. The second wiring layer 440 and the wiring line 640a are in contact with the first surface 103a. The light-emitting element 650 is in contact with the wiring line 640a at a light-emitting surface 651S, and is electrically connected to the wiring 640a. An outer periphery of the wiring line 640a includes, in XY plan view, an outer periphery of the light-emitting element 650 when the light-emitting element 650 is projected onto the wiring line 640a. The wiring line 640a protrudes over the first surface 103a from directly below the light-emitting surface 651S. The region in which the wiring line 640a protrudes is connected to one end of the via 161k. Accordingly, the n-type semiconductor layer 651 is electrically connected to the ground line 4 of the circuit in FIG. 2 described above, for example, through the wiring line 640a, the via 161k, and the wiring line 110k.

In the present embodiment, the light-blocking layer 330 is provided. The light-blocking layer 330 is the same as that described with reference to FIG. 18 in the third embodiment. The light-blocking layer 330 includes a second portion 630a. The second portion 630a includes, in XY plan view, a region including an outer periphery of the TFT channel 104 when the TFT channel 104 is projected onto the second portion 630a.

The light-emitting element 650 is provided on the wiring line 640a. The light-emitting element 650 is an element having a truncated pyramid shape or a truncated cone shape, reducing the area in the XY plan view in the positive direction of the Z axis. The light-emitting element 650 includes the light-emitting surface 651S on the first surface 103a and an upper surface 653U provided on a side opposite to the light-emitting surface 651S. The light-emitting surface 651S is provided on the first surface 103a. The light-emitting element 650 includes an n-type semiconductor layer 651, a light-emitting layer 652, and a p-type semiconductor layer 653. The n-type semiconductor layer 651, the light-emitting layer 652, and the p-type semiconductor layer 653 are layered in the order from the first surface 103a side.

FIG. 36 illustrates a detailed positional relationship between the first surface 103a and the light-emitting element 650.

As illustrated in FIG. 36, the first surface 103a is a flat surface substantially parallel to the XY plane. The light-emitting element 650 is provided on the first surface 103a, and the light-emitting surface 651S is a surface substantially parallel to the first surface 103a. The wiring line 640a is provided on the first surface 103a, and the light-emitting surface 651S is provided on the first surface 103a with the wiring line 640a interposed therebetween. A thickness of wiring line 640a is sufficiently thin, and thus the reflection and absorption of light is sufficiently minimal.

The light-emitting element 650 includes a lateral surface 655a. The lateral surface 655a is a surface between the upper surface 653U and the first surface 103a, and is a surface adjacent to the light-emitting surface 651S. An interior angle θ of the angle between the lateral surface 655a and the first surface 103a is less than 90°. Preferably, the interior angle θ is about 70°. More preferably, the interior angle θ is less than a critical angle at the lateral surface 655a determined on the basis of a refractive index of the light-emitting element 650 and a refractive index of the first interlayer insulating film 156. The light-emitting element 650 is covered with the first interlayer insulating film 156, and the lateral surface 655a is in contact with the first interlayer insulating film 156.

A critical angle θc of the interior angle θ formed by the lateral surface 655a of the light-emitting element 650 and the first surface 103a is determined as follows, for example. Given n0 as the refractive index of the light-emitting element 650 and n1 as the refractive index of the first interlayer insulating film 156, the critical angle θc of the light emitted from the light-emitting element 650 to the first interlayer insulating film 156 is found by using the following equation (1).

$$\theta c = 90° - \sin^{-1}(n1/n0) \qquad (1)$$

For example, it is known that the refractive index of a typical transparent organic insulating material, such as acrylic resin, is in a range from about 1.4 to about 1.5. Thus, in a case in which the light-emitting element 650 is formed of GaN and the first interlayer insulating film 156 is formed of a typical transparent organic insulating material, the refractive index n0 of the light-emitting element 650 and the refractive index n of the first interlayer insulating film 156 can be set to 2.5 and 1.4, respectively. These values are then substituted in equation (1), and thus the critical angle θc = 56° is obtained.

This indicates that, in a case in which the interior angle θ formed between the first surface 103a and the lateral surface 655a is set to θc = 56°, of the light emitted from the light-emitting layer 652, light parallel to the first surface 103a is totally reflected by the lateral surface 655a. Further, this indicates that, of the light emitted from the light-emitting layer 652, light having a component in the positive direction of the Z axis is also totally reflected by the lateral surface 655a. For the sake of simplicity, the first interlayer insulating film 156 is a transparent resin. However, even when the transparent resin is changed to a white resin, the effect of the scattering microparticles for the white resin on the refractive index is small, and thus ignored in the above calculation.

On the other hand, of the light emitted from the light-emitting layer 652, light having a component in the negative direction of the Z axis is emitted from the lateral surface 655a at an emission angle corresponding to the refractive index at the lateral surface 655a. The light incident on the first interlayer insulating film 156 is emitted from the first interlayer insulating film 156 at an angle determined by the refractive index of the first interlayer insulating film 156.

The light totally reflected by the lateral surface 655a is reflected again by the upper surface 653U and, of the light reflected again, light having a component in the negative direction of the Z axis is emitted from the light-emitting surface 651S and the lateral surface 655a. The light parallel to the first surface 103a and the light having a component in the positive direction of the Z axis is totally reflected by the lateral surface 655a.

In this way, of the light emitted from the light-emitting layer 652, the light parallel to the first surface 103a and the light having a component in the positive direction of the Z axis is converted to light having a component in the negative direction of the Z axis by the lateral surface 655a. Accordingly, a proportion of the light emitted from the light-emitting element 650 that travels toward the light-emitting surface 6515 is increased, improving the substantial light emission efficiency of the light-emitting element 650.

By setting $\theta < \theta c$, most of the light having a component parallel to the first surface 103a can be totally reflected in the light-emitting element 650. When the refractive index of the first interlayer insulating film 156 is set to n = 1.4, the critical angle $\theta c$ is about 56°, and thus the set interior angle $\theta$ is more preferably set to 45° or 30° or the like. Further, the critical angle $\theta c$ is less in materials having a greater refractive index n. However, even when the interior angle $\theta$ is set to about 70°, most of the light having a component in the negative direction of the Z axis can be converted to light having a component in the positive direction of the Z axis, and thus, for example, the interior angle $\theta$ may be set to 80° or less in consideration of manufacturing variations and the like.

A manufacturing method of the image display device according to the present embodiment will now be described. In the present embodiment, the manufacturing processes for the light-emitting element 650 differ from those of the other embodiments, and these other manufacturing processes can be applied to the other embodiments described above. The following is a description of the portion of manufacturing processes that differs from those of the other embodiments. In the present embodiment, the following processes are executed to form the shape of the light-emitting element 650 illustrated in FIG. 36. The semiconductor layer 1150 illustrated in FIG. 27B is bonded to the first surface 103a and subsequently processed by etching into the shape of the light-emitting element 650 illustrated in FIG. 35. In the formation of the light-emitting element 650, an etching rate is selected so that the lateral surface 655a illustrated in FIG. 36 forms the interior angle $\theta$ with respect to the surface of the first surface 103a. For example, a greater etching rate is selected as a distance to the upper surface 653U decreases. Preferably, the etching rate is configured to increase linearly from the side of the light-emitting surface 651S toward the side of the upper surface 653U.

Specifically, for example, a resist mask pattern at the time of dry etching is devised during exposure so that the pattern gradually thins toward an end portion thereof. This allows the amount of etching to gradually recede from the thin portion of the resist during dry etching, increasing the amount of etching from the light-emitting surface 651S toward the upper surface 653U side. In this way, the lateral surface 655a of the light-emitting element 650 forms a constant angle with respect to the first surface 103a. Therefore, in the light-emitting element 650, the area of each layer from the upper surface 653U in XY plan view is formed so that the areas of the p-type semiconductor layer 653, the light-emitting layer 652, and the n-type semiconductor layer 651 increase in that order.

Subsequently, the sub-pixel 620 is formed as in the other embodiments.

Effects of the image display device of the present embodiment will now be described.

The image display device of the present embodiment, in addition to the effect of making it possible to shorten the time of the transfer process for forming the light-emitting element 650 and reduce the number of processes as in the image display devices of the other embodiments described above, achieves the following effects.

In the image display device of the present embodiment, the light-emitting element 650 includes the lateral surface 655a that forms the interior angle $\theta$ with respect to the first surface 103a provided with the light-emitting element 650. The interior angle $\theta$ is less than 90°and is set on the basis of the critical angle $\theta c$ determined by the refractive indices of the respective materials of the light-emitting element 650 and the first interlayer insulating film 156. The interior angle $\theta$ can convert, of the light emitted from the light-emitting layer 652, light traveling laterally and upwardly of the light-emitting element 650 to light traveling toward the light-emitting surface 651S side to emit the light. With the interior angle $\theta$ set sufficiently small, the substantial light emission efficiency in the light-emitting element 650 is improved.

In the present embodiment, the light-emitting element 650 is a vertical element and is connected to the via 161k by using the second wiring layer 440. The connection is not limited thereto, and the light-emitting element may be provided with a connecting portion formed on the first surface 103a, and connected to the via 161k through the connecting portion. In a case in which the light-emitting element is provided with the connecting portion for connection to the via 161k, the light-emitting surface can be roughened.

Seventh Embodiment

FIG. 37 is a schematic cross-sectional view exemplifying a portion of an image display device according to the present embodiment.

In the present embodiment, the image display device differs from those of other embodiments in including a sub-pixel group 720 including a plurality of light-emitting regions on one light-emitting surface. The same components are denoted by the same reference signs, and detailed description thereof will be omitted as appropriate.

As illustrated in FIG. 37, the image display device of the present embodiment includes the sub-pixel group 720. The sub-pixel group 720 includes the substrate 102, the semiconductor layer 750, the first interlayer insulating film 156, a plurality of transistors 103-1, 103-2, the second interlayer insulating film 108, a plurality of vias 761a1, 761a2, and the first wiring layer 110. The semiconductor layer 750 is provided on the first surface 103a.

In the present embodiment, turning on the p-channel transistors 103-1, 103-2 injects positive holes from one side of the semiconductor layer 750 through the first wiring layer 110 and the vias 761a1, 761a2. Turning on the p-channel transistors 103-1, 103-2 injects electrons from the other side of the semiconductor layer 750 through the first wiring layer 110. In the semiconductor layer 750, positive holes and electrons are injected and, by the positive holes and electrons being combined, light-emitting layers 752a1, 752a2, separated from each other, emit light. The circuit configuration illustrated in FIG. 2, for example, is applied to the drive circuit for driving the light-emitting layers 752a1, 752a2. The n-type semiconductor layer and the p-type semiconductor layer of the semiconductor layers can also be switched by using the example of the second embodiment to make a configuration in which the semiconductor layer is driven by an n-channel transistor. In such a case, the circuit configuration of FIG. 11, for example, is applied to the drive circuit.

The configuration of the sub-pixel group 720 will now be described in detail.

The semiconductor layer 750 includes a light-emitting surface 751S that comes into contact with the first surface 103a. The light-emitting surface 751S is a surface of an n-type semiconductor layer 751. The light-emitting surface 751S includes a plurality of light-emitting regions 751R1, 751R2.

The semiconductor layer 750 includes the n-type semiconductor layer 751, the light-emitting layers 752a1, 752a2, and p-type semiconductor layers 753a1, 753a2. The light-emitting layer 752a1 is provided on the n-type semiconductor layer 751. The light-emitting layer 752a2 is separated and spaced apart from the light-emitting layer 752a1, and is provided on the n-type semiconductor layer 751. The p-type semiconductor layer 753a1 is provided on the light-emitting layer 752a1. The p-type semiconductor layer 753a2 is separated and spaced apart from the p-type semiconductor layer 753a1, and is provided on the light-emitting layer 752a2.

The p-type semiconductor layer 753a1 includes an upper surface 753U1 provided on a side opposite to the surface on which the light-emitting layer 752a1 is provided. The p-type semiconductor layer 753a2 includes an upper surface 753U2 provided on a side opposite to the surface on which the light-emitting layer 752a2 is provided.

The light-emitting region 751R1 substantially matches a region of the light-emitting surface 751S on a side opposite to the upper surface 753U1. The light-emitting region 751R2 substantially matches a region of the light-emitting surface 751S on a side opposite to the upper surface 753U2.

FIG. 38 is a schematic cross-sectional view exemplifying a portion of the image display device according to the present embodiment.

FIG. 38 is a schematic view for explaining the light-emitting regions 751R1, 751R2.

As illustrated in FIG. 38, the light-emitting regions 751R1, 751R2 are surfaces on the light-emitting surface 751S. In FIG. 38, portions of the semiconductor layer 750 that include the light-emitting regions 751R1, 751R2 are referred to as light-emitting portions R1, R2, respectively. The light-emitting portion R1 includes a portion of the n-type semiconductor layer 751, the light-emitting layer 752a1, and the p-type semiconductor layer 753a1. The light-emitting portion R2 includes a portion of the n-type semiconductor layer 751, the light-emitting layer 752a2, and the p-type semiconductor layer 753a2.

The semiconductor layer 750 includes a connecting portion R0. The connecting portion R0 is provided between the light-emitting portions R1, R2, and is a portion of the n-type semiconductor layer 751. One end of a via 761k illustrated in FIG. 37 is connected to the connecting portion R0, and thus the connecting portion R0 provides a path of the current from the via 761k to the light-emitting portions R1, R2.

In the light-emitting portion R1, electrons supplied via the connecting portion R0 are supplied to the light-emitting layer 752a1. In the light-emitting portion R1, positive holes supplied via the upper surface 753U1 are supplied to the light-emitting layer 752a1. The electrons and the positive holes supplied to the light-emitting layer 752a1 are combined to emit light. Light emitted by the light-emitting layer 752a1 passes through a portion of the n-type semiconductor layer 751 of the light-emitting portion R1 and reaches the light-emitting surface 751S. The light travels substantially straight in the Z axis direction in the light-emitting portion R1, and thus the region of the light-emitting surface 751S that emits light is the light-emitting region 751R1. Accordingly, in this example, the light-emitting region 751R1 substantially matches a region surrounded by an outer periphery of the light-emitting layer 752a1 projected onto the light-emitting surface 751S in XY plan view.

The light-emitting portion R2 is similar to the light-emitting portion R1. That is, in the light-emitting portion R2, electrons supplied via the connecting portion R0 are supplied to the light-emitting layer 752a2. In the light-emitting portion R2, positive holes supplied via the upper surface 753U2 are supplied to the light-emitting layer 752a2. The electrons and the positive holes supplied to the light-emitting layer 752a2 are combined to emit light. Light emitted by the light-emitting layer 752a2 passes through a portion of the n-type semiconductor layer 751 of the light-emitting portion R2 and reaches the light-emitting surface 751S. The light travels substantially straight in the Z axis direction in the light-emitting portion R2, and thus the region of the light-emitting surface 751S that emits light is the light-emitting region 751R2. Accordingly, in this example, the light-emitting region 751R2 substantially matches a region surrounded by an outer periphery of the light-emitting layer 752a2 projected onto the light-emitting surface 751S in XY plan view.

In this way, in the semiconductor layer 750, the n-type semiconductor layer 751 is shared to form a plurality of the light-emitting regions 751R1, 751R2 on the light-emitting surface 751S.

In the present embodiment, in the plurality of light-emitting layers 752a1, 752a2 and the plurality of p-type semiconductor layers 753a1, 753a2 of the semiconductor layer 750, a portion of the n-type semiconductor layer 751 can be used as the connecting portion R0, making it possible to form the semiconductor layer 750. Accordingly, the semiconductor layer 750 can be formed in the same manner as in the method of forming the light-emitting elements 150, 250 in the first embodiment, the second embodiment, and the like described above.

The description will now be continued, returning back to FIG. 37.

The first interlayer insulating film 156 (first insulating film) covers the first surface 103a and the semiconductor layer 750.

The TFT lower layer film 106 is formed across the first interlayer insulating film 156. The TFT lower layer film 106 is flattened, and TFT channels 104-1, 104-2 and the like are formed on the TFT lower layer film 106.

The insulating layer 105 covers the TFT lower layer film 106 and the TFT channels 104-1, 104-2. A gate 107-1 is provided on the TFT channel 104-1 with the insulating layer 105 interposed therebetween. A gate 107-2 is provided on the TFT channel 104-2 with the insulating layer 105 interposed therebetween. The transistor 103-1 includes the TFT channel 104-1 and the gate 107-1. The transistor 103-2 includes the TFT channel 104-2 and the gate 107-2.

The second interlayer insulating film (second insulating film) 108 covers the insulating layer 105 and the gates 107-1, 107-2.

The TFT channel 104-1 includes regions 104s1, 104d1 doped with the p-type, and the regions 104s1, 104d1 are a source region and a drain region of the transistor 103-1. A region 104i1 is doped with the n-type, forming a channel of the transistor 103-1. The TFT channel 104-2 similarly includes regions 104s2, 104d2 doped with the p-type, and the regions 104s2, 104d2 are a source region and a drain region of the transistor 103-2. A region 104i2 is doped with the n-type, forming a channel of the transistor 103-2. In the present embodiment, the circuit 101 is a circuit that includes the TFT channels 104-1, 104-2, the insulating layer 105, the second interlayer insulating film 108, vias 111s1, 111d1, 111s2, 111d2, and the first wiring layer 110.

The first wiring layer 110 is formed on the second interlayer insulating film 108. The first wiring layer 110 includes wiring lines 710s1, 710d1, 710k, 710d2, 710s2.

The wiring line 710k is provided above the n-type semiconductor layer 751. The via 761k is provided between the wiring line 710k and the n-type semiconductor layer 751, and allows electrical connection between the wiring line 710k and the n-type semiconductor layer 751. The wiring line 710k is connected to the ground line 4 of the circuit illustrated in FIG. 2, for example.

The vias 111d1, 111s1, 111d2, 111s2 pass through the second interlayer insulating film 108 and the insulating layer 105. The via 111d1 is provided between the region 104d1 and the wiring line 710d1 and allows electrical connection the region 104d1 and the wiring line 710d1. The via 111s1 is provided between the region 104s1 and the wiring line 710s1 and allows electrical connection between the region 104s1 and the wiring line 710s1. The via 111d2 is provided between the region 104d2 and the wiring line 710d2 and allows electrical connection between the region 104d2 and the wiring line 710d2. The via 111s2 is provided between the region 104s2 and the wiring line 710s2 and allows electrical connection between the region 104s2 and the wiring line 710s2. The wiring lines 710s1, 710s2 are connected to the power source line 3 of the circuit in FIG. 2, for example.

The wiring line 710d1 is provided above the upper surface 753U1. The via 761a1 is provided between the wiring line 710d1 and the upper surface 753U1, and allows electrical connection between the wiring line 710d1 and the upper surface 753U1. Accordingly, the p-type semiconductor layer 753a1 is electrically connected to the drain region of the transistor 103-1 through the upper surface 753U1, the via 761a1, the wiring line 710d1, and the via 111d1.

The wiring line 710d2 is provided above the upper surface 753U2. The via 761a2 is provided between the wiring line 710d2 and the upper surface 753U2, and allows electrical connection between the wiring line 710d2 and the upper surface 753U2. Accordingly, the p-type semiconductor layer 753a2 is electrically connected to the drain region of the transistor 103-2 through the upper surface 753U2, the via 761a2, the wiring line 710d2, and the via 111d2.

For example, the transistors 103-1, 103-2 are drive transistors of adjacent sub-pixels and are driven sequentially. When positive holes supplied from the transistors 103-1 are injected into the light-emitting layer 752a1 and electrons supplied from the wiring line 710k are injected into the light-emitting layer 752a1, the light-emitting layer 752a1 emits light and the light is emitted from the light-emitting region 751R1. When positive holes supplied from the transistor 103-2 are injected into the light-emitting layer 752a2 and electrons supplied from the wiring line 710k are injected into the light-emitting layer 752a2, the light-emitting layer 752a2 emits light and the light is emitted from the light-emitting region 751R2.

Effects of the image display device of the present embodiment will now be described.

The image display device of the present embodiment, similarly to the image display devices of the other embodiments described above, achieves the effect of making it possible to shorten the time of the transfer process for forming the semiconductor layer 750 and reduce the number of processes. In addition, the connecting portion R0 can be shared by the plurality of light-emitting portions R1, R2, and thus the number of vias 761k provided in the connecting portion R0 can be reduced. By reducing the number of vias, a pitch of the light-emitting portions R1, R2 constituting the sub-pixel group 720 can be reduced, and the image display device can be made small in size and high in definition. Although a case of two light-emitting regions has been described in this example, the number of light-emitting regions formed in the light-emitting surface is not limited to two, and can be a desired number of three or more.

Eighth Embodiment

The image display device described above can be, as an image display module including an appropriate number of pixels, a computer display, a television, a mobile terminal such as a smartphone, or a car navigation system, for example.

FIG. 39 is a block diagram exemplifying an image display device according to the present embodiment.

A main portion of a configuration of a computer display is illustrated in FIG. 39.

As illustrated in FIG. 39, an image display device 801 includes an image display module 802. The image display module 802 is, for example, an image display device provided with the configuration of the first embodiment described above. The image display module 802 includes the display region 2 in which the plurality of sub-pixels including the sub-pixel 20 are arrayed, the row selection circuit 5, and the signal voltage output circuit 7.

The image display device 801 further includes a controller 870. The controller 870 inputs control signals separated and generated by an interface circuit (not illustrated) to control the drive and drive sequence of each sub-pixel with respect to the row selection circuit 5 and the signal voltage output circuit 7.

Modified Example

The image display device described above can be, as an image display module including an appropriate number of pixels, a computer display, a television, a mobile terminal such as a smartphone, or a car navigation system, for example.

FIG. 40 is a block diagram exemplifying an image display device according to a modified example of the present embodiment.

FIG. 40 illustrates a configuration of a high-definition, flat-screen television.

As illustrated in FIG. 40, an image display device 901 includes an image display module 902. The image display module 902 is, for example, the image display device 1 provided with the configuration of the first embodiment described above. The image display device 901 includes a controller 970 and a frame memory 980. The controller 970 controls the drive sequence of each sub-pixel in the display region 2 on the basis of the control signal supplied by a bus 940. The frame memory 980 stores the display data of one frame and is used for processing, such as smooth video playback.

The image display device 901 includes an I/O circuit 910. The I/O circuit 910 is simply denoted as "I/O" in FIG. 40. The I/O circuit 910 provides an interface circuit and the like for connection to an external terminal, device, or the like. The I/O circuit 910 includes, for example, a universal serial bus (USB) interface for connecting an external hard disk device or the like, and an audio interface.

The image display device 901 includes a receiving unit 920 and a signal processing unit 930. The receiving unit 920 is connected with an antenna 922 to separate and generate necessary signals from radio waves received by the antenna 922. The signal processing unit 930 includes a digital signal processor (DSP), a central processing unit (CPU), and the like, and signals separated and generated by the receiving unit 920 are separated and generated into image data, audio data, and the like by the signal processing unit 930.

Other image display devices can be made as well by using the receiving unit 920 and the signal processing unit 930 as high-frequency communication modules for transmission/reception of mobile phones, Wi-Fi, global positioning system (GPS) receivers, and the like. For example, an image display device provided with an image display module with an appropriate screen size and resolution may be made into a mobile information terminal such as a smartphone or a car navigation system.

The image display module in the case of the present embodiment is not limited to the configuration of the image display device in the first embodiment, and may be the configuration of a modified example or other embodiment. The image display modules in the case of the present embodiment and the modified example are configured to include a large number of sub-pixels as illustrated in FIGS. 9 and 25.

According to the embodiments described above, an image display device manufacturing method and an image display device that reduce a transfer process of a light-emitting element and improve yield are realized.

While several embodiments of the present invention have been described above, these embodiments have been presented by way of example, and are not intended to limit the scope of the invention. These novel embodiments may be implemented in various other forms and various omissions, substitutions, and changes may be made without departing from the spirit of the invention. These embodiments and variations thereof are included in the scope and spirit of the invention, and are within the scope of the invention described in the claims and equivalents thereof. Further, each of the aforementioned embodiments may be implemented in combination with each other.

[Reference Signs List]

1, 201, 301, 501, 801, 901 Image display device
2 Display region
3 Power source line
4 Ground line
5, 205 Row selection circuit
6, 206 Scanning line
7, 207 Signal voltage output circuit
8, 208 Signal line
10 Pixel
20, 220, 320, 420, 520, 620 Sub-pixel
22, 222 Light-emitting element
24, 224 Selection transistor
26, 226 Drive transistor
28, 228 Capacitor
100 Drive circuit portion
101 Circuit
102, 402, 502 Substrate
103a, 180a First surface
103, 103-1, 103-2, 203 Transistor
104, 104-1, 104-2, 204 TFT channel
105 Insulating layer
107, 107-1, 107-2 Gate
108 Second interlayer insulating film
110 First wiring layer
150, 250, 650 Light-emitting element
151a, 253a, R0 Connecting portion
151S, 151S1, 253S, 651S, 751S Light-emitting surface
156 First interlayer insulating film
161a, 161k, 261a, 261k, 361a, 361k, 761a1, 761a2, 761k Via
172 Light-emitting circuit portion
180 Color filter
330 Light-blocking layer
440 Second wiring layer
470 Third wiring layer
560a Light-blocking electrode
720 Sub-pixel group
1001 Crystal growth substrate
1150 Semiconductor layer
1155 Transparent flattening film
1180 Reinforcing substrate
1190 Support substrate
1192 Structure
1194, 1294 Semiconductor growth substrate
1440 Conductive film

**Claims**

1. An image display device manufacturing method comprising:

    preparing a semiconductor layer comprising a light-emitting layer;
    bonding the semiconductor layer to a first surface of a light-transmitting substrate;
    etching the semiconductor layer to form, on the first surface, a light-emitting element comprising a light-emitting surface and an upper surface provided on a side opposite to the light-emitting surface;
    forming a first insulating film covering the first surface and the light-emitting element;
    forming a circuit element on the first insulating film;
    forming a second insulating film covering the first insulating film and the circuit element;
    forming a first via passing through the first insulating film and the second insulating film; and
    forming a first wiring layer on the second insulating film, wherein
    the first via is provided between the first wiring layer and the upper surface, and allows electrical connection between the first wiring layer and the upper surface.

2. The image display device manufacturing method according to claim 1, further comprising roughening an exposed surface of the semiconductor layer, and forming a film having light transmittance across a roughened surface before the step of bonding the semiconductor layer.

3. The image display device manufacturing method according to claim 1, further comprising:

    forming a second via passing through the first insulating film and the second insulating film, wherein
    the light-emitting element comprises a connecting portion, and
    the second via is provided between the first wiring layer and the connecting portion, and allows electrical connection between the first wiring layer and the connecting portion.

4. The image display device manufacturing method according to claim 1, further comprising:

    forming a conductive layer having light transmittance on the semiconductor layer before the step of bonding the semiconductor layer; and
    etching the conductive layer to form a second wiring layer after the step of bonding the semiconductor layer.

5. The image display device manufacturing method according to claim 4, further comprising:

    forming a second via passing through the first insulating film and the second insulating film, wherein
    the second via is provided between the first wiring layer and the second wiring layer, and allows electrical connection between the first wiring layer and the second wiring layer.

6. The image display device manufacturing method according to claim 1, further comprising
forming a light-blocking layer on the first insulating film before the step of forming the circuit element.

7. The image display device manufacturing method according to claim 1, further comprising
forming a third wiring layer covering the light-emitting element before the step of forming the first insulating film.

8. The image display device manufacturing method according to claim 1, wherein
the semiconductor layer comprises a gallium nitride compound semiconductor.

9. The image display device manufacturing method according to claim 1, further comprising
forming a wavelength conversion member on a second surface on a side opposite to the first surface.

10. The image display device manufacturing method according to claim 1, further comprising
removing the light-transmitting substrate and forming a wavelength conversion member in place of the light-transmitting substrate.

11. An image display device comprising:

a light-transmitting member comprising a first surface;
a light-emitting element, on the first surface, comprising a light-emitting surface and an upper surface on a side opposite to the light-emitting surface;
a first insulating film covering the first surface and the light-emitting element;
a circuit element provided on the first insulating film;
a second insulating film covering the first insulating film and the circuit element;
a first via passing through the first insulating film and the second insulating film; and
a first wiring layer provided on the second insulating film, wherein
the first via is provided between the first wiring layer and the upper surface, and allows electrical connection between the first wiring layer and the upper surface.

12. The image display device according to claim 11, further comprising:

a second via passing through the first insulating film and the second insulating film, wherein
the light-emitting element comprises a connecting portion formed on the first surface,
the first wiring layer comprises a first wiring line and a second wiring line separated from the first wiring line,
the first via is provided between the first wiring line and the upper surface, and allows electrical connection between the first wiring line and the upper surface, and
the second via is provided between the second wiring line and the connecting portion, and allows electrical connection between the second wiring line and the connecting portion.

13. The image display device according to claim 11, wherein
the light-emitting surface is roughened.

14. The image display device according to claim 11, further comprising:

a second wiring layer provided between the first surface and the light-emitting surface and having light transmittance; and
a second via passing through the first insulating film and the second insulating film, wherein
the first wiring layer comprises a first wiring line and a second wiring line separated from the first wiring line,
the first via is provided between the first wiring line and the upper surface, and allows electrical connection between the first wiring line and the upper surface, and
the second via is provided between the second wiring line and the second wiring layer, and allows electrical connection between the second wiring line and the second wiring layer.

15. The image display device according to claim 14, further comprising:

a third wiring layer covering the upper surface and a lateral surface of the light-emitting element, and comprising a first light-blocking electrode electrically connected to the upper surface, wherein
the first via is provided between the first wiring layer and the first light-blocking electrode, and allows electrical connection between the first wiring layer and the first light-blocking electrode.

16. The image display device according to claim 14, further comprising:

a second light-blocking electrode covering the upper surface and configured to be electrically connected to the upper surface, wherein
the first via is provided in a through hole having an inner diameter comprising an outer periphery of the second light-blocking electrode in plan view, is provided between the first wiring layer and the second light-blocking electrode, and allows electrical connection between the first wiring layer and the second light-blocking electrode.

17. The image display device according to claim 14, wherein
an interior angle formed by the first surface and a lateral surface of the light-emitting element is less than 90°.

18. The image display device according to claim 11, further comprising
a light-blocking layer provided between the first insulating film and the second insulating film.

19. The image display device according to claim 11, wherein
the first insulating film has light reflectivity.

20. The image display device according to claim 11, wherein
the light-emitting element comprises a gallium nitride compound semiconductor.

21. The image display device according to claim 11, wherein
the light-transmitting member comprises a wavelength conversion member.

22. An image display device comprising:

a light-transmitting member comprising a first surface;
a first semiconductor layer, on the first surface, comprising a light-emitting surface that can form a plurality of light-emitting regions;
a plurality of light-emitting layers spaced apart on the first semiconductor layer;
a plurality of second semiconductor layers respectively provided on the plurality of light-emitting layers and having a conductivity type different from a conductivity type of the first semiconductor layer;
a first insulating film covering the first surface, the first semiconductor layer, the plurality of light-emitting layers, and the plurality of second semiconductor layers;
a plurality of transistors spaced apart from one another on the first insulating film;
a second insulating film covering the first insulating film and the plurality of transistors;
a plurality of first vias passing through the first insulating film and the second insulating film; and
a first wiring layer provided on the second insulating film, wherein
the plurality of second semiconductor layers and the plurality of light-emitting layers are separated by the first insulating film, and
the plurality of first vias are disposed between the first wiring layer and the plurality of respective second semiconductor layers, and allow electrical connection between the first wiring layer and the plurality of respective second semiconductor layers.

23. An image display device comprising:

a light-transmitting member comprising a first surface;
a plurality of light-emitting elements, on the first surface, each comprising a light-emitting surface and an upper surface on a side opposite to the light-emitting surface;
a first insulating film covering the first surface and the plurality of light-emitting elements;
a circuit element provided on the first insulating film;
a second insulating film covering the first insulating film and the circuit element;
a plurality of first vias passing through the first insulating film and the second insulating film; and
a first wiring layer provided on the second insulating film, wherein
each of the plurality of first vias is provided between the first wiring layer and the upper surface, and allows electrical connection between the first wiring layer and the upper surface.

20

110s   111s   111d   110d   161a   110k

110
108
101
105
104
106

156
161k

103a
102a
303
102
102b

104s 104i 104d   153 152 151

107   104   150   151a

103   153U   151S

Z

**FIG. 1**

FIG. 2

FIG. 3

FIG. 4A

FIG. 4B

## FIG. 5A

## FIG. 5B

FIG. 6

## FIG. 7A

## FIG. 7B

## FIG. 8A

## FIG. 8B

FIG. 9

FIG. 10

FIG. 11

FIG. 12A

FIG. 12B

FIG. 13

FIG. 14A

1294

n  1151
1152  1150
p  1153

1001

Z ↑

FIG. 14B

1294

1001

p  1153
1152  1150
n  1151

1151E

1190E

1190

Z ↑

## FIG. 15A

1295

1190

n — 1151
— 1152 } 1150
p — 1153

1153E

103a
102a
303
102

Z ↑

## FIG. 15B

1190

n — 1151
— 1152 } 1150
p — 1153

103a
102a
303
102

Z ↑

FIG. 16A

FIG. 16B

## FIG. 17A

105
106

103a
102a

204s 204i 204d        251 252 253

107        204              250

203                  251U          253S

156
253a
303
102

Z

## FIG. 17B

220

210s    111s    111d    210d    261k    210a

110
108
101
105
204
106

210s

103a
102a

204s 204i 204d        251 252 253

107        204              250

203                  251U          253S

156
261a
303
102

253a

Z

FIG. 18

FIG. 19

## FIG. 20A

1155E
1151E1
1155
1151
1152 } 1150
1153
1190

n

p

Z
↑

## FIG. 20B

1190

p
1153
1152 } 1150
n
1151
1155
1155E

103a
102a
303
102

Z
↑

## FIG. 21A

## FIG. 21B

# FIG. 22A

# FIG. 22B

## FIG. 23A

## FIG. 23B

FIG. 24A

FIG. 24B

FIG. 24C

FIG. 24D

100

150

172

180

Z

Y

X

FIG. 25

**FIG. 26**

## FIG. 27A

1151E
1440
1151
1152 } 1150
1153 }
1190 }
n
p
1195

Z

## FIG. 27B

1190
1195
1153 }
1152 } 1150
1151 }
1440
p
n

103a
102a
303
102

Z

## FIG. 28A

462a

457
103a
102a

440a
440
303
102

153U      151S

153 152 151

150

Z

## FIG. 28B

461a

1470
457
103a
102a

440a
440
303
102

153U      151S

153 152 151

150

Z

# FIG. 29A

# FIG. 29B

# FIG. 30A

# FIG. 30B

FIG. 31

FIG. 32

## FIG. 33A

## FIG. 33B

## FIG. 34A

## FIG. 34B

FIG. 35

FIG. 36

FIG. 37

EP 4 216 290 A1

FIG. 38

EP 4 216 290 A1

CONTROL SIGNAL →

870

CONTROLLER

801

5

802

2

DRIVE SIGNAL →

7

FIG. 39

FIG. 40

## INTERNATIONAL SEARCH REPORT

| International application No. |
|---|
| **PCT/JP2021/032529** |

### A. CLASSIFICATION OF SUBJECT MATTER

*H01L 33/02*(2010.01)i; *H01L 33/48*(2010.01)i; *G09F 9/00*(2006.01)i; *G09F 9/30*(2006.01)i; *G09F 9/33*(2006.01)i
FI: G09F9/30 330; G09F9/33; G09F9/30 338; G09F9/30 349C; G09F9/30 348A; G09F9/00 342; H01L33/48; H01L33/02

According to International Patent Classification (IPC) or to both national classification and IPC

### B. FIELDS SEARCHED

Minimum documentation searched (classification system followed by classification symbols)

H01L33/02; H01L33/48; G09F9/00; G09F9/30; G09F9/33

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | US 2019/0157523 A1 (KAISTAR LIGHTING (XIAMEN) CO., LTD.) 23 May 2019 (2019-05-23)<br>entire text, all drawings | 1-23 |
| A | US 2018/0259570 A1 (TESORO SCIENTIFIC, INC.) 13 September 2018 (2018-09-13)<br>entire text, all drawings | 1-23 |
| A | JP 2010-219310 A (SHARP CORP.) 30 September 2010 (2010-09-30)<br>entire text, all drawings | 1-23 |
| A | JP 2009-111371 A (SEMICONDUCTOR ENERGY LAB CO., LTD.) 21 May 2009 (2009-05-21)<br>entire text, all drawings | 1-23 |
| A | US 2009/0078963 A1 (KHODJA, Salah) 26 March 2009 (2009-03-26)<br>entire text, all drawings | 1-23 |
| A | JP 2008-159767 A (OKI DATA KK) 10 July 2008 (2008-07-10)<br>entire text, all drawings | 1-23 |

☑ Further documents are listed in the continuation of Box C.     ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **08 November 2021** | **22 November 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

EP 4 216 290 A1

**INTERNATIONAL SEARCH REPORT**

International application No.

**PCT/JP2021/032529**

**C.    DOCUMENTS CONSIDERED TO BE RELEVANT**

| Category* | Citation of document, with indication, where appropriate, of the relevant passages | Relevant to claim No. |
|---|---|---|
| A | JP 2007-242645 A (ROHM CO., LTD.) 20 September 2007 (2007-09-20) entire text, all drawings | 1-23 |
| A | JP 2002-141492 A (CANON INC.) 17 May 2002 (2002-05-17) entire text, all drawings | 1-23 |
| P, A | WO 2020/226044 A1 (NICHIA CORPORATION) 12 November 2020 (2020-11-12) entire text, all drawings | 1-23 |

Form PCT/ISA/210 (second sheet) (January 2015)

# EP 4 216 290 A1

<table>
<tr><td rowspan="2" colspan="3">INTERNATIONAL SEARCH REPORT<br>Information on patent family members</td><td colspan="2">International application No.<br><br>**PCT/JP2021/032529**</td></tr>
</table>

| Patent document cited in search report | | | Publication date (day/month/year) | Patent family member(s) | | | Publication date (day/month/year) |
|---|---|---|---|---|---|---|---|
| US | 2019/0157523 | A1 | 23 May 2019 | CN | 107731864 | A | |
| US | 2018/0259570 | A1 | 13 September 2018 | JP | 2020-506541 | A | |
| | | | | WO | 2018/136970 | A1 | |
| | | | | EP | 3571494 | A1 | |
| | | | | TW | 201841278 | A | |
| | | | | KR | 10-2019-0112294 | A | |
| | | | | CN | 110462387 | A | |
| JP | 2010-219310 | A | 30 September 2010 | (Family: none) | | | |
| JP | 2009-111371 | A | 21 May 2009 | US | 2009/0098674 | A1 | |
| | | | | CN | 101409223 | A | |
| US | 2009/0078963 | A1 | 26 March 2009 | (Family: none) | | | |
| JP | 2008-159767 | A | 10 July 2008 | US | 2008/0185972 | A1 | |
| JP | 2007-242645 | A | 20 September 2007 | (Family: none) | | | |
| JP | 2002-141492 | A | 17 May 2002 | (Family: none) | | | |
| WO | 2020/226044 | A1 | 12 November 2020 | (Family: none) | | | |

Form PCT/ISA/210 (patent family annex) (January 2015)

**REFERENCES CITED IN THE DESCRIPTION**

**Patent documents cited in the description**

- JP 2002141492 A